# EUROPEAN PATENT SPECIFICATION

(11) **EP 3 184 877 B1**
(45) Date of publication and mention of the grant of the patent: **29.08.2018**
(21) Application number: 16206515.5
(22) Date of filing: 22.12.2016
(51) Int. Cl.: F21K 9/00, F21K 9/90, F21V 19/00, F21V 29/70, F21V 29/83, F21Y 107/00, F21Y 115/10

(54) **LED ILLUMINATION APPARATUS AND MANUFACTURING METHOD THEREOF**
LED-BELEUCHTUNGSVORRICHTUNG UND HERSTELLUNGSVERFAHREN DAFÜR
APPAREIL D'ÉCLAIRAGE À DEL ET SON PROCÉDÉ DE FABRICATION

(30) Priority: 25.12.2015 TW 104143916
(43) Date of publication of application: 28.06.2017
(73) Proprietor: LongWide Technology Inc., 545 Puli Township (TW)
(72) Inventor: CHIEN, HUAN JAN, HSINCHU COUNTY (TW); TSAI, MING YANG, Nantou County (TW)
(74) Representative: Cabinet Chaillot

(56) References cited:
- EP-A1- 2 314 913
- EP-A2- 2 615 358

## Description

### FIELD OF THE INVENTION

The present invention relates to a light emitting diode (LED) illumination apparatus, and more particularly to the technical field of forming an illumination circuit structure by a stamping technology.

### BACKGROUND OF THE INVENTION

LED illumination apparatus generally uses a packaged LED chip as a light emitting component, and the common forms of packaged LEDs include DIP package LED, SMD package LED, COB package LED, CSP packaged LED, etc, and the aforementioned package LEDs are called LED chips. Besides the electrically conductive electrode contact, the LED chip may also have a heat transfer contact for accelerating the conduction of heat to the outside. To improve the illumination power, some manufacturers may package a plurality of LED dies onto a large aluminum substrate, and the size of the LED dies is much greater than the size of the LED bare chip, and such package is called a large aluminum substrate package.

The common functional requirements and conventional solutions of the LED illumination apparatus are described below:

### 1. Heat Dissipation Requirement:

As disclosed in R.O.C. Utility Model No. TWM337844, a large power LED comprises an electrode pin installed onto a metal plate to increase the heat dissipating area, but such solution does not adopts the structure of a heat transfer contact and has not disclosed a total cooling solution for the illumination apparatus.

As disclosed in P.R.C. Pat. No. CN102494257A, a large-angle LED bulb capable of dissipating heat by natural convection of the air comprises an LED chip attached onto a polygonal cooling column with a plurality of heat dissipating channels, and air is circulated naturally through the heat dissipating channels for cooling. Since the specific column-shaped cooling column can just provide illumination in the circumferential direction, such heat dissipation does not provide any solution for the illumination range.

As disclosed in R.O.C. Pat. No. TWM477544, a circular LED bulb heat sink comprises a planar circular LED module and a circular light cover, so that cold air may enter from the central penetrating position into the high-temperature position of the heat sink to carry away the waste heat and discharge the heat from an opening formed at the upper half of the heat sink, and a circular translucent cover must be used to overcome the problem of the illumination range.

As disclosed in U.S. Pat. No. US2014/029362A1, an LED lamp heat dissipating structure comprises an LED aluminum substrate installed to a casing, and an insulative sleeve and casing cover jointly form a current gap and are installed onto a lamp head, and a current through hole is formed from a ventilation hole on a surface of a lamp cover to an aluminum substrate and communicated with the current gap for timely dissipating the heat generated by a driving circuit and the LED aluminum substrate.

As disclosed in R.O.C. Pat. No. TW201330307, an LED 3D curved leadframe of a light emitting apparatus comprises a light emitting apparatus with a curved surface, and the heat dissipating fins of an aluminum alloy body require a large consumption of aluminum.

### 2. Illumination Range Requirement:

As disclosed in R.O.C. Pat. No. TWM405524, an LED 3D bulb comprises a plurality of LED chips installed to a plurality of aslant carrying surfaces respectively to increase the illumination range of the LED light source.

As disclosed in Japan Pat. No. JP2014003032A, an LED chip is installed onto a cut aluminum substrate, and the aluminum substrate is bent, so that the LED chip is capable of emitting light in the circumferential direction.

As disclosed in Japan Pat. No. JP2014093235A, a small low power cylindrical bulb is installed in a lamp, and a reflective mirror is provided fro improving the uniformity of the illuminating light.

As disclosed in U.S. Pat. No. US2012062151A1, a flexible circuit board with an installed LED chip forms a light emitting sphere, and the light emitting sphere is capable of meeting the illumination requirement for the 3D spherical surface.

In R.O.C. Pat. No. TW201330307, an LED 3D curved leadframe of a light emitting apparatus capable of meeting different illumination ranges is disclosed.

As disclosed in U.S. Pat. No. US2014/0254145A1, a lamp tube structure comprises two aslant surfaces provided for installing an aluminum substrate with an LED chip package to meet the illumination range requirement, and a large-area structure is used for the heat dissipation.

### 3. Material Requirement:

Due to cost, most conventional LED bulbs adopts heat dissipating fins or sheet structures made of aluminum sheet or aluminum die-cast sheet to achieve the effect of environmental friendliness and consume less material.

### 4. Environmental Protection Requirement:

In R.O.C. Pat. No. TW201330307, an LED 3D curved leadframe of a light emitting apparatus is disclosed, wherein the manufacturing process of the curved leadframe meets the environmental protection requirement, but the aluminum alloy body of the light emitting apparatus of this solution requires a larger consumption of aluminum.

As disclosed in U.S. Pat. No. US2014/0254145A1, an LED chip is installed onto a circuit of an aluminum substrate, and the manufacturing process includes several PCB chemical processes.

In U.S. Pat. No. US2012/006215A1, a flexible circuit board is manufactured with several PCB chemical processes, and thus this solution fails to meet the high-power heat dissipation requirement and the environmental protection requirement.

In U.S. Pat. No. US2014/0293624A1, an aluminum substrate is manufactured with several PCB chemical processes.

In a conventional sheet metal process, a sheet metal is stamped into a 3D structure and then cut to form a circuit which is similar to the conductive plate. Such process can form the structure more quickly, but it also had disadvantages on the process of cutting the circuit and the follow-up manual process of mounting an LED chip on to the 3D curved surface and the soldering process. In addition, such solution incurs a high cost and a low reliability for mass production.

### SUMMARY OF THE INVENTION

The invention relates to an LED illumination apparatus according to claim 1 and a method of manufacturing such an LED illumination apparatus according to claim 18. The embodiments not covered by the claims do not form part of the invention but represent background art that is useful for understanding the invention. The present invention includes a conductive plate made of an electrically conductive metal plate, and a surface insulation treatment such as spray coating or printing an insulative paint is conducted in advance to meet electrical safety regulations and insulation requirements, and each isolation slot and each electrode slot have a width in compliance with the electrical safety regulations, and the metal of electrode contacts is exposed.

Therefore, it is a primary objective of the present invention to overcome the aforementioned problems of the conventional LED illumination apparatus and adopt the concept of combining a 3D light emitting curved surface thermoelectrically, so that the large amount of heat generated by the LED chip can be dissipated by convection through the conductive plate made of a large-area metal.

The secondary objective of the present invention is to provide an LED illumination apparatus that adopts a mechanical process without polluting the environment to meet the environmental protection requirements.

Another objective of the present invention is to provide an LED illumination apparatus with a protection mechanism installed at an LED chip soldering point of the conductive plate to lower the defective rate during the manufacturing process.

A further objective of the present invention is to provide an LED illumination apparatus that uses less material to reduce the weight of the lamp.

To achieve the aforementioned and other objectives, the present invention provided an LED illumination apparatus comprising a conductive plate made of metal and a support frame with an insulating effect, and the conductive plate and the support frame are combined to form the illumination apparatus, and the support frame is provided for fixing and supporting the conductive plate in each manufacturing process to facilitate the formation of the illumination circuit of the present invention.

The support frame may have a main body comprised of a plurality of strip support ribs and installed in the internal space of the conductive plate; and each support rib is configured to be corresponsive to the strip structure of the conductive plate; and each support rib has a plurality of fixing columns thereon, and a support surface is disposed between each group of fixing columns and provided for attaching and supporting a fixed planar structure of the conductive plate, and each fixing column is passed through a fixing hole of the conductive plate and combined with the fixing hole for protecting an electrode soldering point of each LED chip; and more than one ventilation hole is formed between the support ribs, and the ventilation holes are separated from each other, and each auxiliary portion of the conductive plate to be cut is covered by the area of a ventilation hole, and in a process of pressing by the stamping mold, both of the fixed planar structure and the support rib are pressed and fixed to cut each auxiliary portion.

The conductive plate may be a material board manufactured by stamping and cutting an electrically conductive metal plate, and the conductive plate removed from the material board has a strip structure, which can be bent to form different types of 3D curved surfaces in compliance with the requirement of a series-parallel illumination circuit.

Optionally, on the conductive plate, a series of parallel illumination circuits are formed, and the illumination circuit is divided into a plurality of parallel circuit areas by a plurality of isolation slots, and an electrode slot divides each parallel circuit area and a plurality of LED chips are installed in the parallel circuit area. In other words, a plurality of strip structures and a connecting portion form the parallel circuit area to construct the plurality of parallel circuit areas; and a high potential electrode contact of an LED chip in each group of parallel circuit areas is connected in parallel with a connecting portion in the area, and a low potential electrode contact is connected in parallel with another connecting portion in the area, and these connecting portions are disposed across the isolation slot, and a connecting portion outside the area is disposed across the isolation slot for connecting each parallel circuit area in series. It is noteworthy that if each electrode slot is formed on the isolation slot, then each auxiliary portion will be disposed across the electrode slot and the isolation slot.

Further, the conductive plate may comprise a power contact, a positioning portion, a plurality of isolation slots, a plurality of connecting portions, a plurality of strip structures, and the fixed planar structure has a protection mechanism at the LED chip soldering point.

Wherein, the positioning portion refers to a portion that provides a positioning effect when bending and forming the conductive plate, so as to facilitate the conductive plate to be stamped into a 3D curved surface.

The isolation slot is provided for dividing the conductive plate into a plurality of strip structures, or dividing a strip structure into a smaller strip structure; each isolation slot is provided for isolating the high potential circuit and the low potential circuit between each group of parallel circuits, and the isolation slot may have a plurality of electrode slots formed thereon to meet circuit requirements, if needed.

The plurality of connecting portions may be disposed on an edge of the electrode of the electrode slot for connecting the high potential electrodes in the parallel circuit areas in series, and the low potential electrodes in series as well as connecting the parallel circuit areas in parallel, while maintaining the whole shape after the conductive plate is stamped and formed, and a partial bending and deformation occurs at some of the positions of the connecting portion to meet the requirement of the conductive plate having a 3D curved surface.

The fixed planar structure refers the planes between the fixing hole of the conductive plate, the periphery of the LED chip, and its non-opening area. When the conductive plate is bent and formed, the stamping mold avoids the LED chip and its soldering point and presses the fixed planar structure to facilitate stamping and forming the conductive plate, prevent the electrode slot from being deformed, and protect the of electrode soldering point each LED chip. It is noteworthy that the fixed planar structure may be a circular strip structure, a concentric circular strip structure, a U-shaped strip arranged structure, or a rectangular arranged structure configured according to each LED chip.

Further, the protection mechanism of the LED chip soldering point may be formed by each fixing hole of the conductive plate, the fixed planar structure and the support rib, the support surface, and the fixing column of the support frame, wherein a plurality of auxiliary portions are connected into the electrode slot to form a single-component conductive plate, and then the fixed planar structures between the fixing holes of the conductive plate, the periphery of the LED chip and its non-opening area is used as a stamp positioning area , and then each fixing hole of the conductive plate and each fixing column of the support frame are combined with each other, and each support surface of the support frame abuts and supports the fixed planar structure of the conductive plate.

The manufacturing method of an illumination apparatus of the present invention is as defined in claim 18 and comprises a material preparation process and a formation process, wherein the material preparation process further comprises: an unloading process, a mounting process, and a reclaiming process, and the formation process comprises a formation preparation process, a bending process, an assembling process, and an auxiliary portion removing process. In the aforementioned processes, the plurality of fixed planar structures, fixing holes, and auxiliary portions of the conductive plate and the plurality of support ribs, support surfaces, and support columns of the support frame constitute the aforementioned LED chip soldering point protection mechanism to lower the defective rate of the manufacturing process. Each process may not be carried out for one time only, and each process is described below:

In the unloading process, a metal sheet is stamped and cut into a material board in advance, so that the material board includes a plurality of strip structures, and each strip structure is separated by a plurality of isolation slots, and each auxiliary portion causing a short circuit and the connecting portion disposed across the isolation slot are used to connect each strip structure, so that the material board is formed to be an integral plate structure.

In the mounting process, each LED chip is soldered onto the plurality of electrode slots of the material board.

In the reclaiming process, the plurality of connecting plates is cut from the material board to remove a stamping board.

In the formation preparation process, a stamping mold is provided for pressing and positioning the positioning portion of the stamping board, and the stamping mold conducts a pre-press to produce a required deformation at a predetermined position according to the 3D shape of the conductive plate, wherein the required deformation includes the deformation at each bending portion and each connecting portion.

In the bending process, a stamping mold is used to press each fixed planar structure of the pre-deformed punching board and bend each bending portion to complete the formation of the conductive plate, and the bending process may take place before or after the assembling process.

In the assembling process, the conductive plate is combined and fixed to the support frame, and each fixing column of the support frame is passed through each fixing hole of the conductive plate, and the support surface of each support rib is attached to the fixed planar structure of the conductive plate to provide the necessary structure strength of the conductive plate for the support, so as to facilitate the incomplete bending process of the conductive plate, and the ventilation hole area of each support rib of the support frame must cover the auxiliary portion of the conductive plate.

In the auxiliary portion removing process, the stamping mold presses the fixed planar structure of the conductive plate and each support rib of the support frame, and each auxiliary portion is cut open to form a complete series-parallel illumination circuit of the present invention.

The aforementioned illumination apparatus manufacturing method further comprises a shaping process between the bending process and the assembling process, and the shaping process further shapes the formed conductive plate with dimensions of a higher precision.

The present invention applying the aforementioned technical measures achieves the following effects:

1. The conductive plate of the present invention has a strip structure, and the stamping and cutting processes comply with the environmental protection requirements and use less material, and when the LED chip is soldered, the low potential electrode of each electrode slot can cover the heat transfer contact of each LED chip. Since the conductive plate thermoelectrically combined with a strip structure and accompanied with the support frame provides a double large-area heat dissipation effect (wherein the support frame can dissipate heat as well) to improve the heat dissipating efficiency of the present invention.

2. The mechanical stamping process of the present invention does not pollute the environment, and the material board is suitable for the mounting and soldering processes before the conductive plate is formed and provides a solution to achieve mass production. In addition, the present invention adopts the bending process to bend each strip structure to form a 3D curved surface easily, so that the illumination range of the present invention can be designed and adjusted easily.

3. The present invention provides a protection mechanism at an LED chip soldering point, so that the electrode soldering point of each LED chip of the present invention is protected in each manufacturing process to reduce the deformation of each LED chip electrode soldering point and improve the yield rate.

4. The conductive plate of the present invention is a thin sheet that consumes less metal material while reducing the weight of the illumination apparatus of the present invention.

### BRIEF DESCRIPTION OF THE DRAWINGS

FIG. 1 is a perspective view of a flat bulb lamp of the present invention;
FIG. 1(a) is an exploded view of a flat bulb lamp of the present invention;
FIG. 1(b) is a cross-sectional view of a flat bulb lamp of the present invention;
FIG. 1(c) is a circuit diagram of a flat bulb lamp of the present invention;
FIG. 1(d) is a schematic view of a material board of a flat bulb lamp of the present invention;
FIG. 1(e) is a schematic view of a stamping board of a flat bulb lamp of the present invention;
FIG. 1(f) is a perspective view of a support frame of a flat bulb lamp of the present invention;
FIG. 1(g) is a semi-sectional perspective view of an illumination apparatus of a flat bulb lamp of the present invention;
FIG. 1(h) is a schematic view of removing an auxiliary portion of a conductive plate of a flat bulb lamp of the present invention;
FIG. 1(i) is a flow chart of a manufacturing method of an illumination apparatus of a flat bulb lamp of the present invention;
FIG. 2 is a perspective view of a convexly curved surface bulb of the present invention;
FIG. 2(a) is an exploded view of a convexly curved surface bulb of the present invention;
FIG. 2(b) is a sectional view of a convexly curved surface bulb of the present invention;
FIG. 2(c) is a schematic view of a material board of a convexly curved surface bulb of the present invention;
FIG. 2(d) is a schematic view of a stamping board of a convexly curved surface bulb of the present invention;
FIG. 2(e) is a perspective view of a support frame of a convexly curved surface bulb of the present invention;
FIG. 2(f) is a semi-sectional perspective view of an illumination apparatus of a convexly curved surface bulb lamp of the present invention;
FIG. 2(g) is a schematic view of bending and forming a spherical curved surface of a conductive plate of a convexly curved surface bulb lamp of the present invention;
FIG. 2(h) is a schematic view of removing an auxiliary portion of a conductive plate of a convexly curved surface bulb lamp of the present invention;
FIG. 2(i) is a flow chart of a manufacturing method of an illumination apparatus of a convexly curved surface bulb of the present invention;
FIG. 3 is a perspective sectional view of a concavely curved surface bulb of the present invention;
FIG. 3(a) is an exploded view of a concavely curved surface bulb of the present invention;
FIG. 3(b) is a sectional view of a concavely curved surface bulb of the present invention;
FIG. 3(c) is a perspective view of a support frame of a concavely curved surface bulb of the present invention;
FIG. 3(d) is a schematic view of bending and forming a conductive plate of a concavely curved surface bulb of the present invention;
FIG. 3(e) is a schematic view of bending and forming a concave circular curved surface of a conductive plate of a concavely curved surface bulb of the present invention;
FIG. 3(f) is a schematic view of removing an auxiliary portion of an illumination apparatus of a concavely curved surface bulb lamp of the present invention;
FIG. 4 is a perspective semi-sectional view of a hemispherical lamp of the present invention;
FIG. 4(a) is an exploded view of a hemispherical lamp of the present invention;
FIG. 4(b) is a sectional view of a hemispherical lamp of the present invention;
FIG. 4(c) is a circuit diagram of a hemispherical lamp of the present invention;
FIG. 4(d) is a schematic view of a material board of a hemispherical lamp of the present invention;
FIG. 4(e) is a schematic view of a stamping board of a hemispherical lamp of the present invention;
FIG. 4(f) is a perspective view of a support frame of a hemispherical lamp of the present invention;
FIG. 4(g) is a schematic view of an illumination apparatus of a hemispherical lamp of the present invention;
FIG. 5 is a perspective view of a bulb lamp of the present invention;
FIG. 5(a) is an exploded view of a bulb lamp of the present invention;
FIG. 5(b) is a sectional view of a bulb lamp of the present invention;
FIG. 6 is a perspective view of a strip lamp of the present invention;
FIG. 6(a) is a perspective semi-sectional view of a strip lamp of the present invention;
FIG. 6(b) is a circuit diagram of a strip lamp of the present invention;
FIG. 6(c) is a perspective view of a support frame of a strip lamp of the present invention;
FIG. 6(d) is a schematic view of an illumination apparatus of a strip lamp of the present invention;
FIG. 6(e) is a partial perspective sectional view of an illumination apparatus of a strip lamp of the present invention;
FIG. 7 is a perspective view of a rectangular planar lamp of the present invention;
FIG. 7(a) is an exploded view of a rectangular planar lamp of the present invention;
FIG. 7(b) is a sectional view of a rectangular planar lamp of the present invention;
FIG. 7(c) is a schematic view of a material board of a rectangular planar lamp of the present invention;
FIG. 7(d) is a schematic view of a stamping board of a rectangular planar lamp of the present invention;
FIG. 7 (e) shows the external appearance of a support frame of a rectangular planar lamp of the present invention;
FIG 7(f) is a sectional view of a rectangular planar lamp of the present invention;
FIG. 7(g) is a schematic view of forming a longitudinal combining portion of a conductive plate of a rectangular planar lamp of the present invention;
FIG. 7(h) is a schematic view of forming a longitudinal bending portion of a rectangular planar lamp of the present invention;
FIG. 7(i) is a schematic view of forming a transverse combining portion of a rectangular planar lamp of the present invention;
FIG. 7(j) is a schematic view of forming a complete conductive plate of a rectangular planar lamp of the present invention; and
FIG. 7(K) is a flow chart of a manufacturing method of an illumination apparatus of a rectangular planar lamp of the present invention.

### DESCRIPTION OF THE PREFERRED EMBODIMENTS

The aforementioned and other objectives and advantages of this disclosure will become clearer in light of the following detailed description of an illustrative embodiment of this invention described in connection with the drawings.

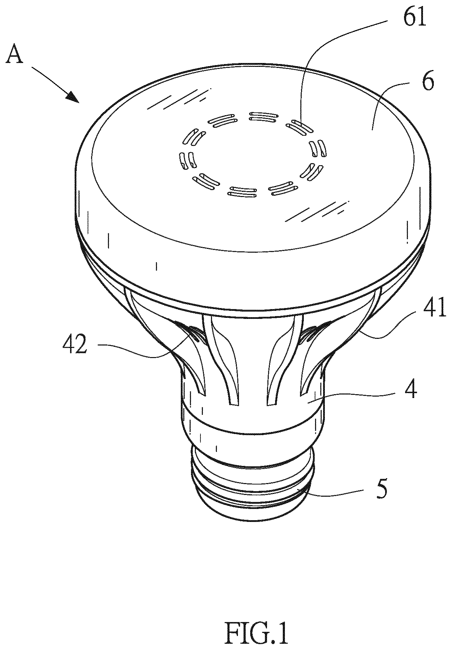

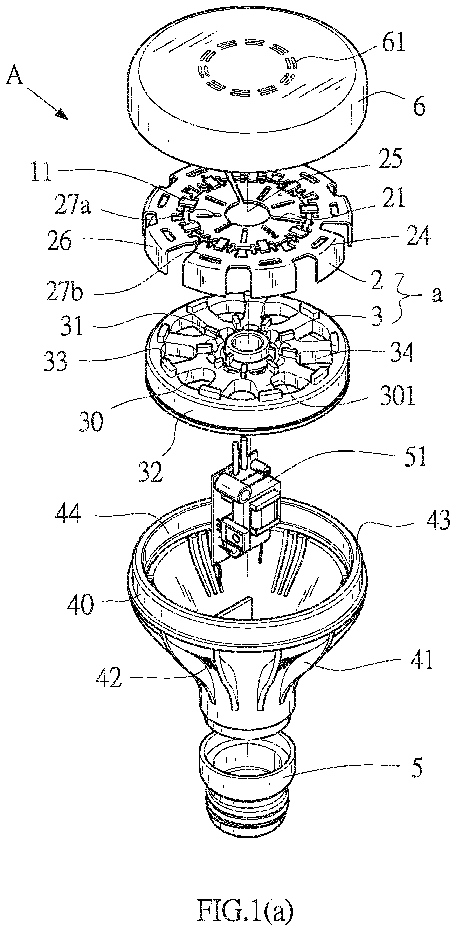

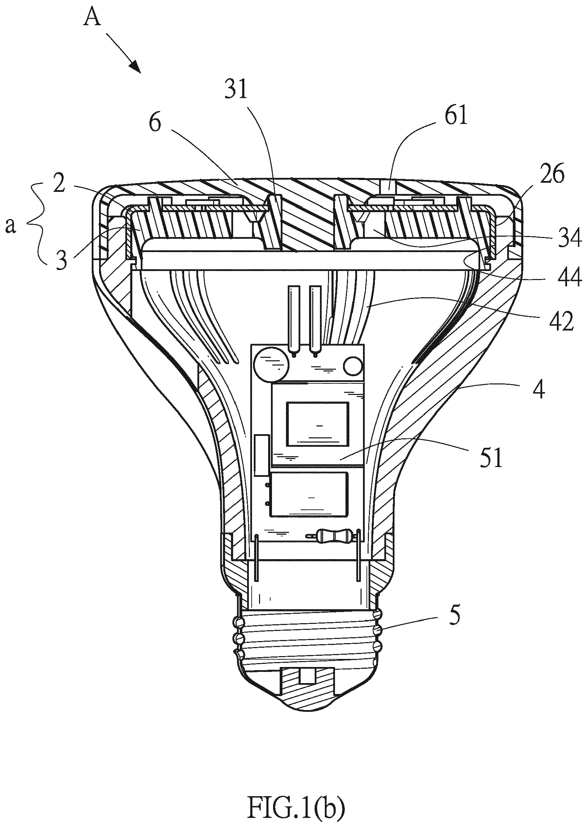

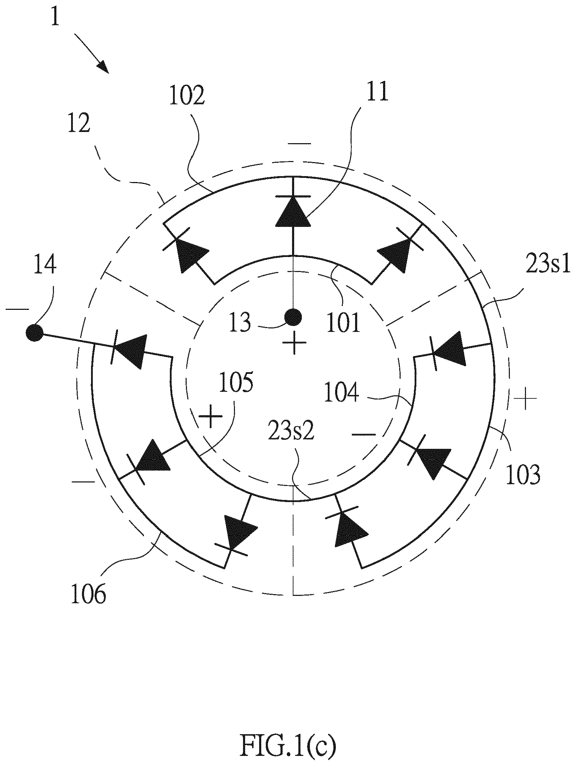

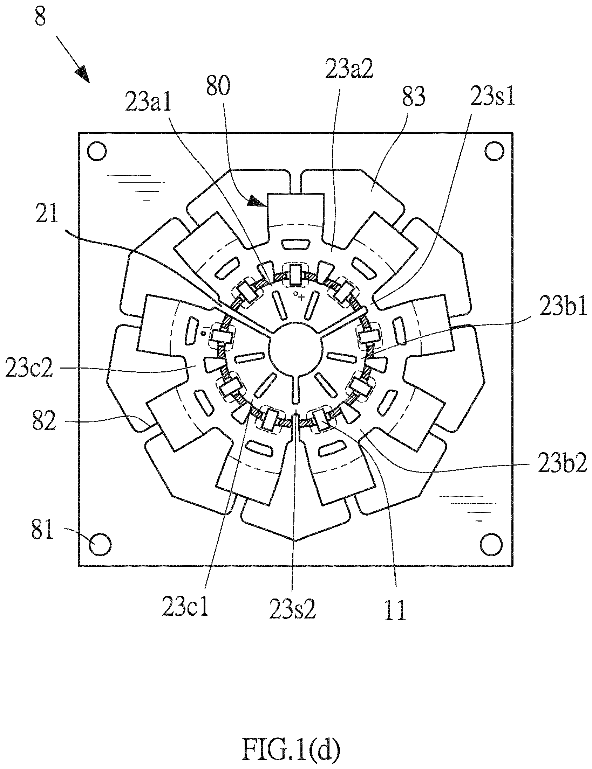

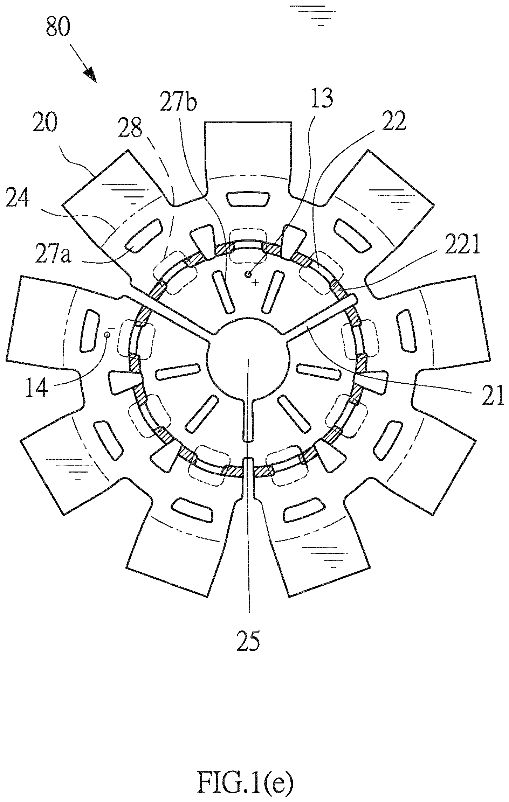

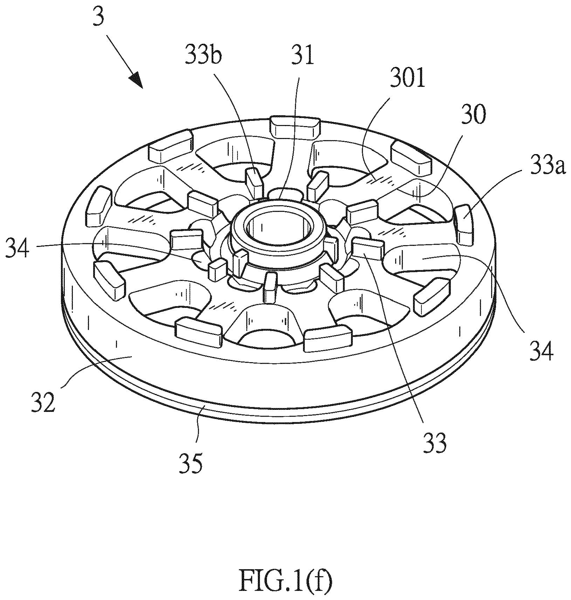

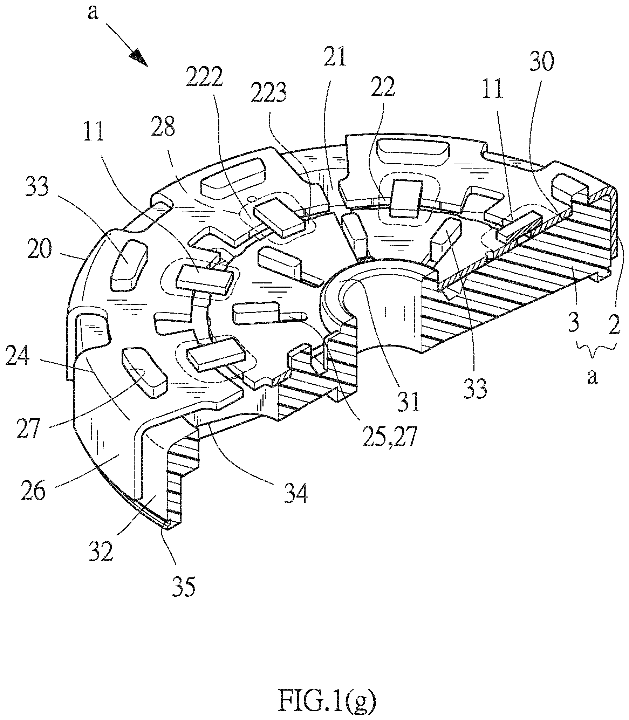

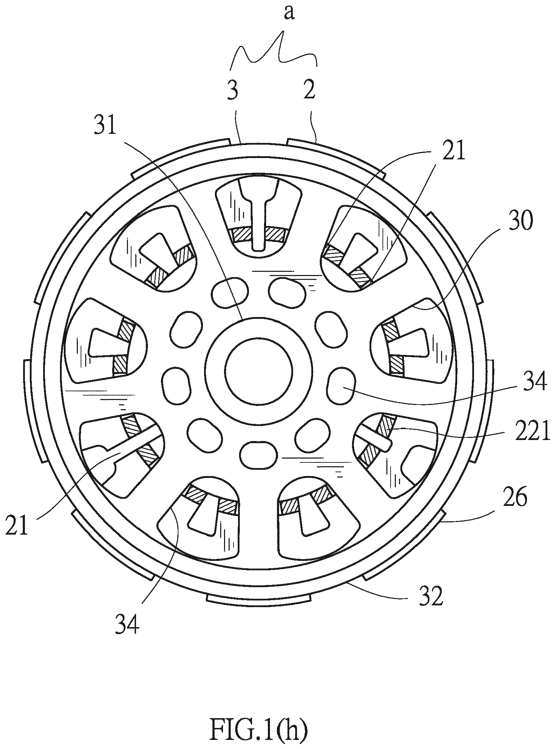

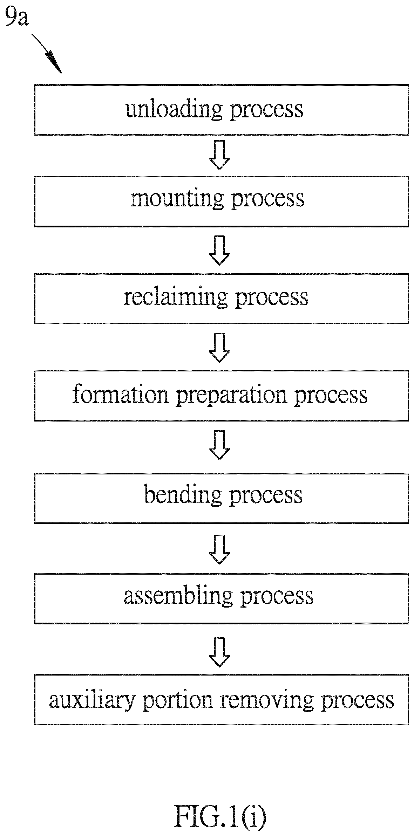

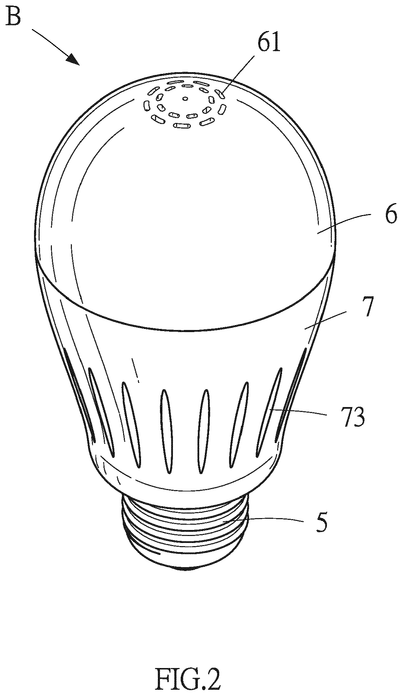

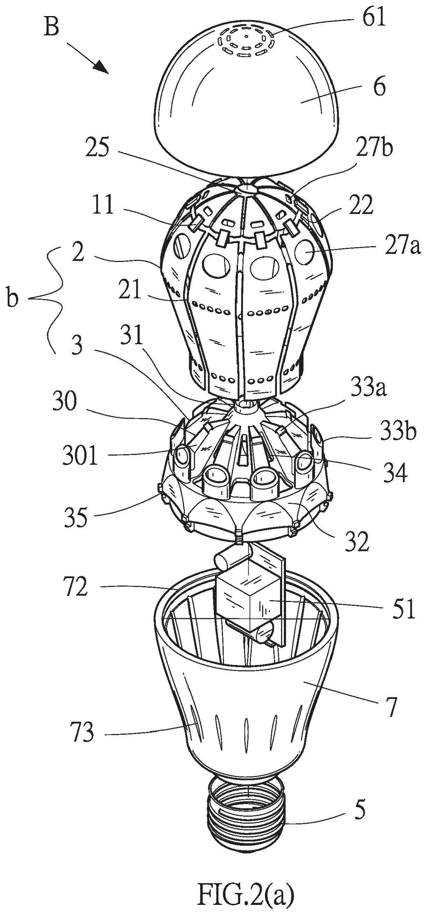

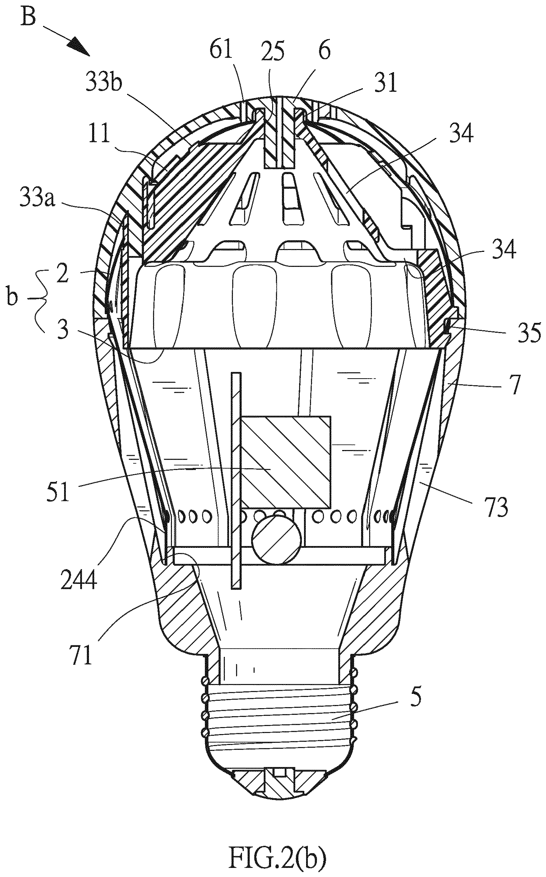

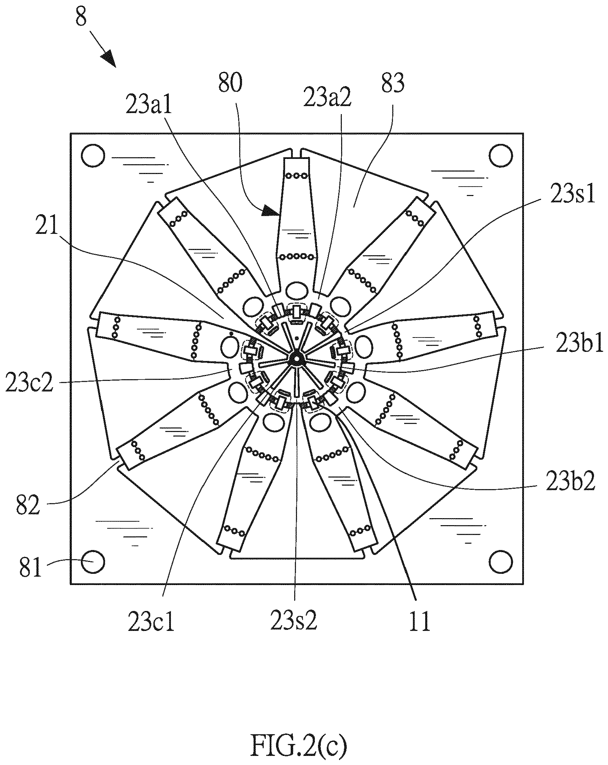

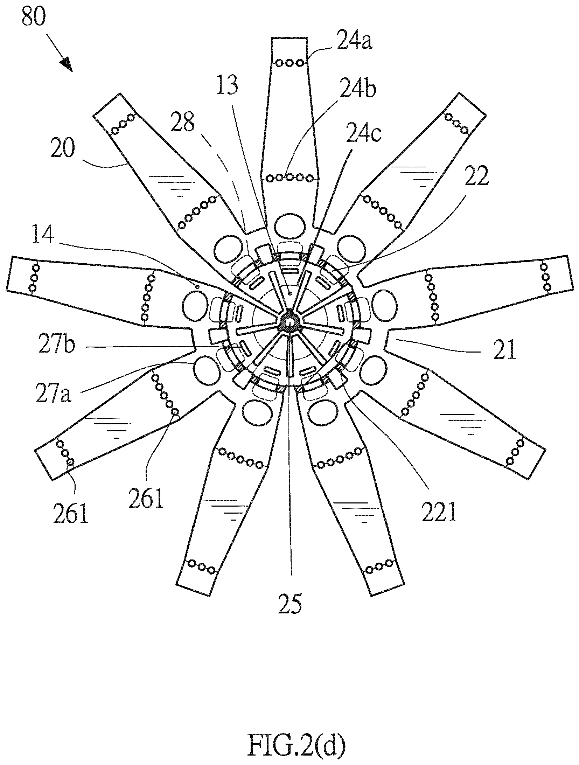

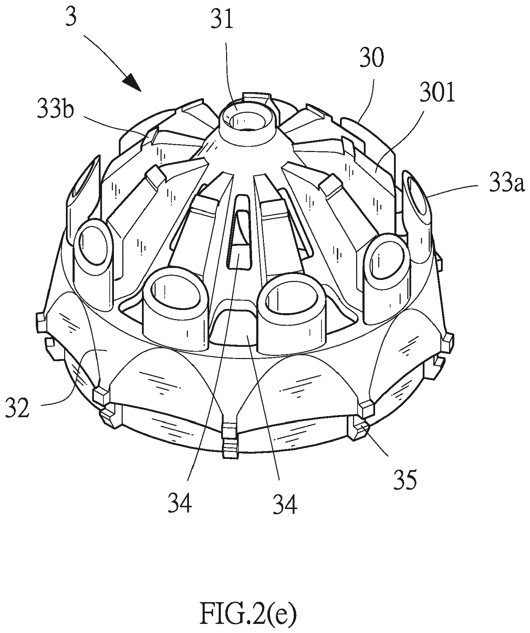

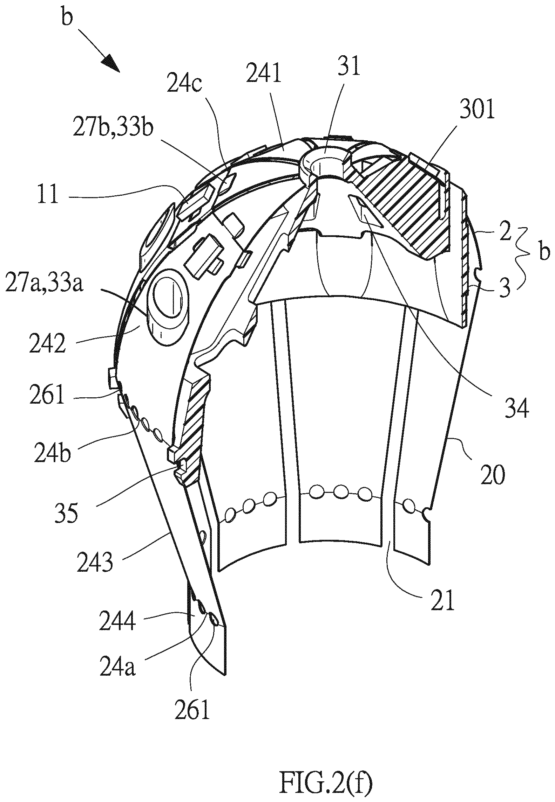

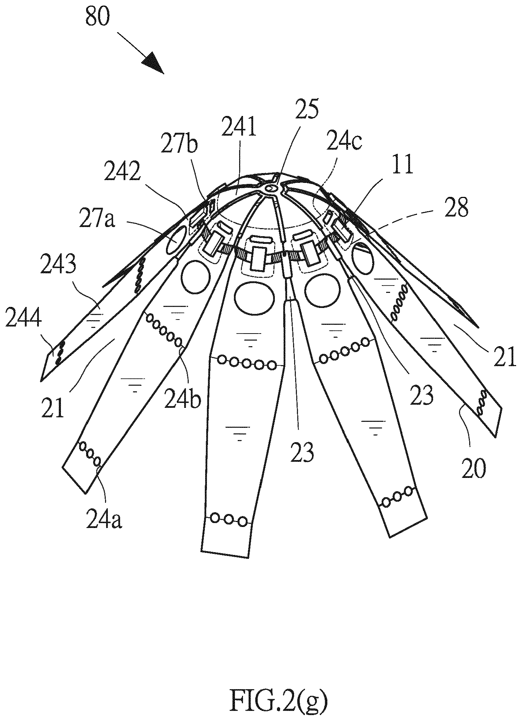

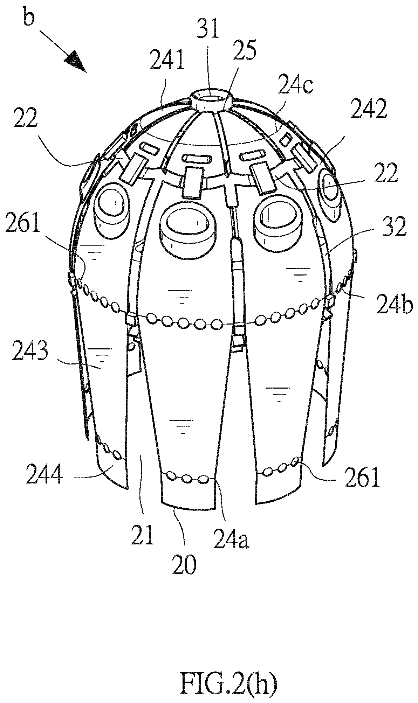

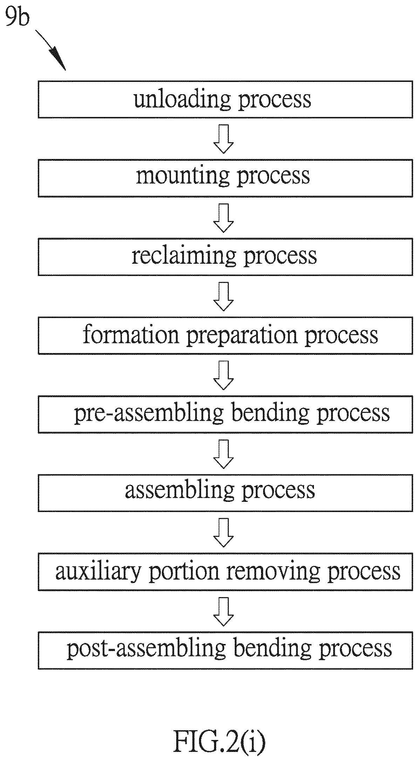

The present invention relates to an LED illumination apparatus and a manufacturing method thereof, and seven embodiments of the present invention and seven system diagrams are provided for illustrating the core technology of the present invention, wherein FIGS. 1∼1(i) illustrate an illumination apparatus and its manufacturing method of a flat bulb lamp in accordance with the first embodiment of the present invention, FIGS. 2∼2(h) illustrates an illumination apparatus of a curved surface in accordance with the second embodiment of the present invention, so on. It is noteworthy that the main components with the same function are represented by their respective numerals respectively in each embodiment of the present invention to simplify the description of the present invention.

With reference to FIG. 1(e) for an illumination apparatus of the first embodiment of the present invention, the illumination apparatus comprises a conductive plate 2 and a support frame 3 combined with each other; wherein the conductive plate 2 is cut into a plurality of strip structures 20 from a plurality of isolation slots 21 by a stamping board 80, and a plurality of connecting portions 23 is disposed across each isolation slot 21 and combined to form a planar sheet structure (if each electrode slot 22 is disposed at the isolation slot 21, then each auxiliary portion 221 will be disposed across the electrode slot 22 and the isolation slot 21 simultaneously), and each auxiliary portion 221 causes a short circuit which is marked by slant sectional lines for the purpose of recognition.

With reference to FIG. 1(g) for an illumination apparatus in accordance with an embodiment of the present invention, the illumination apparatus comprises an electrode soldering point protection mechanism of an LED chip 11 which is a fixed planar structure 29 formed between by each group of fixing holes 27 of the conductive plate 2, the periphery of the LED chip 11 and its non-opening area, and each group of fixing holes 27 of the conductive plate 2 and each group of fixing columns 33 of the support frame 3 are combined with each other, and each support surface 301 disposed between the fixing column 33 is attached to the fixed planar structure 28 for supporting the fixed planar structure 28. It is noteworthy that the fixed planar structure 28 may be a circular strip structure, a concentric circular strip structure, a U-shaped strip arranged structure, or a rectangular arranged structure according to the configuration of each LED chip 11.

Both sides of the electrode slot 22 are divided into a low potential electrode 222 and a high potential electrode 223 respectively. Wherein, the plurality of fixing holes 27 are disposed on both sides of the electrode slot 22, and each group of fixing holes 27 is combined with a group of fixing columns 33 of the support rib 30 for protecting the electrode soldering point of the LED chip 11. In addition, each fixing column 33 is passed and extended to each fixing hole 27 for its connection, so as to fix the fixing column 33 to the corresponsive fixing hole 27 by the deformation of each fixing column 33 or by using an adhesive.

With reference to FIG. 1(g) and 1(h) for an embodiment of the present invention, a support surface 301 of a support rib 30 of the support frame 3 may be attached to the fixed planar structure 28, of the conductive plate 2 for pressing a stamping mold; a ventilation hole 34 is formed between the support ribs 30, and the area of each ventilation hole 34 covers an auxiliary portion 221 to be cut, so that each auxiliary portion 221 is pressed by the stamping mold and cut open.

With reference to FIG. 1(c) for an illumination circuit 1, 10, 100 of different embodiments of the present invention, the illumination circuit 1, 10, 100 comprises a circuit 101, a circuit 102, a circuit 103, a circuit 104, a circuit 105, and a circuit 106. In addition, the conductive plate 2 configured to be corresponsive to a three-series-three-parallel circuit 1 mainly using 3 LED chips 11 for a parallel circuit area 12 (in other words, three strip structures 20 are connected to form the parallel circuit area 12), and there are three parallel circuit areas 12. In addition, at least two connecting portions formed between the parallel circuit areas 12 are used for connecting the parallel circuit areas 12 in series to form the three-series-three-parallel illumination circuit 1.

With reference to FIG. 1(d) for the illumination circuit 1, the power contacts of the illumination circuit 1 are divided into a positive power contact 13 and a negative power contact 14, and the connecting portion 23 in the parallel circuit is further divided into a parallel connecting portion 23a1, a parallel connecting portion 23a2, a parallel connecting portion 23b1, a parallel connecting portion 23b2, a parallel connecting portion 23c1, a parallel connecting portion 23c2, and the connecting portion 23 in the serial circuit is further divided into a serial connecting portion 23s1 and a serial connecting portion 23s2.

With reference to FIG. 1(e), the parallel connecting portion 23a1 connected to a positive power contact 13 corresponsive of the corresponsive circuit 101 as shown in FIG. 1(d) is connected to a high potential contact of the LED chip 11 of the first group, and the parallel connecting portion 23a2 (corresponsive to the circuit 102) is connected to a low potential contact of the LED chip 11 in parallel, and the serial connecting portion 23s1 is connected to the parallel connecting portion 23a2 and the parallel connecting portion 23b1 (corresponsive to the circuit 103); and the parallel connecting portion 23b1 is connected to a high potential contact of the second group of LED chips in parallel, and the parallel connecting portion 23b2 (corresponsive to the circuit 104) is connected to a low potential contact of the second group of LED chips, and the serial connecting portion 23s2 is connected to the parallel connecting portion 23b2 and the parallel connecting portion 23c1 (corresponsive to the circuit 105); and the parallel connecting portion 23c1 is connected to a high potential contact of the third group of LED chips 11 in parallel, and the parallel connecting portion 23c2 (corresponsive to the circuit 106) is connected to a low potential contact of the third group of LED chips 11c in parallel and combined with a positive power contact 14. The seven embodiments of the present invention are described below:

With reference to FIG. 1∼1(b) for a flat bulb lamp A with a planar light emission function in accordance with the first embodiment of the present invention, an illumination apparatus is comprised of a support frame 3 and a conductive plate 2, wherein the flat bulb lamp A comprises a lamp cover 6, an aluminum alloy radiating base 4, a connector 5, a conductive plate 2, a plurality of LED chips 11, a support frame 3, and a power module 51.

With reference to FIGS. 1∼1(b) for the flat bulb lamp A installed in the ceiling, the connector 5 is disposed at the uppermost position; wherein, the lamp cover 6 is disposed at the lowermost position, and the lamp cover 6 is installed and combined to an end opening 43 of the radiating base 4 and has a plurality of ventilation holes 61 to constitute the external appearance of the flat bulb lamp A.

The power module 51 is installed in the radiating base 4 and has a power cord connected to a power contact of the conductive plate 2, and a connector 5 for supplying power to the LED chip 11.

The radiating base 4 is a conical pipe structure and has a plurality of heat dissipating fins 41 disposed at the external periphery of the radiating base 4, and a plurality of ventilation holes 42 are formed between the heat dissipating fins 41, and a heat conduction surface 44 and an external circular surface 40 are situated on both sides of the opening 43 respectively. When the heat generated by each LED chip 11 is conducted to the conductive plate 2, the heat is cooled by air convection and through the large-area heat conduction surface 26 of the conductive plate 2 and the conduction surface 44 of the radiating base 4, and the remained heat is transferred to the heat dissipating fins 41 of the radiating base 4 to facilitate heat dissipation.

With reference to FIG. 1(e) and 1(g), a conductive plate 2 having a circular surface with a shallow cup-shaped structure is installed in the lamp cover 6, and each isolation slot 21 is divided to form nine radial strip structures 20, and each connecting portion 23 is disposed across and connected to the isolation slot 21 to form the illumination circuit of this embodiment. Each strip structure 20 comprises a plurality of fixing holes 27 distributed on both sides of an electrode slot 22, and a bending portion 24 disposed on the external periphery such that after the conductive plate 2 is bent into a circular shape, a heat conduction surface 26 is formed, and the heat conduction surface 26 is connected to the heat conduction surface 44 of the radiating base 4 as shown in FIG. 1(b) and attached to an external circular surface 32 of the support frame 3.

With reference to FIG. 1(f), the support frame 3 corresponsive to the conductive plate 2 is a circular disc structure with the external circular surface 32, and the support frame 3 matched with the conductive plate 2 is formed by nine radially arranged strip support ribs 30, and each support rib 30 has a group of fixing columns 33, and a support surface 301 is formed between the two fixing columns 30, and each support surface 301 is provided for attaching and supporting the fixed planar structure 28 of the conductive plate 2; and a ventilation hole 34 is formed between each support rib 30 to produce a circumferential arrangement, and each group of fixing columns 33 is passed through and combined with the fixing hole 27 of the conductive plate 2, and the external circular surface 32 of the support frame 3 is attached to the bending portion 24 of the conductive plate 2, and the support frame 3 is combined and fixed to a position of the opening 43 of the radiating base. It is noteworthy that each fixing hole 27 of the conductive plate 2, the fixed planar structure 28 of the circular strip structure, and the support rib 30, the support surface 301, and each fixing column 33 of the support frame 3 form the electrode soldering point protection mechanism of the LED chip of the illumination apparatus of this embodiment, and the manufacturing method 9a of an illumination apparatus of this embodiment also adopts the measure of the electrode soldering point protection mechanism of the LED chip.

With reference to FIG. 1(c)∼1(e) for the schematic views of a series-parallel circuit of a flat bulb lamp A and a stamping board 80 (which is the conductive plate 2 before formation) of the present invention, three strip structures 20 form a parallel circuit area 12, and then the serial connecting portion 23s1 and the serial connecting portion 23s2 are arranged and disposed across the isolation slot 21 to connect the plurality of parallel circuit areas 12 in series, so as to form the three-series-three-parallel illumination circuit 1 of this embodiment.

With reference to FIG. 1(i) for a manufacturing method 9a of an illumination apparatus a of the present invention, the method comprises an unloading process, a mounting process, a reclaiming process, a formation preparation process, a bending process, an assembling process and an auxiliary portion removing process.

With reference to FIGS. 1(d) and 1(e) for the unloading process, a material board 8 is processed through a stamping process, so that the material board 8 has the feature of an external appearance with a stamping board 80, a plurality of connecting plates 82, a plurality of positioning holes 81 and a plurality of cut holes 83.

In the mounting process, each LED chip 11 is soldered onto the plurality of electrode slots 22 of the stamping board 80.

In the reclaiming process, the plurality of connecting plates 82 are cut from the material board 8 and a stamping board 80 is removed.

In the formation preparation process, a stamping mold is provided to press the positioning portion 25 of the stamping board 80 and the fixed planar structure 28 closely.

In the bending process, the stamping board 80 bends the bending portion 24 to form a 3D conductive plate 2 as shown in FIG. 1(a).

In the assembling process as shown in FIG. 1(g), the support frame 3 and the conductive plate 2 are combined, and the external circular surface 32 and the bending portion 24 are attached to the heat conduction surface 26, and each fixing column 33 is passed through and combined with each fixing hole 27, and the support surface 301 of each support rib 30 supports and fixes the fixed planar structure 28 of the circular strip, and the fixing ring 31 of the support frame 3 is passed through the center hole of the positioning portion 25 for providing the support of the conductive plate 2 in the follow-up operations and completing the electrode soldering point protection mechanism, of the LED chip to facilitate the follow-up processes.

With reference to FIG. 1(h) for the auxiliary portion removing process, a stamping mold is provided for pressing the support frame 3 and the conductive plate 2 and cutting open each auxiliary portion 221, so that the position of the short-circuit auxiliary portion 221 becomes the electrode slot 22, so as to form the complete three-series-three-parallel illumination circuit 1 of this embodiment as shown in FIG. 1(c).

With reference to FIG. 2~2(b) for a convexly curved surface bulb B having a light emission function on a convex curved surface in accordance with the second embodiment of the present invention, an illumination apparatus b is comprised of a support frame 3 and a conductive plate 2, and the illumination circuit 1 of the aforementioned first embodiment is adopted. Wherein, the convexly curved surface bulb B comprises a lamp cover 6, a protective cover 7, a connector 5, a conductive plate 2, a plurality of LED chips 11, a support frame 3, and a power module 51.

The illumination apparatus B of this embodiment installed in the ceiling has a connector 5 disposed at the uppermost position, and the lamp cover 6 is disposed at the lowermost position. The lamp cover 6 is connected to the support frame 3 disposed at the position of an end opening of the protective cover 7 and the other end of the protective cover 7 is connected to the connector 5 to form the external appearance of the convexly curved surface bulb B of this embodiment.

The lamp cover 6 is a hemispherical opening structure installed outside the illumination apparatus b and made of a transparent or semi-transparent material, and the lamp cover 6 has a plurality of ventilation holes 61, and the lamp cover 6 is embedded into the latch slot 35 and other through holes of the support frame 3 for the fixation and combination purpose as shown in FIG. 2(b).

The protective cover 7 is a long curved conical tubular structure installed outside the illumination apparatus b and has a fixing slot 71 and a plurality of ventilation holes 73 formed thereon, wherein the cylindrical surface 244 of the conductive plate 2 is fixed to the fixing slot 71 as shown in FIG. 2(b).

The power module 51 is installed in the conductive plate 2 and fixed into the protective cover 7, and the power module 51 has a power cord connected to the conductive plate 2 and the connector 5 for supplying the required power to the LED chip 11 of the present invention as shown in FIG. 2 (b).

With reference to FIGS. 2(a), 2(b) and 2(f), the conductive plate 2 has a 3D curved surface, and the support frame 3 is provided for supporting and fixing the conductive plate 2, and the conductive plate 2 is divided by each isolation slot 21 to form a circumferentially arranged strip structure 20, and an end of the conductive plate 2 is a hemispherical curved surface formed by a spherical curved surface 241 and a circular curved surface 242, and the other end of the conductive plate 2 is in a conical shape formed by a conical curved surface 243 and a cylindrical surface 244.

With reference to FIG. 2(d) for a structure of the conductive plate 2, the structure comprises a power contact, a plurality of electrode slots 22, a positioning portion 25, a plurality of connecting portions 23, a plurality of isolation slots 21, and a plurality of strip structures 20. Each isolation slot 21 is extended radially outward to divide the conductive plate 2 into nine strip structures 20 distributed at equal angles and disposed around the periphery of the center hole of the positioning portion 25. The connecting portion 23 disposed across the isolation slot 21 is bent by the stamping mold into a V-shape to reduce the circumference, so as to form a 3D curved surface structure of the conductive plate 2 to meet the series-parallel connection requirement of the illumination circuit 1.

With reference to FIG. 2(g), each strip structure 20 arranging in a direction from the cylindrical surface 244 towards the spherical curved surface 241 comprises a bending portion 24a disposed between the cylindrical surface 244 and the conical curved surface 243, a bending portion 24b disposed between the circular curved surface 242 and the conical curved surface 243, a bending portion 24c disposed on the spherical curved surface 241; a plurality of fixing holes 27b disposed on the spherical curved surface 241, a plurality of fixing holes 27a disposed on the circular curved surface 242, wherein the two fixing holes 27a, 27b form a group; the electrode slot 22 is formed between the spherical curved surface 241 and the circular curved surface 242 and disposed at the middle of each group of fixing holes 27.

With reference to FIG. 2(e), the support frame 3 is an opening hemispherical structure formed by nine radially arranged support ribs 30, and each support rib 30 has a group of fixing columns 33a, 33 b, a support surface 301 formed between the group of fixing columns 33a, 33 b, and each support surface 301 is provided for attaching and supporting the fixed planar structure 28 of the conductive plate 2; two ventilation holes 34 are formed between each support rib 30; a fixing ring 31 is disposed at the middle of the support frame 3, and a plurality of external circular surfaces 32 are formed at the external circumference of the support frame 3; the fixing ring 31 is passed through the center hole of the positioning portion 25 of the conductive plate 2; each external circular surface 32 has a plurality of latch slots 35 formed thereon and provided for combining the lamp cover 6 and the protective cover 7. It is noteworthy that each fixing hole 27a, 27b and the fixed planar structure 28 of the conductive plate 2 and the support rib 30, the support surface 301, and each fixing column 33a, 33b of the support frame 3 form an electrode soldering point protection mechanism of the LED chip with a circular strip structure of an illumination apparatus b of this embodiment, and the manufacturing method 9b of an illumination apparatus b of this embodiment also has the measure of the soldering point protection mechanism of the LED chip electrode.

With reference to FIGS. 1(c) and 2(c) for the illumination circuit 1 of the illumination apparatus b, and the illumination circuit 1 is a three-series-three-parallel illumination circuit 1, the relation with the structure of the conductive plate 2 of this embodiment is illustrated. Each strip structure 20 has an LED chip 11 and uses three strip structures 20 and the LED chip 11 to form a parallel circuit area 12, and there are three groups of parallel circuit areas 12, and the two connecting portions 23s1, 23s2 connect each parallel circuit area 12 in series to form the illumination circuit 1.

With reference to FIG. 2(i) for a manufacturing method 9b of an illumination apparatus b of this embodiment, the manufacturing method 9b comprises an unloading process, a mounting process, a reclaiming process, a formation preparation process, a pre-assembling bending process, an assembling process, an auxiliary portion removing process and a post-assembling bending process. It is noteworthy that this embodiment and the following embodiments have the same unloading process, mounting process, and reclaiming process of the stamping board 80 as those of the first embodiment, and thus they will not be repeated.

With reference to FIGS. 2(i), and 2(f)∼2(h) for the process of bending and forming the conductive plate 2 by the stamping board 80, the stamping mold 80 is used in the formation preparation process as shown in FIG. 2(g) to position the center hole of the positioning portion 25 and press the circular strip fixed planar structure 28 and bend each connecting portion 23 disposed across the isolation slot 21 on the stamping board 80 into a V-shape to weaken the strength of each connecting portion 23 along the circumferential direction, and then reduce the strip structure near the bending portion 24c along the circumferential direction, so that the width of each isolation slot 21 is further reduced, and the V-shaped connecting portion 23 is bent further into a deep V-shape, and the stamping board 80 of the planar structure is a conical structure as shown in FIG. 2(g). Wherein, each strip structure 20 at the outermost periphery in the circumferential direction is not bent into a curved surface, and the circular strip fixed planar structure 28 of this process can still be maintain to be planar to protect the electrode soldering point of the LED chip, so as to minimize the deformation.

The pre-assembling bending process further comprises a spherical curved surface bending process and a circular curved surface bending process. With reference to FIG. 2(g) for the spherical curved surface bending process, a stamping mold is provided for pressing the circular strip fixed planar structure 28 to a predetermined conical angle to bend the bending portion 24c to form a spherical curved surface 241, so that the circular curved surface 242, the conical curved surface 243, and the cylindrical surface 244 form a conical surface, and the width of each isolation slot 21 disposed on the external diameter is reduced significantly. With reference to FIG. 2(h) for the circular curved surface bending process, the positioning portion 25 is cut and removed to form a circular center hole, and then the stamping mold is used to press and fix each fixed planar structure 28 again, and each bending portion 24b is bent to form the circular curved surface 242, the spherical curved surface 241 and the circular curved surface 242 to form a hemispherical shape. Now, the width of the isolation slot 21 disposed at the external diameter is reduced.

With reference to FIG. 2(h) for the assembling process, the support frame 3 and the conductive plate 2 (which is the stamping board 80) are combined, and its external circular surface 32 is attached to the bending portion 24b of the conductive plate 3 for providing the support for the follow-up operations and complete the electrode soldering point protection mechanism of the LED chip.

In the auxiliary portion removing process, the stamping mold is provided for pressing the support frame 3 and the conductive plate 2 and then cutting open each auxiliary portion 221, so that the position of the original short-circuit auxiliary portion 221 has become the electrode slot 22.

The post-assembling bending process further comprises a conical curved surface bending process and a cylindrical surface bending process. With reference to FIG. 2(f), the stamping mold is finally used for fixing the support frame 3 to bend the bending portion 24a and the bending portion 24b of the conductive plate 2. Due to the bending hole 261, the structural strength is weakened, so that the conical curved surface 243 and the cylindrical surface 244 can be formed to complete the three-series-three-parallel illumination circuit 1 of this embodiment.

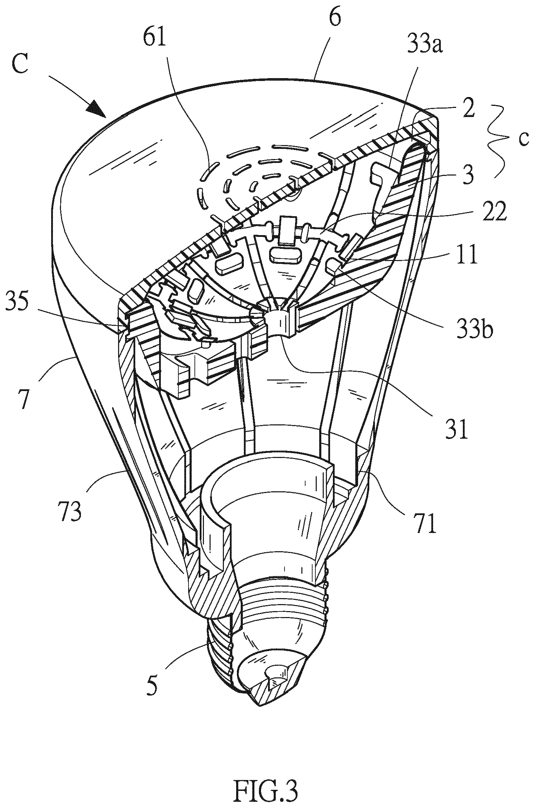

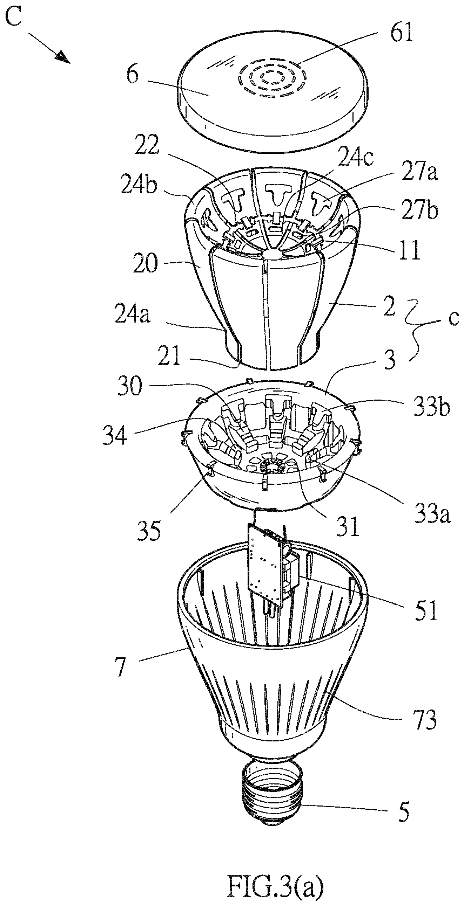

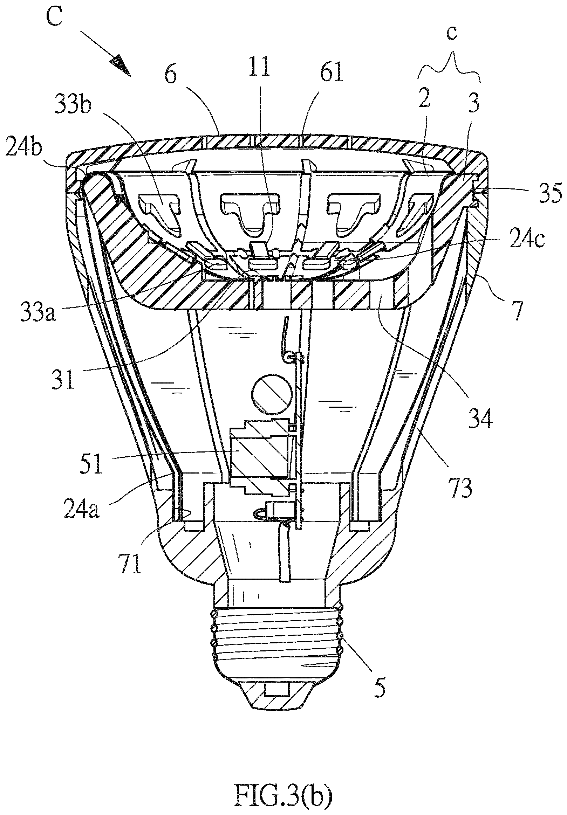

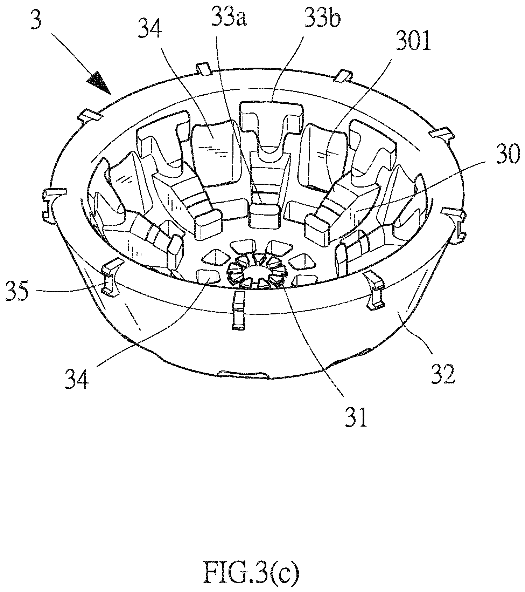

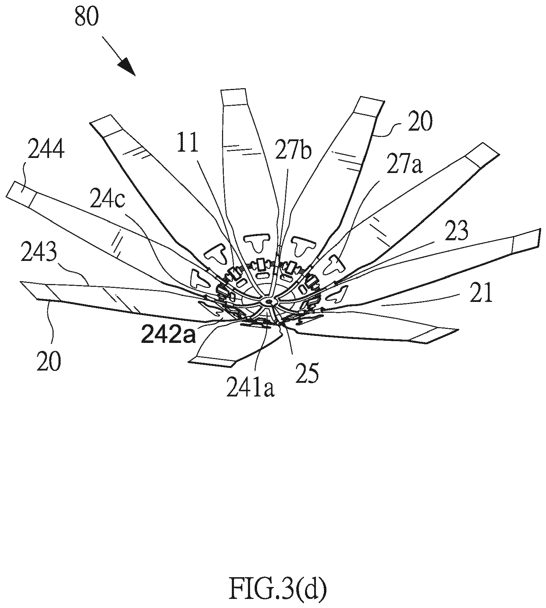

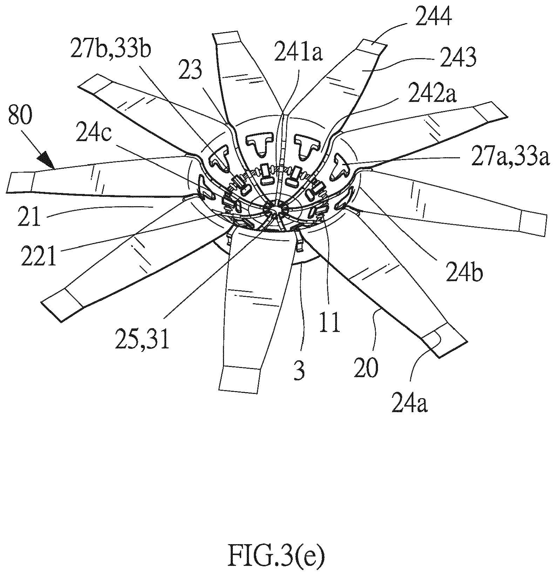

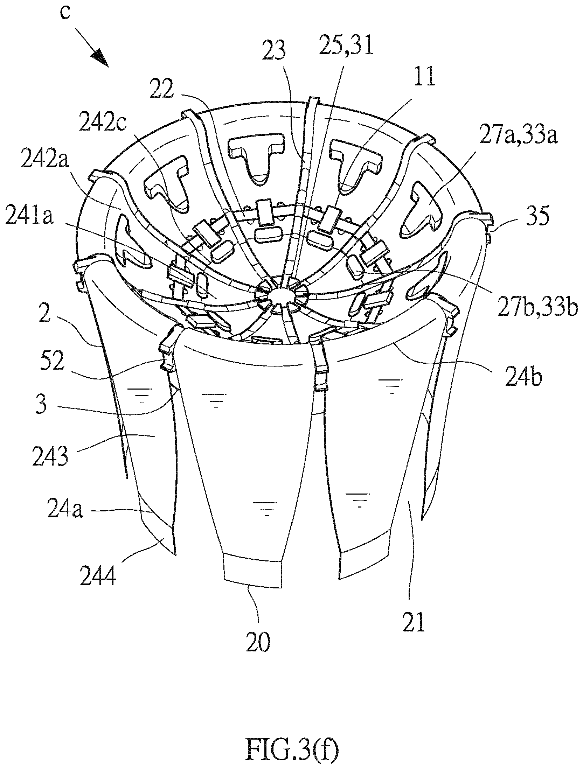

With reference to FIG. 3~3(b) for a concavely curved surface bulb C having a light emission function at a concavely curved surface in accordance with the third embodiment of the present invention, an illumination apparatus c of this embodiment is comprised of a support frame 3 and a conductive plate 2, wherein the concavely curved surface bulb C comprises a lamp cover 6, a protective cover 7, a connector 5, a conductive plate 2, a plurality of LED chips 11, a support frame 3, and a power module 51. It is noteworthy that this embodiment adopts the aforementioned illumination circuit 1, the lamp cover of the first embodiment, and the protective cover and the power module 51 of the second embodiment.

With reference to FIGS. 3(a) and 3(b) for a concavely curved surface bulb C installed in the ceiling, a connector 5 is disposed at the uppermost position, and the lamp cover 6 is disposed at the lowermost position. In addition, the lamp cover 6 and an end opening of the protective cover 7 are connected to a latch slot 35 of the support frame 3, and the other end of the protective cover 7 is connected to the connector 5 to form the external appearance of the concavely curved surface bulb C.

With reference to FIG. 3(f) for a stamping board 80 of a conductive plate 2 of this embodiment which is similar to the aforementioned second embodiment, the formation process forms a convex curved surface by the spherical curved surface 241 and the circular curved surface 242 of the aforementioned second embodiment which is bent into concave hemispherical curved surface formed by a concave spherical surface 241a and a concave circular curved surface 242a. In the formation operation of the concave circular curved surface 242a, the bending portion 24b is bent in a reverse direction into a U-shape.

The conductive plate 2 of this embodiment is installed in the lamp cover 6 and the protective cover 7, and the conductive plate 2 is supported and fixed into the support frame 3. In addition, the conductive plate 2 is divided by each isolation slot 21 into circumferentially arranged strip structure 20 and distributed at the periphery of the positioning portion 25. In addition, an end of the conductive plate 2 is a concave hemispherical curved surface formed by the concave spherical surface 241a and the concave circular curved surface 242a, and the other end of the conductive plate 2 is in a conical shape formed by the conical curved surface 243 and the cylindrical surface 244, and the bending portion 24b is bent into a U-shape, and then the cylindrical surface 244 of the conductive plate 3 is fixed into the fixing slot 71 of the protective cover 7.

With reference to FIG. 3(a) for the structure of the conductive plate 2, the conductive plate 2 comprises a power contact, a positioning portion 25, a plurality of connecting portions 23, a plurality of isolation slots 21, and a plurality of strip structures 20. Each connecting portion 23 disposed across the isolation slot 21 is bent by the stamping mold into a V-shape to reduce the circumference to form the 3D structure. With reference to FIGS. 3(d) and 3(e), each strip structure 20 arranging in a direction from the cylindrical surface 244 towards the concave spherical surface 241a comprises a bending portion 24a disposed between the cylindrical surface 244 and the conical curved surface 243, a bending portion 24b disposed between the concave circular curved surface 242a and the conical curved surface 243, a bending portion 24c disposed on the concave spherical surface 241a; a plurality of fixing holes 27b disposed on the concave spherical surface 241a, and another fixing hole 27a disposed on the concave circular curved surface 242a, and the two fixing holes 27a, 27b form a group; each electrode slot 22 is formed between the concave spherical surface 241a and the concave circular curved surface 242a and disposed between each group of fixing holes 27.

With reference to FIGS. 3 and 3(c), the support frame 3 is an opening concave hemispherical structure installed in the conductive plate 2 having a 3D curved surface and formed by a plurality of radially arranged support ribs 30, and each support rib 30 has fixing columns 33a, 33b which are group into two, and more than one ventilation hole 34 are formed between each support rib 30; the center of the support frame 3 has a fixing ring 31 and the external circumference of the support frame 3 has an external circular surface 32; each group of fixing columns 33a, 33b are passed through and combined with each group of fixing holes 27a, 27b of the conductive plate 2, and the fixing ring 31 is passed through the center hole of the positioning portion 25 of the conductive plate 2; the external circular surface 32 of the support frame 3 is disposed on an opening end and capable of attaching the bending portion 24b of the conductive plate 2, and the latch slot 35 is provided for fixing the lamp cover 6 and the protective cover 7. The power module 51 is installed in the protective cover 7 and a power cord is connected to the conductive plate 2 and the connector 5. It is noteworthy that each fixing hole 27a, 27b of the conductive plate 2, the fixed planar structure 28 of the circular strip, and the support rib 30, the support surface 301 and each fixing column 33a, 33b of the support frame 3 form the electrode soldering point protection mechanism of the LED chip of the illumination apparatus c of this embodiment, and the manufacturing method 9 of an illumination apparatus of the following embodiment also has the LED chip electrode soldering point protection mechanism.

With reference to FIG. 2(i) for a manufacturing method of an illumination apparatus c of this embodiment, the manufacturing method comprises an unloading process, a mounting process, a reclaiming process, a formation preparation process, a pre-assembling bending process, an assembling process, an auxiliary portion removing process and a post-assembling bending process.

In the formation preparation process as shown in FIG. 2(d), a stamping mold is provided for positioning the center hole of the positioning portion 25 to press the circular strip fixed planar structure 28 and bend the connecting portion 23 of a serial circuit disposed across the isolation slot 21 into a V-shape to weaken the strength of the connecting portion 23 along the circumferential direction. With reference to FIG. 3(d), the strip structure 20 near the bending portion 24b is reduced along the circumferential direction to further reduce the width of each isolation slot 21, and each V-shaped connecting portion 23 is bent further into a deep V-shape. In other words, the stamping board 80 (which is the conductive plate 2) with a planar structure is a conical structure. Now, each LED chip 11 is installed on an inner side, wherein each strip structure 20 along the circumferential direction is not bent into a curved surface yet. In this process, the fixed planar structure 28 of the circular strip still maintains to be planar to protect the electrode soldering point of the LED chip 11, so as to minimize the deformation, since most deformations usually occur at the connecting portion 23 and the isolation slot 21 with a reduced width.

With reference to FIGS. 3(c), 3(d) and 3(e) for the pre-assembling bending process, the pre-assembling bending process further comprises a concave spherical surface bending process and a concave circular curved surface bending process, wherein the concave spherical surface bending process uses a stamping mold to press and fix the positioning portion 25 and the circular strip fixed planar structure 28 at a predetermined conical angle, and then the bending portion 24c is bent into the concave spherical surface 241a, and the concave circular curved surface 242a, the conical curved surface 243, and the cylindrical surface 244 form a conical surface. Now, the width of the isolation slot 21 disposed at the external diameter is reduced significantly.

With reference to FIG. 3(e), the concave circular curved surface bending process uses the stamping mold to press and fix the positioning portion 25 and the circular strip fixed planar structure 28 and bend the bending portion 24b, so that the conical curved surface 243 and the cylindrical surface 244 form a radial plane, and each LED chip 11 is still disposed on the inner side, and the width of the isolation slot 21 disposed on the concave circular curved surface 242a is reduced, and the width of each isolation slot 21 disposed on the external diameter is relatively larger due to the planar shape. And then, the positioning portion 25 is cut and removed to form the circular center hole, and the stamping mold is used again to press and fix the circular strip fixed planar structure 28 and bend the bending portion 24b, so that the concave circular curved surface 242a is formed. In other words, the concave spherical surface 241a and the concave circular curved surface 242a jointly form a concave hemispherical curved surface.

With reference to FIG. 3(e), the bending portion 24b is bent, and a inverted U-shape is formed between the concave circular curved surface 242a and the conical curved surface 243, and the conical curved surface 243 and the cylindrical surface 244 form an outwardly flapped cylindrical shape, and the V-shaped connecting portion 23 disposed across the isolation slot 21 is further bent, and the width of the isolation slot 21 on the conical curved surface 243 and the cylindrical surface 244 is reduced.

In the assembling process as shown in FIG. 3(e), the support frame 3 and the conductive plate 2 are combined, and the external circular surface 32 is attached to an inner curved surface of the U-shaped bending portion 24b for providing the support of the conductive plate 2 in the follow-up operations, and completing the electrode soldering point protection mechanism of the LED chip 11 to facilitate the follow-up processes.

With reference to FIG. 3(e) for the auxiliary portion removing process, the stamping mold is used for pressing the support frame 3 and the conductive plate 2 and cutting open each auxiliary portion 221, and the position of the original short-circuit auxiliary portion 221 becomes the electrode slot 22.

The post-assembling bending process further comprises a conical curved surface bending process and a cylindrical surface bending process. With reference to FIG. 3(f), the stamping mold is provided for fixing the support frame 3 and forming a conical curved surface 243 and a cylindrical surface 244 of the conductive plate 2. Since the bending portion 24b and the bending portion 24a have a bending hole (not shown in the figure), the structural strength is weakened, and the stamping mold can bend the bending portions easily, and the external circular surface 32 of the support frame 3 is attached to the U-shaped bending portion 24b to provide the required support for the following bending operation, and form the conical curved surface 243 and the cylindrical surface 244, so as to complete the three-series-three-parallel illumination circuit 1 of this embodiment.

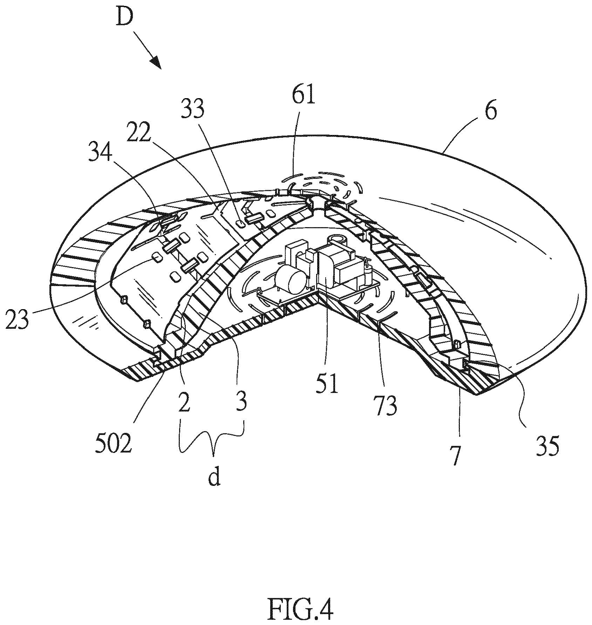

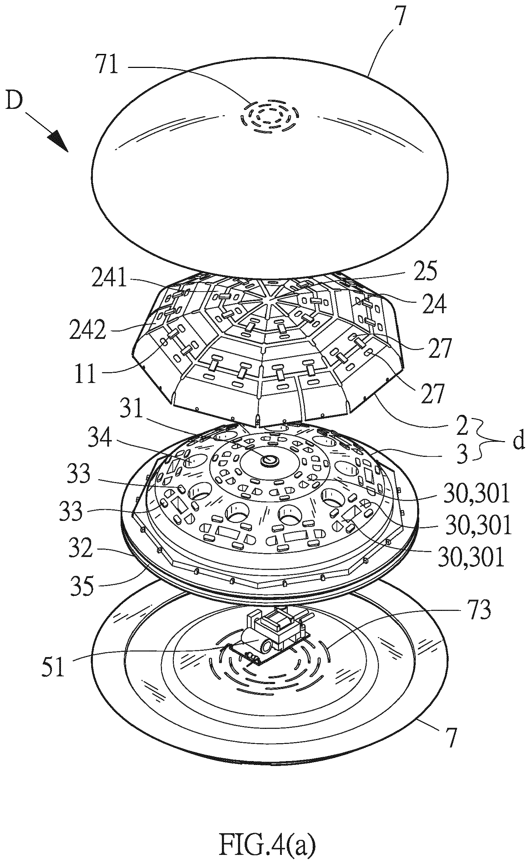

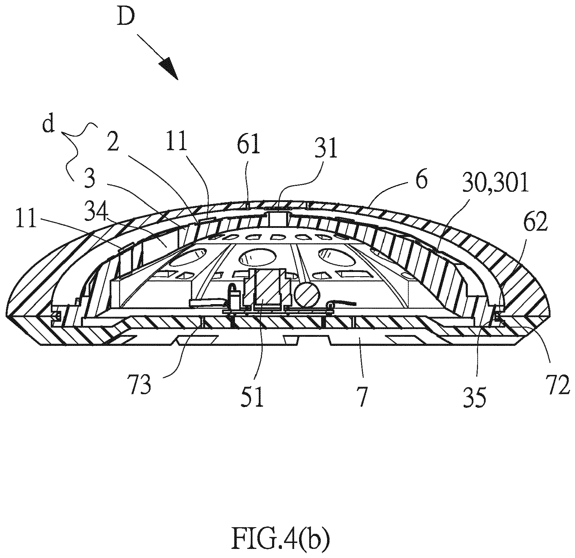

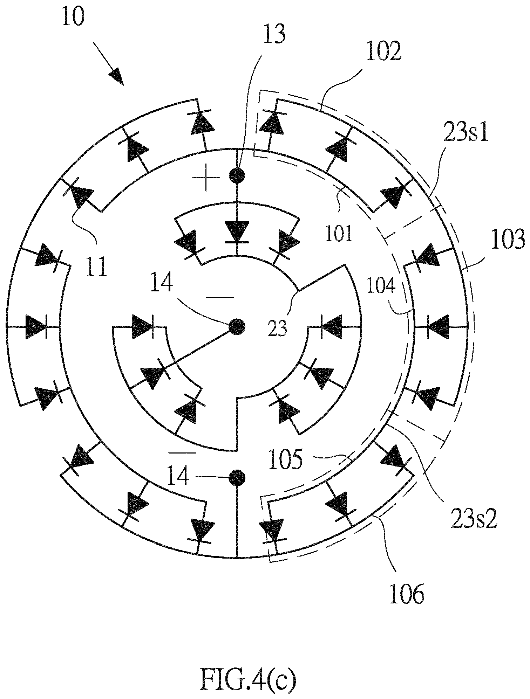

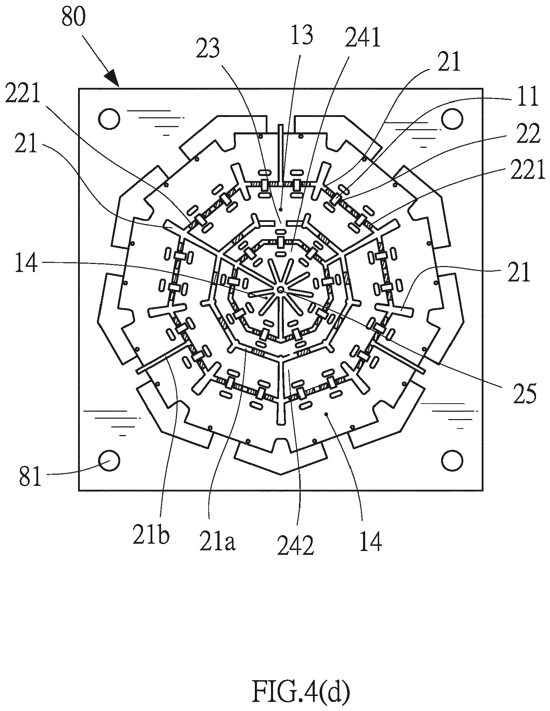

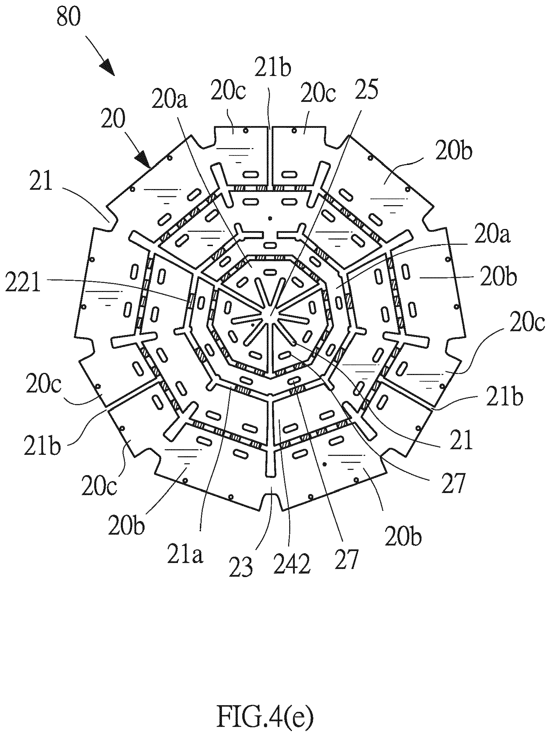

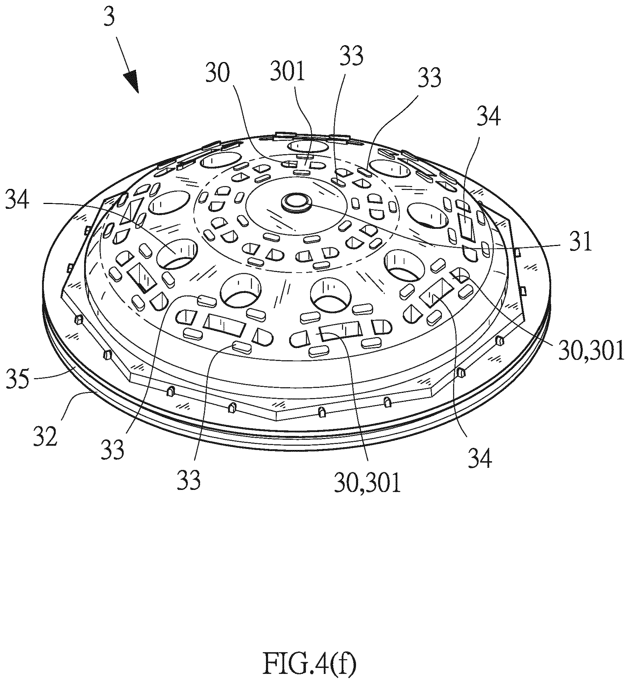

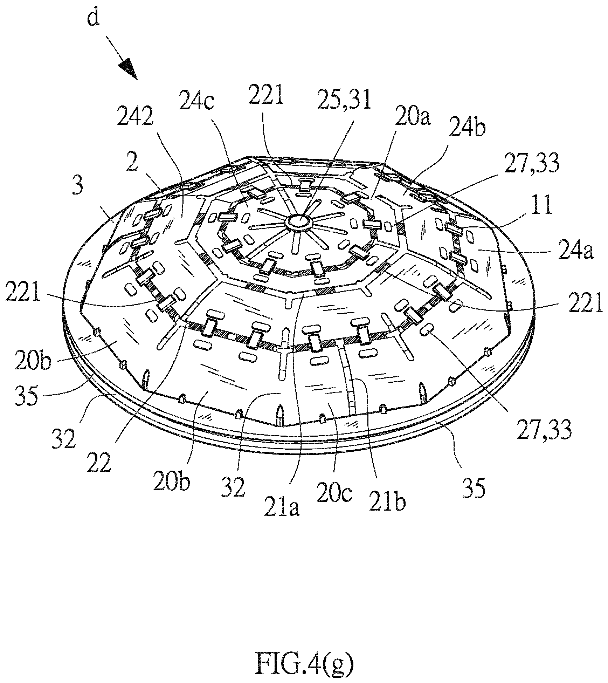

With reference to FIGS. 4~4(c) for a hemispherical lamp D of the fourth embodiment of the present invention, an illumination apparatus is comprised of a support frame 3 and a conductive plate 2, and the illumination circuit 10 is comprised of three groups of three-series-three-parallel circuits, and there are a total of 27 LED chips 11. In addition, the illumination apparatus d of the hemispherical lamp comprises a lamp cover 6, a protective cover 7, a conductive plate 2, a plurality of LED chips 11, a support frame 3, and a power module 51.

When the hemispherical lamp D is installed, the protective cover 7 id disposed at the uppermost position, and the lamp cover 6 is disposed at the lowermost position. Both of the lamp cover 6 and the protective cover 7 are installed into a latch slot 35 of the support frame 3 simultaneously as shown in FIG. 4(b), so as to form the structure of the hemispherical lamp D.

The lamp cover 6 is a hemispherical opening structure made of a transparent or semi-transparent material, and the lamp cover 6 has the latch ring 62 and a plurality of ventilation holes 61. The protective cover 7 is a shallow circular opening structure having the latch ring 72 and a plurality of ventilation holes 73, wherein the aforementioned two latch rings 62, 72 are latched into the latch slot 35 of the support frame 3.

The power module 51 installed in the protective cover 7, and a power cord of the power module 51 is electrically coupled to the conductive plate 2 for supplying the required power to each LED chip 11 of the present invention.

With reference to FIG. 4(g), the conductive plate 2 is installed in an internal space formed by the lamp cover 6 and the protective cover 7, and the conductive plate 2 is supported and fixed by the support frame 3, and the conductive plate 2 has an end with a hemispherical curved surface formed by a spherical curved surface 241 and a circular curved surface 242.

With reference to FIG. 4(f), the support frame 3 is a semi-opening hemispherical structure installed in the conductive plate 2 and has 9 radially arranged support ribs 30 disposed opposite to the spherical curved surface 241, and 18 radially arranged support ribs 30 disposed on the circular curved surface 242, and each support rib 30 has a group of fixing columns 33; and at least one ventilation hole 34 is formed between two adjacent support ribs 30; and a fixing ring 31 is installed at the middle of the support frame 3, and an external circular surface 32 is formed around the external periphery of the support frame 3, and the external circular surface 32 has the latch slot 35; each group of fixing columns 33 are passed through each group of fixing holes 27 of the conductive plate 2, so that the fixing ring 31 is sheathed by the center hole of the positioning portion 25 of the conductive plate 2.

With reference to FIG. 4(c) for the illumination circuit 10 of the hemispherical lamp D and FIG. 4(d) for the circuit of the stamping board 80, the spherical curved surface 241 has a group of 3-series-3-parallel-connection illumination circuits, and the circular curved surface 242 has two groups of 3-series-3-parallel-connection illumination circuits.

With reference to FIGS. 4(d) and 4(e), the stamping board 80 is divided by 9 radial isolation slots 21 into 9 radially arranged strip structures 20, and a circular isolation slot 21a disposed between the spherical curved surface 241 and the circular curved surface 242 isolates and divides each strip structure 20. In other words, each strip structure 20 is divided by the isolation slot 21a into two parts, respectively: a strip structure 20a and a strip structure 20b, and the circular isolation slot 21a has a plurality of auxiliary portions 221 to assure a complete structure capable of connecting the strip structure 20a and the strip structure 20b, and a connecting portion 23 is disposed across the isolation slot 21a, and a parallel high potential circuit is used as a positive power contact 13.

With reference to FIG. 4(e), the spherical curved surface 241 and the circular curved surface 242 have a circular electrode slot 22, so that each strip structure 20a may install a plurality of LED chips 11; every three strip structures 20a form a parallel circuit area 12, and there are a total of three parallel circuit areas 12, and these parallel circuit area 12 are connected into a three-parallel-three-series connection, and there are 9 LED chips installed on the spherical curved surface 241 of the illumination circuit.

With reference to FIG. 4(e), radial isolation slot 21b is added to the middle of every three circumferentially arranged strip structures 20b on the circular curved surface 242 and divided into two strip structures 20c; the strip structure 20c has an LED chip 11, and two LED chips 11 are installed on the non-divided strip structure 20b, and one strip structure 20c and one strip structure 20b have a total of 3 LED chips 11 which form a parallel circuit area 12, so that a series connection is defined in the three parallel circuit areas 12, so as to form a three-series-three-parallel circuits with a total of 9 LED chips 11, and the circular curved surface 242 has two groups of three-series-three-parallel circuits with a total of 18 LED chips 11.

It is noteworthy that each fixing hole 27 and the concentric circular strip fixed planar structure 28 of the conductive plate 2 and the support rib 30, the support surface 301, and each fixing column 33 of the support frame 3 form an LED chip electrode soldering point protection mechanism of the illumination apparatus d of this embodiment, and the manufacturing method 9b of the illumination apparatus d of this embodiment also comprises the LED chip electrode soldering point protection mechanism.

With reference to FIGS. 4, 4(d), and 4(e) for the manufacturing method of the illumination apparatus d of this embodiment, the manufacturing method of this embodiment is substantially the same as that of the aforementioned second embodiment. Referring to FIG. 2(i) as well, the manufacturing method of the illumination apparatus d of this embodiment comprises an unloading process, a mounting process, a reclaiming process, a formation preparation process, a pre-assembling bending process, an assembling process, an auxiliary portion removing process and a post-assembling bending process.

In the bending process, a stamping mold is provided to press and fix a concentric circular strip fixed planar structure 28 of the spherical curved surface 241 to a predetermined conical angle, and then bending the two bending portions 24c, 24b of the strip structure 20a to form a spherical curved surface 241, so that the circular curved surface 242 forms a conical surface, and the width of the isolation slot 21 on the external diameter is reduced significantly; and then the positioning portion 25 is cut and removed to form a circular center hole, and the stamping mold is used again to press the concentric circular strip fixed planar structure 28 of the circular curved surface 242 and bend the bending portion 24b and the bending portion 24 of the strip structure 20b and the strip structure 20c respectively to form the circular curved surface 242. Now, the stamping board 80 becomes the structure of the conductive plate 2. In addition, the spherical curved surface 241 and the circular curved surface 242 jointly form a hemispherical shape, and each connecting portion 23 disposed across the isolation slot 21 is bent into a V-shape and has a very small width, and the width of the isolation slot 21 and the isolation slot 21a is reduced to a predetermined width.

With reference to FIG. 4(g) for the assembling process, the support frame 3 and the conductive plate 2 are combined, and each support rib 30 of the support frame 3 is connected to the interior of the conductive plate 2, and the fixing ring 31 of the support frame 3 is sheathed onto the positioning portion 25 of the conductive plate 2 for supporting the conductive plate 2 in the follow-up operation and completing the electrode soldering point protection mechanism of the LED chip.

In the auxiliary portion removing process, the stamping mold is used to press the support frame 3 and the conductive plate 2 and cut open each auxiliary portion 221, so that these auxiliary portions 221 become electrode slots 22, so as to form the illumination circuits 10 with three groups of three-parallel-three-series connections in accordance with this embodiment.

The bulb lamp E in accordance with the fifth embodiment of the present invention is an extension of the fourth embodiment of the present invention, the bulb lamp E adopts the same series-parallel illumination circuit 10 with two groups of conductive plates and lamp covers of the fourth embodiment, and the support frame structure of the fourth embodiment is changed to a support frame 3, 3a of this embodiment.

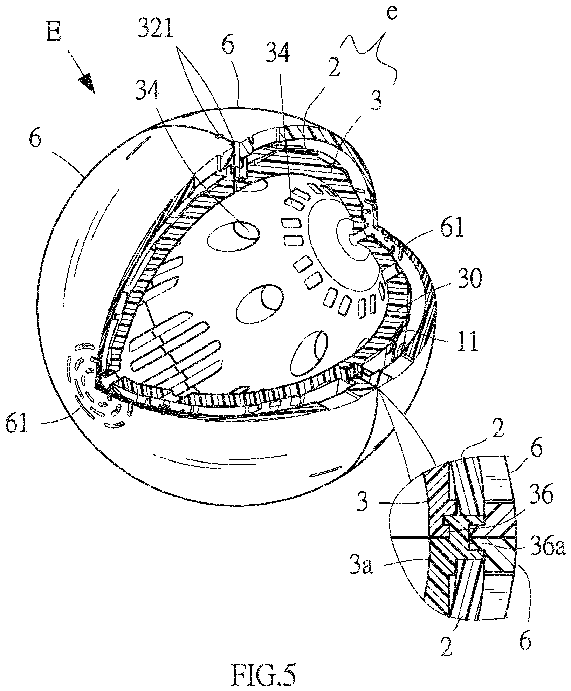

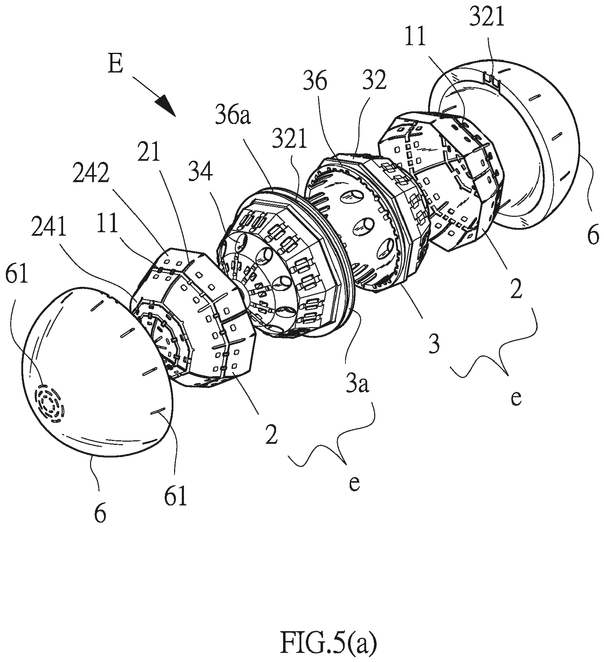

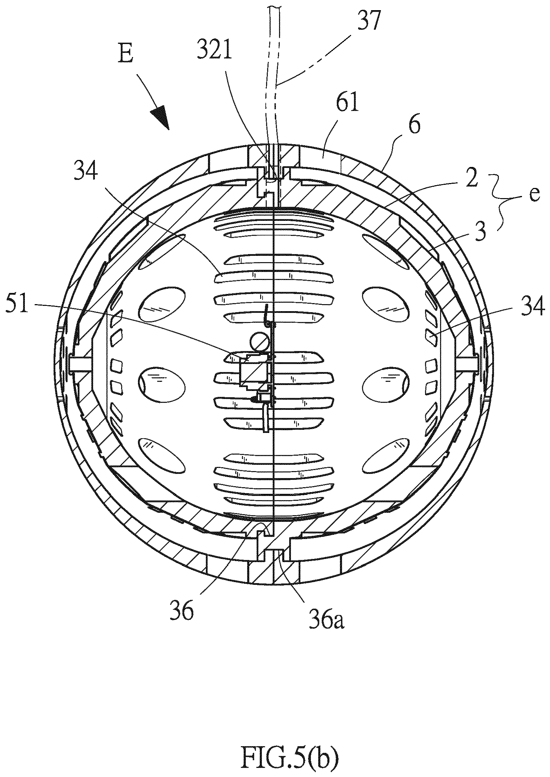

In FIGS. 5-5(b), the bulb lamp E is formed by left and right lamp covers 6, two conductive plates 2, a plurality of LED chips 11, two support frames 3, 3a, and a power module 51, and the two support frames 3, 3a and the lamp cover 6 are embedded and integrated to form the bulb lamp E.

When the bulb lamp E is installed, a sling and a power cord 37 disposed at the uppermost position are passed through a sling hole 321 formed on an external circular surface 32 of the support frame 3, so that the external circular surface 32 is situated at a vertical status, and the two lamp covers 6 are disposed on both sides respectively. In FIG. 5, the two lamp covers 6a are installed onto a combining portion 36a of the two support frames 3, 3a, and the support frame 3 is embedded and integrated by another combining portion 36 to form the external appearance of the bulb lamp E of this embodiment.

Each conductive plate 2 is disposed in each lamp cover 6, and each conductive plate 2 is installed in the support frame 3 to provide support and fixation, and has a shape of a hemispherical curved surface formed by a spherical curved surface 241 and a circular curved surface 242.

With reference to FIG. 5(a), the difference between the two support frames 3, 3a of this embodiment and the support frames of the fourth embodiment resides on the opening end of the external circular surface 32 of this embodiment has a combining portion 36, 36a to combine and embed the two support frames 3, 3a closely with each other, and the opening end of the external circular surface 32 further has at least one sling hole 321 for installing a sling and a power cord 37. It is noteworthy that the illumination apparatus of this embodiment also has the electrode soldering point protection mechanism of the LED chip of the concentric circular strip structure of the aforementioned embodiment.

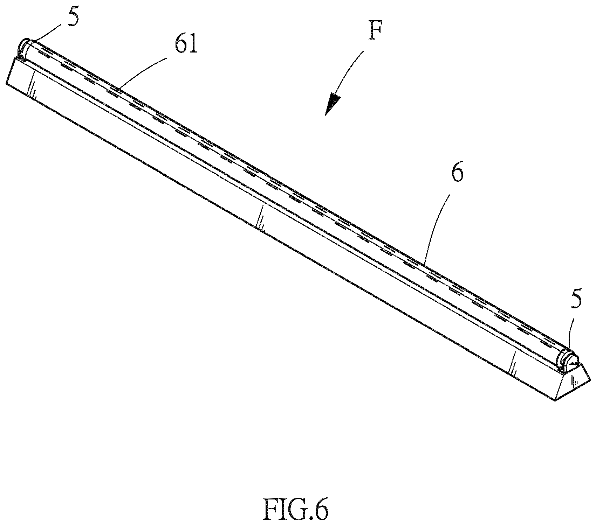

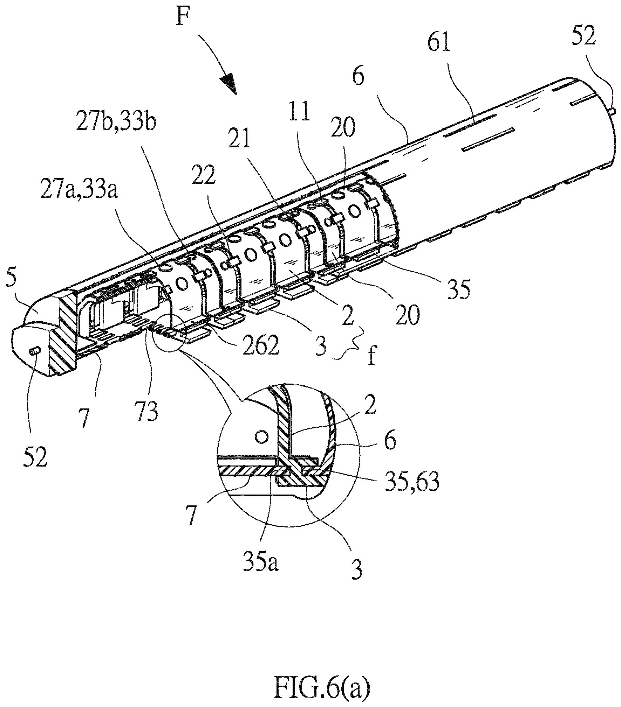

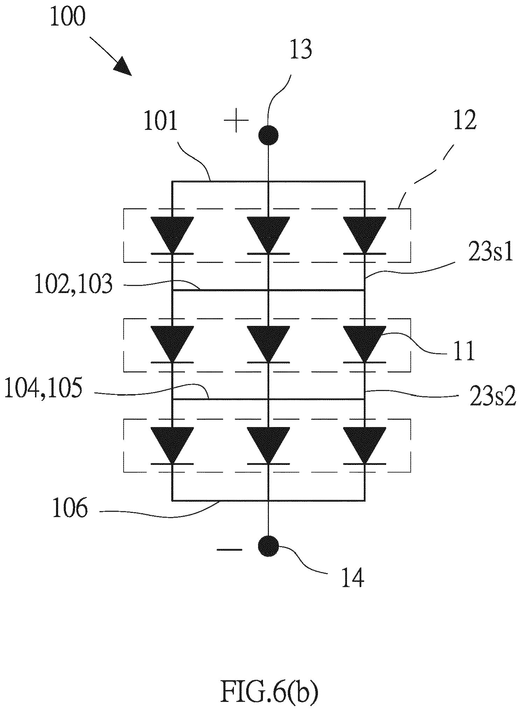

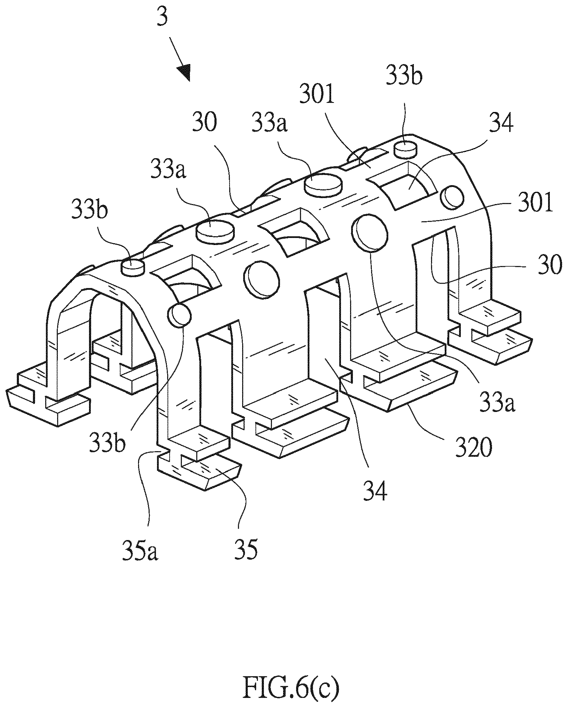

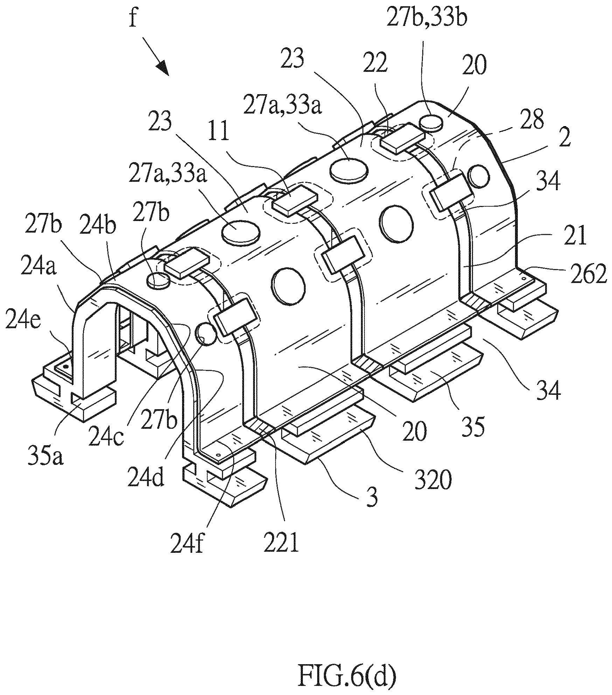

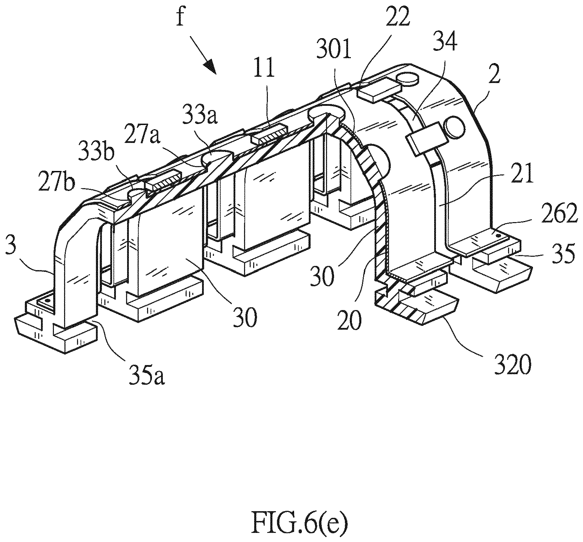

With reference to FIG. 6∼6(b) for an LED illumination apparatus of the sixth embodiment of the present invention, the LED illumination apparatus is a long lamp tube F using the illumination circuit 10 which is a rectangular circuit in compliance wit the requirement of the long lamp tube F, and the illumination apparatus f of this embodiment is comprised of a support frame 3 and a conductive plate 2. Wherein, the long lamp tube F comprises a lamp cover 6, a protective cover 7, two connectors 5, a plurality of conductive plates 2, a plurality of LED chips 11, a plurality of support frames 3, and a power module 51.

The long lamp tube F of this embodiment is installed to a lamp holder at the ceiling, and the protective cover 7 is disposed at the uppermost position, and the lamp cover 6 is disposed at the lowermost position, and the connector 5 is installed on both sides of the lamp tube individually. In addition, the lamp cover 6 and the protective cover 7 are installed to a latch slot 35 and an inner latch slot 35a of the support frame 3 as shown in FIG. 6(a), and the protective cover 7 and the support frame 3 are fixed to the connectors 5 on both sides of the lamp, and the connector 5 has a power pin 52, so as to constitute the external appearance of the long lamp tube F.

With reference to FIG. 6(a), the lamp cover 6 is a strip opening structure with a U-shaped cross-section, and both lateral sides of the lamp cover 6 have a flap 63, the lamp cover 6 is made of a transparent or semi-transparent material, and the lamp cover 6 has a plurality of ventilation holes 61 formed thereon, and the flap 63 is embedded into the latch slot 35. The protective cover 7 is a rectangular plate structure installed to the inner latch slot 35a of the support frame 3 and has a ventilation hole 73 formed thereon.

Further, the power module is installed and fixed into the protective cover 7 and has a power cord connected to the conductive plate 2 and two connectors 5. Each connector 5 is provided for combining the support frame 3, and the power pin 52 is connected to the power module and the power supply of the lamp holder for supplying the required power to each LED chip 11.

The conductive plate 2 is disposed in the lamp cover 6 and supported and fixed by the support frame 3. The conductive plate 2 is divided by the isolation slot 21 into four parallely arranged strip structures 20 and has two flap combining portions 262 with a U-shaped cross-sectional structure; and flap 63 of the lamp cover 6 is embedded into the latch slot 35 of the support frame 3.

With reference to FIG. 6(d), the conductive plate 2 comprises a power contact, a positioning portion (which is a fixing hole 27a, 27b), a plurality of connecting portions 23, a plurality of isolation slots 21, and a plurality of strip structures 20. Each strip structure 20 has four bending portions 24a∼24d, two bending portions 24e, 24f, and three fixing holes 27a, 27b, three electrode slots 22 with an auxiliary portion 221; and each electrode slot 22 is disposed between two bending portions with an unequal interval apart, and a high potential electrode and a low potential electrode are disposed on both edges of the isolation slot 21 respectively, and the three fixing holes 27a or 27b are formed at the edges of the electrode slot 22; the U-shaped cross-section is formed by bending four bending portions 24a∼24d in a relative distance, and the flap combining portion 262 is formed by bending the two bending portions 24e, 24f.

Further, the isolation slot 21 between every two adjacent strip structures 20 has three electrode slots 22 and a total of three parallel circuit areas 12. Both edges of each electrode slot 22 have a fixing hole 27a, 27b each, wherein a fixing hole 27a is formed on a strip structure 20, and another fixing hole 27b is formed on another strip structure 20, and the two fixing holes 27a, 27b form a group; a body of two strip structures 20 arranged at the middle replaces the serial connecting portion 23s1 and the serial connecting portion 23s2 of the illumination circuit 10 to define a series connection between the parallel circuit areas 12 of the LED chip, and the illumination circuit 10 with the three-parallel-three-series connection has a total of 9 LED chips.

With reference to FIG. 6(c), the support frame 3 is a rectangular structure with a U-shaped cross-section and formed by plural groups of support ribs 30 and the support ribs 30 are transversely and parallely arranged and disposed on the support frame 3, and every three support ribs 30 match with of a strip structure 20 of the conductive plate 3, wherein each support rib 30 has a group of fixing columns 33a, 33b and a support surface 301 formed between the fixing columns 33a, 33b, and each support surface 301 is provided for attaching a U-shaped strip fixed planar structure 28 of the conductive plate 2; a plurality of ventilation holes 34 is formed between each support rib 30; each group of fixing columns 33a, 33b are passed through and combined with each group of fixing holes 27a, 27b of the conductive plate 2; two outer side edges 320 of the support frame 3 have a latch slot 35 and an inner latch slot 35a respectively for fixing and combining the lamp cover 6 and the protective cover 7; the ventilation hole 34 of the support frame 3 is provided for cooling airflow which is advantageous for cutting open and removing the auxiliary portion 221. It is noteworthy that each fixing hole 27a, 27b and the U-shaped strip fixed planar structure 28 of the conductive plate 2, and the support rib 30, the support surface 301, and each fixing column 33a, 33b of the support frame 3 jointly form an electrode soldering point protection mechanism of the LED chip of the illumination apparatus f of this embodiment. The manufacturing method 9a of the illumination apparatus f of this embodiment also comprises the LED chip electrode soldering point protection mechanism.

With reference to FIGS. 6(b) and 6(d) for the three-parallel-three-series illumination circuit 100 formed by the conductive plate 2, the conductive plate 2 is divided by three isolation slots 21 to form four parallel longitudinally arranged strip structures 20 from the stamping board 80. The isolation slot 21 between every two parallel strip structures 20 has three electrode slots 22 for installing 3 LED chips 11 onto a parallel circuit area 12, and a total of three parallel circuit areas 12 are formed, and a body of the two middle strip structures 20 replaces the serial connecting portion 23s1 and the serial connecting portion 23s2 of the illumination circuit 100 to define the series connection between the parallel circuit areas 12, so as to form the three-parallel-three-series illumination circuit 100 with a total of 9 LED chips.

With reference to FIGS. 6 and 6(a) for a long lamp tube, the lamp is an illumination apparatus of a fluorescent lamp formed by connecting the aforementioned three-series-three-parallel circuit units of the plurality of illumination apparatuses f in series.

The manufacturing method of the illumination apparatus f of this embodiment is similar to that of the first embodiment as shown in FIG. 1(i), the manufacturing method comprises an unloading process, a mounting process, a reclaiming process, a formation preparation process, a bending process, an assembling process, and an auxiliary portion removing process.

In the bending process as shown in FIGS. 6(c)-6(d), a stamping mold is provided for positioning the longitudinal fixing holes 27a, 27b disposed closest to the edge, pressing the fixed planar structure 28 closely and bending the bending portion 24e, 24f on both edges of the stamping board into an angle, so that the two flap combining portions 262 become right-angled flaps, and then the following processes are repeated: the stamping mold is used to position each fixing hole 27a, 27b of the longitudinal bending portion 24a to be bent, and then the adjacent fixed planar structures 28 are pressed to bent the longitudinal bending portions 24b, 24c, 24d for several times in a linear longitudinal direction, so that the conductive plate 2 forms a U-shaped cross-sectional structure having two flap combining portions 262. In this process, the external periphery of each LED chip 11 is maintained to be a flat area to protect the electrode soldering point of the LED chip 11.

In the assembling process, the support frame 3 and the conductive plate 2 are combined with each other, and the two outer side edges 320 of the support frame 3 are attached to the two flap combining portions 262 of the conductive plate 3 to provide the support of the conductive plate 2 in the follow-up operations and complete the electrode soldering point protection mechanism of the LED chip 11.

In the auxiliary portion removing process, the stamping mold is used to press the support frame 3 and the conductive plate 2 and cut open each auxiliary portion 221, and the position of the original short-circuit auxiliary portion 221 has become the electrode slot 22, so as to form a complete three-series-three-parallel illumination circuit 100 of this embodiment.

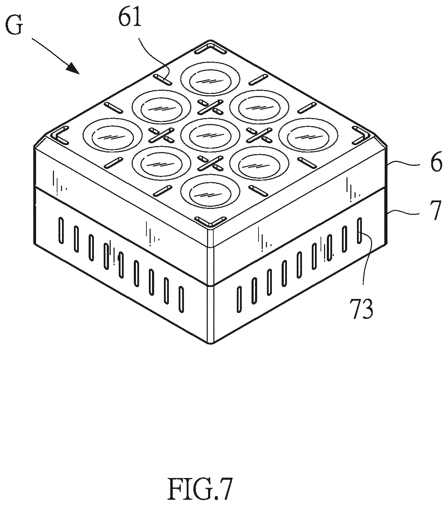

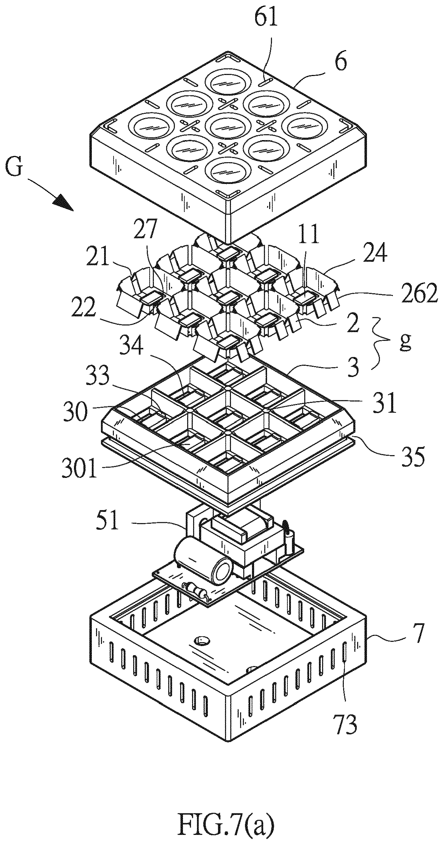

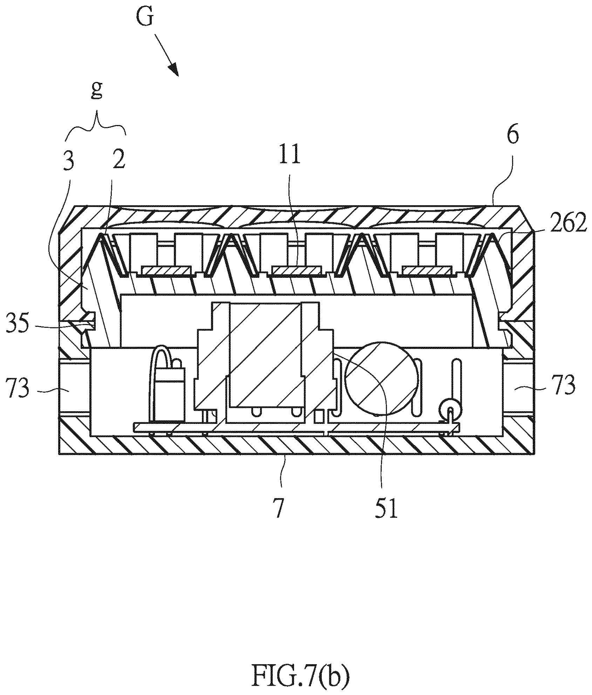

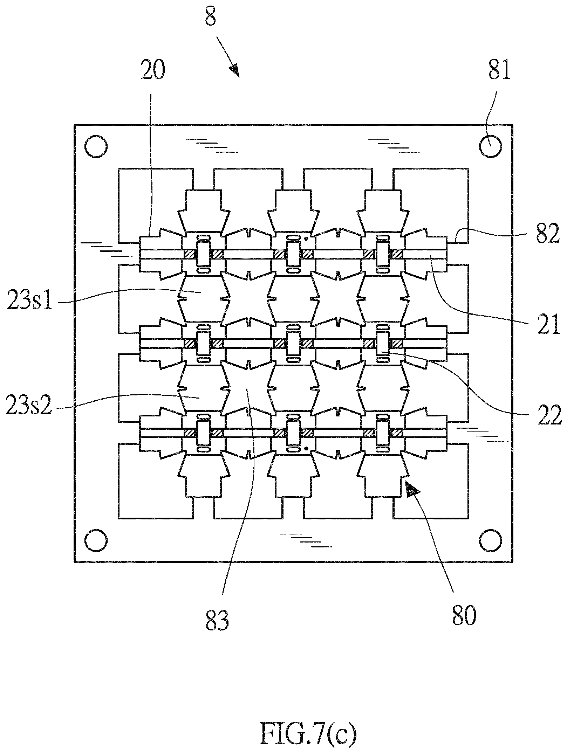

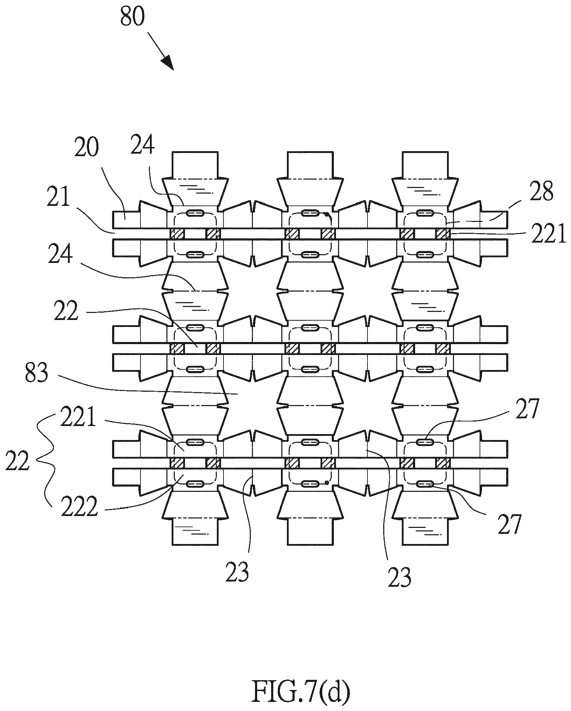

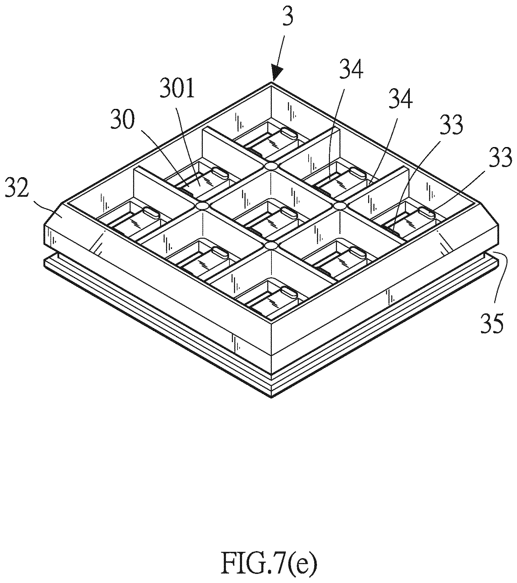

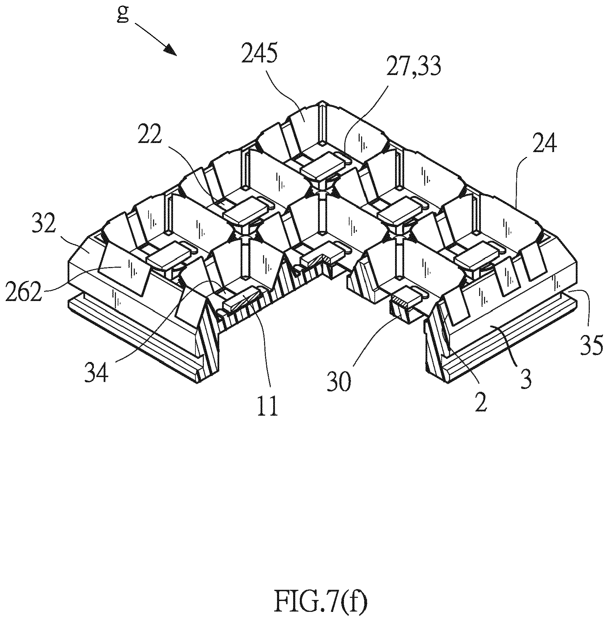

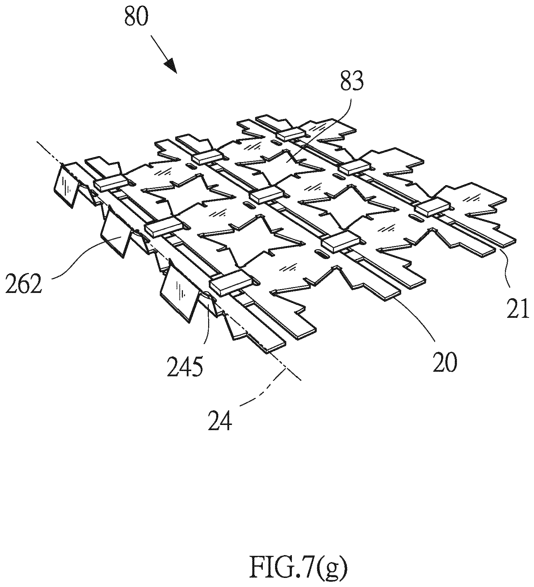

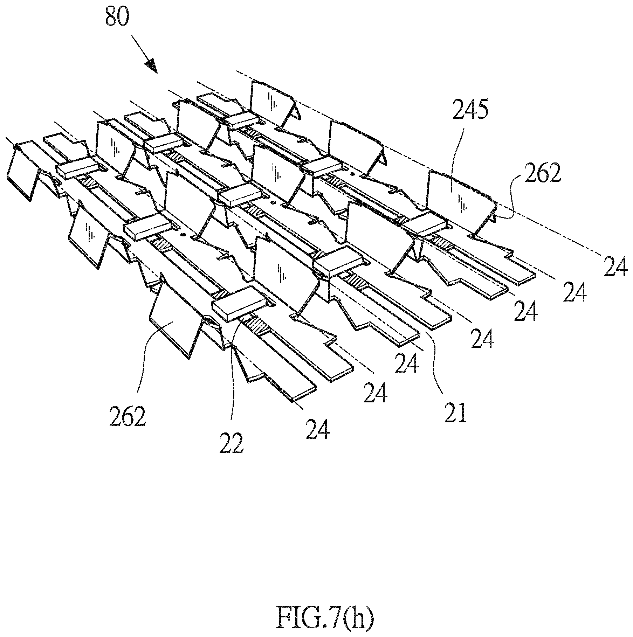

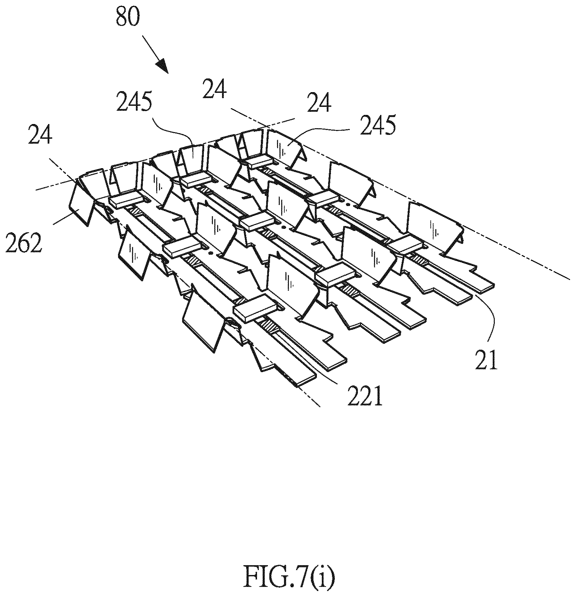

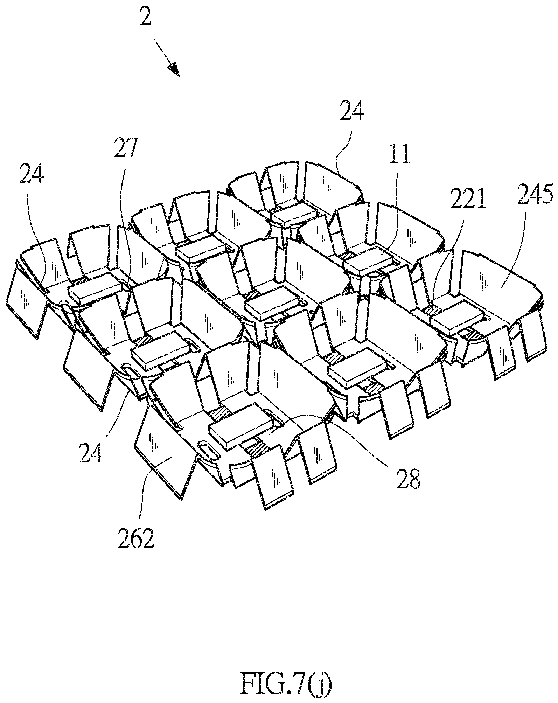

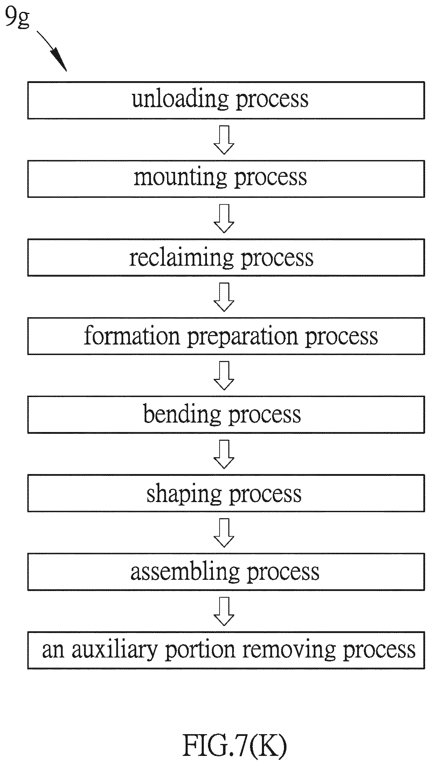

With reference to FIGS. 7∼7(b) for a rectangular flat lamp G in accordance with the seventh embodiment of the present invention, this embodiment is an extension of the aforementioned sixth embodiment and also relates to the three-parallel-three-series illumination circuit 100, and an illumination apparatus g of the rectangular flat lamp G of this embodiment comprises a support frame 3 and a conductive plate 2. In this embodiment, the material board 8 and its stamping board 80 as shown in FIGS. 7(c) and 7(d) come with a structure having two mutually perpendicular mesh structures bent in two mutually perpendicular directions. Wherein, the rectangular flat lamp G comprises a lamp cover 6, a protective cover 7, a conductive plate 2, a plurality of LED chips 11, a support frame 3, and a power module 51. When the rectangular flat lamp G of this embodiment is installed to the ceiling, the protective cover 7 is disposed at the uppermost position and installed to the ceiling, and the lamp cover 6 is disposed at the lowermost position, and its internal power contact is connected to an external power supply. The lamp cover 6 and the protective cover 7 are fixed and combined with the latch slot 35 of the support frame 3 to constitute the external appearance of rectangular flat lamp G of this embodiment.

The lamp cover 6 is a rectangular opening structure made of a transparent or semi-transparent material and has a plurality of ventilation holes 61 formed thereon. In addition, the lamp cover 6 is embedded and combined into the latch slot 35 of the support frame 3 in order to position the flap combining portion 262 of the conductive plate 2. In addition, the opening aslant surface 245 of the rectangular slot of the conductive plate 2 is provided for reflecting the light of each LED chip 11 to the outside.

The power module 51 is installed in the protective cover 7 and fixed to the protective cover 6, and the power module 51 has a power cord for connecting a power contact of the conductive plate to supply the required power to each LED chip 11.

With reference to FIG. 7(j), the conductive plate 2 is supported and fixed by the support frame 3, and the conductive plate 2 is formed by three-by-three nine rectangular slots, and two adjacent rectangular slots and their aslant surfaces 245 are connected to each other, and a rectangular fixed planar structure 28 disposed at the bottom of each rectangular slot has an electrode slot 22 and an LED chip 11, so that each electrode slot 22 and each LED chip 11 are also arranged in a rectangular shape, and the fixed planar structure 28 is enclosed by the groups of four aslant surfaces 245. Further, the external circular surface around the conductive plate 2 has a flap combining portion 262, and its rectangular slots arranged in rows and columns are formed by bending the four bending portions 24 along the row and column directions.

Further, the conductive plate 2 as shown in FIGS. 7(d) and 7(j), the three isolation slots 21 arranged in the row and column directions are cut open to form four strip structures 20, and the three strip structures 20 in row and column divide each plane of the fixed planar structure 28 into two parts. In other words, each plane is disposed on two adjacent strip structures 20, and each isolation slot 21 has a plurality of electrode slots 22, and there are 3 LED chips 11 connected in parallel to form a parallel circuit area 12. In this embodiment, three are three parallel circuit areas 12; and both side edges of each electrode slot 22 have a fixing hole 27; and a body of two middle strip structures 20 replaces the serial connecting portion 23s1 and the serial connecting portion 23s2 of the illumination circuit 100 as shown in FIG. 6(b) to define a series connection between the parallel circuit areas 12.

The support frame 3 as shown in FIG. 7(e) is installed in the conductive plate 2 and in a rectangular shape matched with the strip structure 20 of the conductive plate 2, and the support frame 3 has three-by-three nine rectangular slots, and a strip support rib 30 is disposed at the bottom of each rectangular slot, and both sides of the support rib 30 have a ventilation hole 34 each; and each strip support rib 30 has a support surface 301, and the support surface 301 has a group of fixing columns 33, and the group of fixing columns 33 may be passed through and combined with a group of fixing holes 27 of the conductive plate 2, and the external circular surface 32 around the support frame 3 has the latch slot 35 provided for fixing the lamp cover 6 and the protective cover 7.

It is noteworthy that each fixing hole 27 and the rectangular fixed planar structure 28 of the conductive plate 2 and the support rib 30, the support surface 301, and each fixing column 33 of the support frame 3 jointly form an electrode soldering point protection mechanism of the LED chip of the illumination apparatus g of this embodiment. The manufacturing method 9g of the illumination apparatus f of this embodiment also has the electrode soldering point protection mechanism of the LED chip.

With reference to FIG. 7(K) for the manufacturing method 9g of the illumination apparatus g of this embodiment, the manufacturing method 9g comprises an unloading process, a mounting process, a reclaiming process, a formation preparation process, a bending process, a shaping process, an assembling process, and an auxiliary portion removing process.

In the bending process as shown in FIG. 7(d) and 7(g), when the stamping mold selects a row direction or a column direction, the fixing hole 27 of the fixed planar structure 28 in the selected direction is used for positioning and pressing the fixed planar structure 28 in the row direction or the column direction and bending the bending portions 24 on both sides of the stamping board 80 into a large angle, so that the flap combining portion 262 becomes an obtuse flap, and then the bending portion 24 of the fixed planar structure 28 is bent. In FIG. 7(h), the same bending process is repeated in the same direction until the bending and forming process in the same row direction or the same column direction is completed. In FIG. 7(i), the bending in a different direction takes place, and the fixing hole 27 of the fixed planar structure 28 in such direction is used for positioning, and the same bending process is repeated until the bending process in the same row or column direction is completed as shown in FIG. 7(j). In other words, the aforementioned bending process is repeated until the four sides of each plane of the fixed planar structure 28 and the bending portions 24 on four aslant surfaces 245 of the rectangular slot are bent.

With reference to FIG. 7(j) for the shaping process, the shaping process of the rectangular slot takes place after the bending process ends, wherein a stamping mold is used to combine and fix all fixing holes 27 and press the fixed planar structures 28 arranged in a rectangular shape closely to size the final dimensions of each rectangular slot and shape the aslant surface 245 of the opening, so that the light of each LED chip 11 can be reflected to the outside.

With reference to FIG. 7(f) for the assembling process, the support frame 3 and the conductive plate 2 are combined with each other, and the external circular surface 32 of the support frame is attached to the flap combining portion 262 of the conductive plate to provide support to the conductive plate 2 for the follow-up operation and complete the electrode soldering point protection mechanism of the LED chip 11, so as to facilitate the follow-up process.

In the auxiliary portion removing process, the stamping mold is used to press the support frame 3 and the conductive plate 2 and cut open each auxiliary portion 221, and the position of the original short-circuit auxiliary portion 221 becomes the electrode slot 22, so as to form the illumination circuit of this embodiment.

In summation of the aforementioned embodiments, the present invention relates to an LED illumination apparatus and its manufacturing method, wherein a metal sheet is stamped to form a conductive plate with a 3D space, and the conductive plate has an illumination circuit, and a support frame is installed in the conductive plate, and the support frame is provided for supporting and fixing the conductive plate to facilitate the formation of the conductive plate and the protection of each LED chip soldering point, and the core components of an LED illumination apparatus of the present invention go with a lamp cover, a protective cover, and a power module exclusively designed for the LED illumination apparatus, so that various types of lamps with a better heat dissipating effect can be achieved, and the ventilation holes formed on the lamp cover and the protective cover have a slit width <1mm for indoor protection (IP grade) such as IP40 grade, so that outside air is in direct contact with both sides of the conductive plate of the present invention to achieve the effect of convection and provide an excellent heat dissipating efficiency .

## Claims

1. An LED illumination apparatus comprising:
a conductive plate (2), being stamped to form a structure with 3D space, and having at least one electrode slot (22) and a plurality of isolation slots (21), and each isolation slot (21) dividing the conductive plate (2) into a plurality of strip structures (20), and each strip structure (20) forming a fixed planar structure (28) and a plurality of fixing holes (27) provided for mold pressing, wherein the fixed planar structure (28) is disposed across the electrode slot (22), and each fixing hole (27) is formed adjacent to an edge of the fixed planar structure (28) ;
a plurality of LED chips (11), coupled and installed into the fixed planar structure (28) of the conductive plate (2) and across the electrode slot (22), and provided for dividing each strip structure (20) into a plurality of parallel circuit areas (12) of the LED chip (11), and a plurality of connecting portions (23) or a strip structure (20) being provided for connecting each parallel circuit area (12) in series to form a series-parallel circuit (1) ; and
a support frame (3) with an insulating effect, comprised of a plurality of strip support ribs (30), each support rib (30) comprising a plurality of fixing columns (33) thereon, and disposed in an internal space under the conductive plate (2), so that each fixing column (33) is passed and coupled to a fixing hole (27) of the conductive plate (2), and a ventilation hole (34) is formed between adjacent support ribs (30), and each support rib (30) is configured to be corresponsive to a strip structure (20) of the conductive plate (2) ;
and wherein the support frame (3) comprises a support surface (301), extended between the support rib (30) and each fixing column (33), and provided for attaching the bottom of each plane of the conductive plate (2), and used for mold pressing, and each fixing column (33) being passed and extended to both sides of each LED chip (11) to form an LED chip (11) soldering point protection mechanism for protecting an electrode soldering point of each LED chip (11) during a manufacturing process of the LED chip (11).

2. The LED illumination apparatus according to claim 1, wherein the illumination circuit (1, 10, 100) has a series circuit isolated by each isolation slot (21), and each parallel circuit area (12) is isolated by the electrode slot (22), and a connecting portion (23) in the parallel circuit area (12) is disposed across the isolation slot (21) and provided for connecting a high potential electrode (223) and a low potential (222) of the plurality of LED chips (11) in the area in parallel.

3. The LED illumination apparatus according to claim 1, wherein the conductive plate (2) may dissipate heat with double large areas and the combined support frame (3) also increases an additional heat dissipating area.

4. The LED illumination apparatus according to claim 1, further comprising a plurality of auxiliary portions (221) coupled into the electrode slot (22) to form a single-component conductive plate (2), and a fixed planar structure (28) being formed between the fixing holes (27) of the conductive plate (2), the periphery of the LED chip (11), and its non-opening area, and each group of fixing holes (27) of the conductive plate (2) and each group of fixing columns (33) of each support rib (30) being coupled to one another, and a support surface (301) between each group of fixing columns (27) attaching and abutting the bottom of the fixed planar structure (28), so that the electrode soldering point of each LED chip (11) is protected during the manufacturing process to reduce the deformation of each LED chip electrode soldering point and improve the yield rate, and finally the plurality of auxiliary portions (221) is removed to prevent a short circuit of the electrode and form a complete series-parallel circuit.

5. The LED illumination apparatus according to claim 1, wherein the low potential electrode (222) of the electrode slot (22) covers a heat transfer contact of each LED chip (11) for accelerating the heat dissipation of each LED chip (11), when the electrode contact of each LED chip (11) is soldered.

6. The LED illumination apparatus according to claim 1, wherein each fixing column (33) is passed and extended into each fixing hole (27) for connecting each fixing column (33), so that each fixing column (33) is fixed into the fixing hole (27) by deformation or an adhesive.

7. The LED illumination apparatus according to claim 1, wherein when each strip structure (20) is radially arranged, each connecting portion (23) is disposed across the isolation slot (21) to maintain an integral sheet structure of the conductive plate (2) after the conductive plate (2) is stamped and formed.

8. The LED illumination apparatus according to claim 7, further comprising a plurality of radial isolation slots (21) for dividing the outermost portion of each strip structure (20) into smaller strip structures (20), and a plurality of electrode slots (22) for satisfying a circuit requirement.

9. The LED illumination apparatus according to claim 1, wherein when each strip structure (20) is arranged parallely, each electrode slot (22) is disposed in the isolation slot (21), and when each electrode slot (22) is arranged on both edges of the strip structure (20), the electrode slot (22) is situated on the isolation slot (21) to substitute the connecting portion (23) by two middle strip structures (20), and plural groups of shorter conductive plates (2) are connected in series to form a longer strip conductive plate (2).

10. The LED illumination apparatus according to claim 1, wherein when each strip structure (20) is arranged parallely, and the fixed planar structure (28) is divided by each isolation slot (21), two adjacent strip structures (20) form a plane and an electrode slot (22) for mold pressing, and the plurality of electrode slots (22) is arranged in the isolation slot (21) ; and each strip structure (20) has a plurality of electrode slots (22), and the fixing holes (27) of two adjacent strip structures (20) are formed on both sides of the plane; a body of the middle strip structure (20) may substitute each connecting portion (23) to define a series connection between the parallel circuit areas (12) of the LED chip (11).

11. The LED illumination apparatus according to claim 7, being used as a flat bulb lamp, **characterized in that** the conductive plate (2) comprises a power contact (13, 14), an electrode slot (22), a positioning portion (25), a plurality of connecting portions (23), a plurality of isolation slots (21), and a plurality of strip structures (20), wherein the plurality of isolation slots (21) may divide the conductive plate (2) into radially distributed strip structures (20) ; the conductive plate (2) further comprising a plurality of heat conduction surfaces (26) which are substantially circular shallow cup-shaped structures, and the heat conduction surface (26) may be attached to an external circular surface (32) of the support frame (3) ; each strip structure (20) further comprises: a group of fixing holes (27), an electrode slot (22), a bending portion (24), and a plane of the fixed planar structure (28), wherein the group of fixing holes (27) is disposed on both sides of the electrode slot (22) ; the bending portion (24) is disposed on an outer periphery and attached to an external circular surface (32) of the support frame (3) after the bending portion (24) is bent and formed; and the support frame (3) being substantially a circular disc structure matched with the conductive plate (2) and composed of a plurality of radially arranged strip support ribs (30), and each support rib (30) having a group of fixing columns (33) and the support surface (301) disposed between the group of fixing columns (33), and each support surface (301) matching with each group of fixing columns (33) and being combined with a fixing hole (27) of the conductive plate (2) to support and fix a fixed planar structure (28) of the conductive plate (2) ; a fixing ring (31) installed to the center of the support frame (3) and passing through a positioning portion (25) of the conductive plate (2) ; and a latch slot (35) being formed on an external circular surface (32) of the support frame (3) disposed around the periphery of an opening end.

12. The LED illumination apparatus according to claim 7, being used as a convexly curved surface bulb, **characterized in that** the conductive plate (2) comprises a power contact (13, 14), an electrode slot (22), a positioning portion (25), a plurality of connecting portions (23), a plurality of isolation slots (21), and a plurality of strip structures (20) ; wherein the plurality of isolation slots (21) divides the conductive plate (2) into a plurality of radially distributed strip structures (20) ; the conductive plate (2) is in a shape of a hemispherical curved surface with an end composed of a spherical curved surface (241) and a circular curved surface (242) and the other end composed of a conical curved surface (243) and a cylindrical surface (244) to form a conical shape; a connecting portion (23), disposed across the isolation slot (21), being bent into a V-shape; each strip structure (20) comprises: a plurality of bending portions (24), a group of fixing holes (27), an electrode slot (22), and a plane of the fixed planar structure (28) ; wherein the plurality of bending portions (24) arranged in a direction from a cylindrical surface (244) towards a spherical curved surface (241) include a bending portion (24) disposed between the cylindrical surface (244) and the conical curved surface (243), a bending portion (24) disposed between the circular curved surface (242) and the conical curved surface (243), and a bending portion (24) disposed on the spherical curved surface (241) ; one of the fixing holes (27) is disposed on the spherical curved surface (241), and another fixing hole (27) is disposed on the circular curved surface (242) ; the fixed planar structure (28) and the electrode slot (22) are disposed between the spherical curved surface (241) and the circular curved surface (242) and arranged at the middle of the group of fixing holes (27) ; and the support frame (3) is a hemispherical structure, and each support rib (30) has a group of fixing columns (33), and the support surface (301) is disposed between each group of fixing columns (33), and each support surface (301) matching each group of fixing columns (33) is combined with a fixing hole (27) of the conductive plate (2) to support and fix a fixed planar structure (28) of the conductive plate (2) ; a fixing ring (31), installed to the center of the support frame (3), and passing through a positioning portion (25) of the conductive plate (2) ; and a latch slot (35) formed on an external circular surface (32) disposed at the external circumference of the support frame (3), and the external circular surface (32) being attached closely to the circular curved surface (242) of the conductive plate (2).

13. The LED illumination apparatus according to claim 7, being used as a concavely curved surface bulb, **characterized in that** the conductive plate (2) comprises a power contact (13, 14), an electrode slot (22), a positioning portion (25), a plurality of connecting portions (23), a plurality of isolation slots (21), and a plurality of strip structures (20) ; the plurality of isolation slots (21) divides the conductive plate (2) into a plurality of radially distributed strip structures (20) ; an end of the conductive plate (2) has a concave hemispherical curved surface formed by a concave spherical surface (241a) and a concave circular curved surface (242a), and the other end of the conductive plate (2) in a conical shape formed by a conical curved surface (243) and a cylindrical surface (244) is bent into a V-shaped by the connecting portion (23) connected and spanned across the isolation slot (21) ; each strip structure (20) comprises a plurality of bending portions (24), a group of fixing holes (27), an electrode slot (22), and a plane of the fixed planar structure (28) ; the plurality of bending portions (24) arranging in the direction from the cylindrical surface (244) towards the concave spherical surface (241a) comprising a bending portion (24) disposed between the cylindrical surface (244) and the conical curved surface (243), a bending portion (24) disposed between the concave circular curved surface (242a) and the conical curved surface (243), and a bending portion (24) disposed on the concave spherical surface (241a) ; wherein one of the fixing holes (27) is disposed on the concave spherical surface (241a) and the other fixing hole (27) is disposed on the concave circular curved surface (242a), and the two fixing holes (27) form a group; the fixed planar structure (28) and the electrode slot (22) are disposed between the concave spherical surface (241a) and the concave circular curved surface (242a) and disposed at the middle of the group of fixing holes (27) ; and the support frame (3) is designed in a concave hemispherical structure and formed by a plurality of radially arranged support ribs (30), and each support rib (30) has a group of fixing columns (33), and the support surface (301) is formed between the group of fixing columns (33), and each support surface (301) matched with each group of fixing columns (33) is passed through and combined with each group of fixing holes (27), so as to support and fix the fixed planar structure (28) of the conductive plate (2) ; and the center of the support frame (3) has a fixing ring (31) passing through a center hole of the positioning portion (25) of the conductive plate (2) ; an external circular surface (32) of the support frame (3) disposed on an opening end has a latch slot (35), and the external circular surface (32) is attached closely to a circular curved surface (242) of the conductive plate (2), and an external circular surface (32) disposed at the external circumference of the support frame (3) is attached closely to the U-shaped bending portion of the conductive plate (2).

14. The LED illumination apparatus according to claim 8, being used as a hemispherical lamp, **characterized in that** the conductive plate (2) comprises a power contact (13, 14), a plurality of electrode slots (22), a positioning portion (25), a plurality of connecting portions (23), a plurality of isolation slots (21), and a plurality of strip structures (20), wherein the conductive plate (2) is cut by the plurality of isolation slots (21) to form a plurality of radially arranged strip structures (20) ; the conductive plate (2) has an end being a hemispherical curved surface formed by the spherical curved surface (241) and the circular curved surface (242), and the spherical curved surface (241) has an electrode slot (22), and another electrode slot (22) formed between the circular curved surface (242) and the spherical curved surface (241) ; each strip structure (20) has two radial sub-strip structures (20) divided by the plurality of isolation slots (21) and formed on the circular curved surface (242) according to a circuit requirement; each strip structure (20) has a size capable of installing the plurality of LED chips (11) ; the spherical curved surface (241) and the circular curved surface (242) have different quantities of parallel circuit areas (12) connected in series, and the plurality of connecting portions (23) are disposed across the isolation slot (21) and bent into a V-shape to reduce the circumference and size of the conductive plate (2), so as to form a space structure of the conductive plate structure; each strip structure (20) arranging with an interval apart in a direction from external diameter towards internal diameter comprises a bending portion (24), a fixing hole (27), an electrode slot (22), a fixing hole (27), a bending portion (24), and a plane of the fixed planar structure (28) ; two fixing holes (27) form a group, and the group of the fixing holes (27), the plane, and the electrode slot (22) are disposed between the aforementioned two bending portions (24) ; the support frame (3) is designed as a hemispherical structure with a main body formed by a plurality of support ribs (30), and having different quantities of radially arranged support ribs (30) disposed on the spherical curved surface (241) and the circular curved surface (242) respectively; each support rib (30) matches the strip structure (20) of the conductive plate (2) ; each support rib (30) has a group of fixing columns (33), a support surface (301) disposed between the group of fixing columns (33), and each support surface (301) matching with each group of fixing columns (33) may be passed through and combined with each group of fixing holes (27), so as to support and fix the fixed planar structure (28) of the conductive plate (2) ; a ventilation hole (34) is formed between the support ribs (30) ; an external circular surface (32) of the support frame (3) has a latch slot (35), and the external circular surface (32) is attached to the circular curved surface (242) of the conductive plate (2).

15. The LED illumination apparatus according to claim 14, being used as a bulb lamp, wherein the bulb lamp is formed by two identical conductive plates (2) and two support frames (3), and each conductive plate (2) is supported and fixed by a support frame (3) ; each support frame (3) has a latch slot (35) and a combining portion (36) formed at the opening end of the external circular surface (32), so that two support frames (3) can be embedded into one another closely, and the opening end of the external circular surface (32) of each support frame (3) has a sling hole (321) provided for installing the sling and a power cord (37).

16. The LED illumination apparatus according to claim 9, being used as a long lamp tube, **characterized in that** the structure of the conductive plate (2) comprises a power contact (13, 14), a plurality of electrode slots (22), a plurality of connecting portions (23), a plurality of isolation slots (21), and a plurality of strip structures (20), wherein the conductive plate (2) is cut by a plurality of isolation slots (21) to form a plurality of parallel strip structures (20) ; the conductive plate (2) further includes a U-shaped cross-sectional structure with two flap combining portions (262), and the U-shaped cross-section is formed by bending the plurality of bending portions (24) to a relative distance, and each flap combining portion (262) is formed by bending two bending portions (24) at the edges; when the flap of the lamp cover (6) is embedded into a latch slot (35) of the support frame (3), the combining portion (36) is engaged and fixed; each strip structure (20) has a plurality of bending portions (24), a plurality of fixing holes (27), a plurality of electrode slots (22), and a plurality of planes of the fixed planar structure (28); wherein each plane and the electrode slot (22) are disposed between two bending portions (24) having different intervals and divided into two parts by one of the isolation slots (21), so that two adjacent strip structures (20) are assembled into each plane and the electrode slot (22), and each electrode slot (22) is mounted onto the isolation slot (21); a fixing hole (21) is formed at an edge of the plurality of electrode slots (22) of each strip structure (20) ; the two fixing holes (27) of the two adjacent strip structures (20) are disposed on both sides of each plane and combined to form a group; a body of the middle strip structure (20) replaces the connecting portion (23) to define a series connection between the LED chip parallel circuit areas (12) ; and the support frame (3) is a rectangular structure with a U-shaped cross-section, and the plurality of transverse parallel support ribs (30) are assembled into a strip structure (20) ; each support rib (30) has a group of fixing columns (33), and a support surface (301) disposed between the group of fixing columns (33), and each support surface (301) matched with each group of fixing columns (33) may be passed through and combined with each group of fixing holes (27) to support and fix the fixed planar structure (28) of the conductive plate (2) ; more than one ventilation holes (34) are formed between the support ribs (30) ; the support frame (3) has two outer side edges (320) ; each group of fixing columns (33) are passed through and combined with each group of fixing holes (27) respectively; and the outer side edge (320) of the support frame (3) has a latch slot (35) and an inner latch slot (35a).

17. The LED illumination apparatus according to claim 10, being used as a rectangular flat lamp, wherein the conductive plate (2) comprises a power contact (13, 14), a plurality of electrode slots (22), a plurality of connecting portions (23), a plurality of isolation slots (21), and a plurality of strip structures (20); the plurality of isolation slots (21) arranged in a row direction or a column direction are cut open to form a plurality of parallel strip structures (20) ; the conductive plate (2) is formed by a plurality of rectangular slots arranged in plural rows by plural columns, and the adjacent rectangular slots are connected with each other by their aslant edges, and the plane of the bottom has an electrode slot (22) and each LED chip (11) installed thereon, and its external periphery has a combining portion (36) of the flap (63) ; and the row or column slot has a cross-section formed by bending the plurality of bending portions (24) and the bending portions (24) on two edges of the aslant surface (245) along the row or column direction; each strip structure (20) has a plurality of bending portions (24), a plurality of fixing holes (27), a plurality of electrode slots (22), and a plurality of planes of the fixed planar structure (28); each plane and the electrode slot (22) ad disposed between two row and column bending portions (24) with a different interval apart and divided into two parts by the isolation slot (21), and two adjacent strip structures (20) are assembled to form the plane and the electrode slot (22), and each electrode slot (22) is mounted onto the isolation slot (21) ; each strip structure (20) has a plurality of electrode slots (22), and the edge of each connecting portion (23) has a fixing hole (27); the fixing holes (27) of the two adjacent strip structures (20) are disposed on both sides of the plane and combined into a group; a body of the middle strip structure (20) replaces the connecting portion (23) to define a series connection between the LED chip parallel circuit areas (12) ; the support frame (3) is in a rectangular shape having a plurality of rectangular slots arranged in rows and columns, and each rectangular slot has a strip support rib (30) installed therein and matched with the plane of the rectangular slot of the conductive plate (2), and each strip support rib (30) has a plurality of support surfaces (301) and two fixing columns (33), and the two fixing columns (33) may be passed through and combined with the fixing hole (27) of the conductive plate (2) to for support and fix the fixed planar structure (28) ; both sides of each support rib (30) have two ventilation holes (34) respectively; an external circular surface (32) of the support frame (3) has a latch slot (35), and the external circular surface (32) of the support frame (3) is attached to the combining portion (36) of the conductive plate (2).

18. A manufacturing method (9) of an LED illumination apparatus according to claim 1, comprising an unloading process, a mounting process, a reclaiming process, a formation preparation process, a bending process, an assembling process, and an auxiliary portion removing process; and the aforementioned processes further including the measure of an LED chip protection mechanism, so that an electrode soldering point of each LED chip (11) is protected during the manufacturing process, and deformation is reduced in the processes, wherein the unloading process stamps a metal sheet to form a material board (8), such that the material board (8) comprises a plurality of strip structures (20) separated by a plurality of isolation slots (21), and a plurality of auxiliary portions (221) capable of causing a short circuit and disposed across a connecting portion (23) of the isolation slot (21) is provided for connecting the strip structure (20), and the material board (8) is formed to be a plate structure; the mounting process mounts the LED chip (11) onto the plurality of electrode slots (22) of the material board (8) by soldering; the reclaiming process cuts the plurality of connecting plates (82) from the material board (8) and removes a flat stamping board (80) ; the formation preparation process uses a stamping mold to press and position a positioning portion (25) of the stamping board (80) and pre-press the stamping board (80) at a predetermined position to produce a bending deformation according to the required 3D space of the conductive plate (2), and the bending deformation includes the deformation of the bending portion (24) and, if applicable, the deformation of the connecting portion (23) ; the bending process uses the stamping mold to press the fixed planar structure (28) of the pre-deformed stamping board (80) and bend the bending portion (24) and forms a 3D space structure of the conductive plate (2) by the stamping board (80) ; the assembling process assembles the support frame (3) and combines and fixes the support frame (3) into the interior of the conductive plate (2), and pass each fixing column (33) of the support frame (3) through each fixing hole (27) of the conductive plate (2), such that each support surface (301) attaches and supports the fixed planar structure (28) of the conductive plate (2) to provide the necessary structural support to the conductive plate (2) in the follow-up process, and a ventilation hole (34) formed between the support ribs (30) of the support frame (3) has an area capable of covering each cut auxiliary portion (221) of the conductive plate (2) ; and the auxiliary portion removing process uses the stamping mold to press the fixed planar structure (28) of the conductive plate (2) and the support rib (30) of the support frame (3) and further to cut open each auxiliary portion (221) of the conductive plate (2) to prevent the electrode from being short circuited, so as to complete a series-parallel circuit.

19. The manufacturing method (9) of an LED illumination apparatus according to claim 18, wherein the LED chip protection mechanism is installed and connected into the electrode slot (22) by the plurality of auxiliary portions (221) to form a single-component conductive plate (2), and forms the fixed planar structure (28) between the fixing holes (27) of the conductive plate (2), the periphery of the LED chip (11) and its non-opening area, and each group of fixing holes (27) of the conductive plate (2) and each group of fixing columns (33) of each support rib (30) are combined with each other, and a support surface between each group of fixing columns (33) attaches, presses and supports the fixed planar structure (28) of the conductive plate (2), so that an electrode soldering point of each LED chip (11) can be protected during the manufacturing process.

20. The manufacturing method (9) of an LED illumination apparatus according to claim 19, being applied for a flat bulb lamp, wherein the bending process bends the bending portion at the external diameter to form a shallow cup-shaped conductive plate with a circular surface and cut the positioning portion (25) to form a center hole; the assembling process passes each fixing column (33) of the support frame (3) through the fixing hole (27) of the conductive plate (2), and the support surface (301) of each support rib (30) matches with each fixing column (33) passing through each fixing hole (27) for attaching and supporting the fixed planar structure (28) of the conductive plate (2), and an external circular surface (32) of the support frame (3) is attached to the bending portion (24) of the conductive plate (2), and a fixing ring (31) of the support frame (3) is passed through the center hole of the positioning portion (25).

21. The manufacturing method (9) of an LED illumination apparatus according to claim 19, being applied for a convexly curved surface bulb, wherein the bending process further comprises a pre-assembling bending process and a post-assembling bending process; the formation preparation process further uses the stamping mold to position the center hole of the positioning portion (25) and presses the fixed planar structure (28) closely and bends each connecting portion (23) of the isolation slot (21) disposed across the conductive plate (2) into a V-shape, so as to bend each strip structure (20) towards the backside, and reduces each strip structure (20) near the bending portion (24) along the circumferential direction, so that the width of each isolation slot (21) is reduced further, and now the stamping board (80) becomes a conical structure and each LED chip (11) is situated on the outer side, and the external periphery of each LED chip (11) is still maintained to be flat; the pre-assembling bending process further comprises a spherical curved surface bending process and a circular curved surface bending process, wherein the spherical curved surface bending process uses the stamping mold to press the positioning portion (25) and the fixed planar structure (28) into a predetermined conical angle, and then performs a spherical curved surface formation operation, and the width of the isolation slot (21) at the external diameter is reduced further; the circular curved surface bending process cuts the positioning portion (25) to form a circular center hole, and uses the stamping mold to press each fixed planar structure (28) to perform a circular curved surface formation operation, and the stamping board so form is a conductive plate with a 3D space, and the spherical curved surface (241) and the circular curved surface (242) jointly form a hemispherical shape, and each connecting portion (23) disposed across the isolation slot (21) is further bent into a V-shape, and the width of the isolation slot (21) of the conical curved surface (243) and the cylindrical surface (244) is also reduced; the assembling process further combines the support frame (3) and the conductive plate (2), and the external circular surface (32) is attached to the internal curved surface of the bending portion (24), and the support surface (301) of each support rib (30) is matched with each fixing column (33) passing through each fixing hole (27) to attach and support the fixed planar structure (28) of the conductive plate (2), and the fixing ring (31) is passed through the center hole of the positioning portion (25); the pre-assembling bending process is a conical curved surface and cylindrical surface bending process that uses the stamping mold to fix the support frame (3) after cutting each auxiliary portion (221) open and form the conical curved surface (243) and the cylindrical surface (244) of the conductive plate (2), and since the bending portion (24) at the intersection of the conical curved surface (243) has a plurality of bending holes to weaken the structural strength for an easy bending effect, so that the external circular surface (32) of the support frame (3) can be attached to the bending portion (24), so as to form the conical curved surface (243) and the cylindrical surface (244).

22. The manufacturing method (9) of an LED illumination apparatus according to claim 19, being applied for a concavely curved surface bulb, wherein the bending process further comprises a pre-assembling bending process and a post-assembling bending process; wherein the formation preparation process further uses the stamping mold to position the center hole of the positioning portion (25) and press the fixed planar structure (28) closely and bend each connecting portion (23) of the isolation hole disposed across the conductive plate (2) into a V-shape, and bend each strip structure (20) towards the rear side, and bend each strip structure (20) near the bending portion (24) in the circumferential direction, so as to further reduce the width of each isolation slot (21), and further bend each connecting portion (23) into a deep V-shape, and now, the stamping board (80) becomes a conical structure, and each LED chip (11) is disposed on the outer side, and now, the external periphery of each LED chip (11) is maintained to be flat; the pre-assembling bending process further comprises a concave spherical surface bending process and a concave circular curved surface bending process, wherein the concave spherical surface bending process further uses the stamping mold to press the positioning portion (25) and the fixed planar structure (28) into a predetermined conical angle and then deform the concave spherical surface (241a), and the concave spherical surface (241a) of the structure is still maintained to be a conical surface, and the bending portion (24) of each strip structure (20) is bent at the external diameter of the fixing hole (27), and the bending angle of the bending portion (24) is greater than 90 degrees, so that the conical curved surface (243) and the cylindrical surface (244) are in form of a radial plane, and each LED chip (11) is still disposed on the inner side, and the width of the isolation slot on the internal diameter of the concave circular curved surface (242a) is reduced, and the width of the isolation slot (21) on the external diameter becomes larger due to the planar shape; the concave circular curved surface bending process cuts and removes the positioning portion (25) to form a circular center hole, and the stamping mold is used again to press the fixed planar structure (28) and form the concave circular curved surface (242a), and the bending portion (24) at the external diameter of the fixing hole (27) of each strip structure (20) is bent, so that the bending portion (24) between the concave circular curved surface (242a) and the conical curved surface (243) becomes an inverted U-shaped bending, and the U-shaped bending portion (24b) has a bending angle substantially equal to 180 degrees, and the stamping board (80) so formed becomes the conductive plate (2) with a 3D space, and the concave spherical surface (241a) and the concave circular curved surface (242a) form a concave hemispherical curved surface, and the conical curved surface (243) and the cylindrical surface (244) form an outwardly flapped cylinder, and the V-shaped connecting portion disposed across the isolation slot (21) is further bent, and the width of the conical curved surface (243) and the cylindrical surface (244) is also reduced; the assembling process combines the support frame (3) and the conductive plate (2) and attaches an external circular surface (32) of the support frame (3) to an internal curved surface of the U-shaped bending portion (24b), and the support surface (301) of each support rib (30) is matched to each fixing column (33) passing through each fixing hole (27) to attach and support the fixed planar structure (28) of the conductive plate (2), and pass the latch slot (35) of the support frame (3) through the isolation slot (21), and the fixing ring (31) is passed through the center hole; the post-assembling bending process is a conical curved surface and cylindrical surface bending process, and uses the stamping mold to fix the support frame (3) after each auxiliary portion process ends stamping mold and also form the conical curved surface (243) and the cylindrical surface (244) of the conductive plate (2), and since the bending portions (24) at two intersections of the conical curved surface (243) have a plurality of bending holes to weaken the structural strength and make the bending process easy, and the external circular surface (32) of the support frame (3) is attached to the U-shaped bending portion (24b) of the conductive plate (2), so as to form the conical curved surface (243) and the cylindrical surface (244).

23. The manufacturing method (9) of an LED illumination apparatus according to claim 18, being applied for a hemispherical lamp, wherein the formation preparation process further uses the stamping mold to position the center hole of the positioning portion (25) and presses the fixed planar structure (28) closely and bends the connecting portion (23) of the isolation slot (21) disposed across the stamping board (80) into a V-shape to weaken the strength of the connecting portion (23) along the circumferential direction; the formation preparation process further uses the stamping mold to position the center hole of the positioning portion (25), and reduces the strip structure (20) near the bending portion (24) of a circular curved surface (242) along the circumferential direction, so that the width of each isolation slot (21) is further reduced, and each V-shaped connecting portion (25) is further bent into a deep V-shape, so that the stamping board (80) of the planar structure becomes a conical structure, wherein each strip structure (20) in the circumferential direction has not been bent into a curved surface; the external periphery of each LED chip (11) is maintained to be planar in this process; the bending process further uses the stamping mold to press the fixed planar structure (28) of the spherical curved surface (241) into a predetermined conical angle, and then bend two bending portions (24) of the strip structure (20) of the spherical curved surface (241), so that the circular curved surface (242) becomes a conical surface; and then the positioning portion (25) is cut and removed to form a circular center hole, and the stamping mold is used again to press the fixed planar structure (28) of the circular curved surface (242) and then bend the two bending portions (24) of the strip structure (20), and the circular curved surface (242) and the spherical curved surface (241) jointly form the conduct plate (2) with a hemispherical space structure, and the connecting portion (25) disposed across each isolation slot (21) is bent into a V-shape; when the assembling process combines the support frame (3) and the conductive plate (2), the external circular surface (32) of the support frame (3) is attached to the circular curved surface (242) of the conductive plate (2), and the support surface (301) of each support rib (30) is matched with and combined with each fixing column (33) passing through each fixing hole (27) to attach and support the fixed planar structure (28) of the conductive plate (2).

24. The manufacturing method (9) of an LED illumination apparatus according to claim 18, being applied for a long lamp tube, wherein the bending process uses a row of fixing holes (27) on an outer side of a stamping board (80) as the positioning portion (25) and further uses the stamping mold to press the fixed planar structure (28) of the column and bend the bending portions (24) on both sides of the stamping board (80) into an angle, so that the combining portion (36) becomes an angle flap with an angle substantially equal to a right angle, and then the aforementioned process is repeated, and the stamping mold with a bending angle is used to fix the fixing holes (21) at another column, and press the fixed planar structure (28), and bend the bending portion (24) for several times, so that the stamping board (80) forms a conductive plate structure with a U-shaped cross-section and having two flap combining portions (262); the assembling process combines the support frame (3) and the conductive plate (2), and attaches the outer side edge (320) to the combining portion (36), and the support surface (301) of each support rib (30) is matched and combined with each fixing column (33) passing through each fixing hole (27) to attach and support the fixed planar structure (28) of the conductive plate (2).

25. The manufacturing method (9) of an LED illumination apparatus according to claim 18, being applied for a rectangular flat lamp, further comprising a shaping process, wherein the bending process further uses the stamping mold to select a row direction or a column direction, and uses the fixing hole (27) of the fixed planar structure (28) in such direction as the positioning portion (25), and press the fixed planar structure (28) in the row direction or the column direction and bend the bending portions (24) on both sides of the stamping board (80) with a large angle, so that the combining portion (36) has an angled flap with an angle substantially equal to 150 degrees, and then the bending portion (24) of the fixed planar structure (28) is bent, and the same bending process is repeated in one direction and then in another direction until all bending portions (24) at the fixed planar structure (28) and the periphery of the rectangular slot are bent; so that the stamping board (80) is formed into a conductive plate (2) having a plurality of rectangular slot structures arranged in rows and columns; the shaping process shapes the rectangular slot and further uses the stamping mold to combine and position each fixing hole (27) and presses a plane of the fixed planar structure (28) closely and shapes the final dimensions of the rectangular slot and the aslant surface (245) of its opening; the assembling process combines the support frame (3) and the conductive plate (2), and the external circular surface (32) of the support frame (3) is attached to the combining portion (36) of the conductive plate (2), and the support surface (301) of each support rib (30) is matched with each fixing column (33) passing through each fixing hole (27) to attach and support the fixed planar structure (28) of the conductive plate (2).

## Patentansprüche

1. LED-Beleuchtungsvorrichtung, mit:
einer leitfähigen Platte (2), die gestanzt ist, um einen 3D-Raum zu bilden, mit mindestens einem Elektrodenschlitz (22) und einer Vielzahl von Isolierschlitzen (21), und jeder Isolierschlitz (21) teilt die leitfähige Platte (2) in eine Vielzahl von Streifenstrukturen (20), und jede Streifenstruktur (20) bildet eine feste planare Struktur (28) und eine Vielzahl von Befestigungslöchern (27) zum Formteilpressen, wobei die feste planare Struktur (28) über dem Elektrodenschlitz (22) angebracht ist, und jedes Befestigungsloch (27) ist angrenzend an eine Kante der festen planaren Struktur (28) gebildet;
einer Vielzahl von LED-Chips (11), die in die feste planare Struktur (28) der leitfähigen Platte (2) gekoppelt und installiert sind und quer über den Elektrodenschlitz (22), und vorgesehen zur Aufteilung jeder Streifenstruktur (20) in eine Vielzahl von Parallelschaltungsbereichen (12) des LED-Chips (11), und eine Vielzahl von Verbindungsteilen (23) oder eine Streifenstruktur (20) sind vorgesehen, um jeden Parallelschaltungsbereich (12) in Reihe zu verbinden, um eine Reihen-Parallelschaltung (1) zu bilden;
und einem Tragrahmen, (3) mit Isolierwirkung, bestehend aus einer Vielzahl von Streifentragrippen (30), jede Tragrippe (30) umfasst eine Vielzahl von Befestigungssäulen (33) darauf, und angeordnet in einem Innenraum unter der leitfähigen Platte (2), so dass jede Befestigungssäule (33) mit einem Befestigungsloch (27) der leitfähigen Platte (2) verbunden ist und es durchquert, und ein Belüftungsloch (34) ist zwischen benachbarten Tragrippen (30) gebildet, und jede Tragrippe (30) ist konfiguriert, um einer Streifenstruktur (20) der leitfähigen Platte (2) zu entsprechen;
wobei der Tragrahmen (3) eine Auflagefläche (301) umfasst, die sich zwischen der Tragrippe (30) und jeder Befestigungssäule (33) erstreckt und zur Befestigung des Bodens jeder Ebene der leitfähigen Platte (2) dient, sowie zum Formteilpressen, und jede Befestigungssäule (33) erstreckt sich auf beiden Seiten jedes LED-Chips (11) und durchquert ihn, um einen LED-Chip (11) Lötpunktschutzmechanismus zu bilden, um einen Elektrodenlötpunkt jedes LED-Chips (11) während eines Produktionsverfahrens des LED-Chips (11) zu schützen.

2. LED-Beleuchtungsvorrichtung nach Anspruch 1, wobei der Beleuchtungsschaltkreis (1, 10, 100) einen Reihenschaltkreis hat, der durch jeden Isolierschlitz (21) isoliert wird, und jeder Parallelschaltungsbereich (12) wird durch den Elektrodenschlitz (22) isoliert, und ein Verbindungsteil (23) in dem Parallelschaltungsbereich (12) ist quer über dem Isolierschlitz (21) angebracht und vorgesehen, um eine Hochpotential-Elektrode (223) und eine Niederpotential-Elektrode (222) der Vielzahl von LED-Chips (11) im parallelen Bereich zu verbinden.

3. LED-Beleuchtungsvorrichtung nach Anspruch 1, wobei die leitfähige Platte (2) mit doppelten breiten Bereichen Wärme ableiten kann und der kombinierte Tragrahmen (3) ebenfalls einen zusätzlichen wärmeableitenden Bereich darstellt.

4. LED-Beleuchtungsvorrichtung nach Anspruch 1, die des Weiteren folgendes umfasst: eine Vielzahl von Hilfsteilen (221), die in den Elektrodenschlitz (22) gekoppelt sind, um eine einteilige leitfähige Platte (2) zu bilden, und eine feste planare Struktur (28) ist zwischen den Befestigungslöchern (27) der leitfähigen Platte (2), dem Umfang des LED-Chips (11) und seinem nicht zu öffnenden Bereich gebildet, und jede Gruppe von Befestigungslöchern (27) der leitfähigen Platte (2) und jede Gruppe von Befestigungssäulen (33) jeder Tragrippe (30) ist miteinander verbunden, und eine Auflagefläche (301) zwischen jeder Gruppe von Befestigungssäulen (27) schlägt an den Boden der festen planaren Struktur (28) und haftet dort, so dass der Elektrodenlötpunkt jedes LED-Chips (11) während des Produktionsverfahrens geschützt ist, um die Verformung jedes LED-Chips-Elektrodenlötpunkts zu reduzieren und die Ausbeute zu verbessern, und schließlich wird die Vielzahl von Hilfsteilen (221) entfernt, um einen Kurzschluss der Elektrode zu verhindern und eine komplette Reihen-Parallelschaltung zu bilden.

5. LED-Beleuchtungsvorrichtung nach Anspruch 1, wobei die Niederpotential-Elektrode (222) des Elektrodenschlitzes (22) einen Wärmeübertragungskontakt jedes LED-Chips (11) abdeckt, um die Wärmeableitung jedes LED-Chips (11) zu beschleunigen, wenn der Elektrodenkontakt jedes LED-Chips (11) verlötet ist.

6. LED-Beleuchtungsvorrichtung nach Anspruch 1, wobei jede Befestigungssäule (33) sich in jedes Befestigungsloch (27) zum Verbinden jeder Befestigungssäule (33) erstreckt und es durchquert, so dass jede Befestigungssäule (33) in dem Befestigungsloch (27) durch Verformung oder ein Haftmittel befestigt ist.

7. LED-Beleuchtungsvorrichtung nach Anspruch 1, wobei, wenn jede Streifenstruktur (20) radial angeordnet ist, jedes Verbindungsteil (23) über den Isolierschlitz (21) hinweg angebracht ist, um ein vollständiges Flächengebilde der leitfähigen Platte (2) aufrechtzuerhalten, nachdem die leitfähige Platte (2) gestanzt und geformt wurde.

8. LED-Beleuchtungsvorrichtung nach Anspruch 7, die des Weiteren folgendes umfasst: eine Vielzahl von radialen Isolierschlitzen (21) zur Aufteilung des äußersten Teils jeder Streifenstruktur (20) in kleinere Streifenstrukturen (20), und eine Vielzahl von Elektrodenschlitzen (22), um eine Schaltkreisanforderung zu erfüllen.

9. LED-Beleuchtungsvorrichtung nach Anspruch 1, wobei, wenn jede Streifenstruktur (20) parallel angebracht ist, jeder Elektrodenschlitz (22) in dem Isolierschlitz (21) angebracht ist, und wenn jeder Elektrodenschlitz (22) auf beiden Kanten der Streifenstruktur (20) angebracht ist, liegt der Elektrodenschlitz (22) auf dem Isolierschlitz (21), um das Verbindungsteil (23) von zwei mittleren Streifenstrukturen (20) zu ersetzen, und eine Vielzahl von Gruppen von kürzeren leitfähigen Platten (2) sind in Reihe verbunden, um eine leitfähige Platte (2) mit längeren Streifen zu bilden.

10. LED-Beleuchtungsvorrichtung nach Anspruch 1, wobei, wenn jede Streifenstruktur (20) parallel angebracht ist und die feste planare Struktur (28) durch jeden Isolierschlitz (21) unterteilt ist, zwei benachbarte Streifenstrukturen (20) eine Ebene und einen Elektrodenschlitz (22) zum Formteilpressen bilden, und die Vielzahl von Elektrodenschlitzen (22) ist in dem Isolierschlitz (21) angebracht; und jede Streifenstruktur (20) hat eine Vielzahl von Elektrodenschlitzen (22), und die Befestigungslöcher (27) von zwei benachbarten Streifenstrukturen (20) sind auf beiden Seiten der Ebene gebildet; ein Körper der mittleren Streifenstruktur (20) kann jedes Verbindungsteil (23) ersetzen, um eine Reihenverbindung zwischen den Parallelschaltungsbereichen (12) des LED-Chips (11) zu definieren.

11. LED-Beleuchtungsvorrichtung nach Anspruch 7, die als Flachlampe mit Glühbirne verwendet wird, **gekennzeichnet dadurch, dass** die leitfähige Platte (2) einen Energiekontakt (13, 14) umfasst, einen Elektrodenschlitz (22), ein Positionierungsteil (25), eine Vielzahl von Verbindungsteilen (23), eine Vielzahl von Isolierschlitzen (21) und eine Vielzahl von Streifenstrukturen (20), wobei die Vielzahl von Isolierschlitzen (21) die leitfähige Platte (2) in radial verteilte Streifenstrukturen (20) teilen kann;
wobei die leitfähige Platte (2) des Weiteren eine Vielzahl von Wärmeleitungsflächen (26) umfasst, die im wesentlichen runde, flache kappenförmige Strukturen sind, und die Wärmeleitungsfläche (26) kann an einer runden Außenfläche (32) des Tragrahmens (3) angebracht werden; jede Streifenstruktur (20) umfasst des Weiteren: eine Gruppe von Befestigungslöchern (27), einen Elektrodenschlitz (22), ein Biegeteil (24) und eine Ebene der festen planaren Struktur (28), wobei die Gruppe von Befestigungslöchern (27) an beiden Seiten des Elektrodenschlitzes (22) angebracht ist;
das Biegeteil (24) wird auf einem Außenumfang angebracht und an einer runden Außenfläche (32) des Tragrahmens (3) befestigt, nachdem das Biegeteil (24) gebogen und geformt wurde; und der Tragrahmen (3) ist im wesentlichen eine runde Scheibenstruktur, die mit der leitfähigen Platte (2) zusammenpasst und aus einer radial angeordneten Vielzahl von Streifentragrippen (30) besteht, und jede Tragrippe (30) umfasst eine Gruppe von Befestigungssäulen (33) und die Auflagefläche (301) ist zwischen der Gruppe von Befestigungssäulen (33) angeordnet, und jede Auflagefläche (301) passt mit jeder Gruppe von Befestigungssäulen (33) zusammen und ist mit einem Befestigungsloch (27) der leitfähigen Platte (2) kombiniert, um ein feste planare Struktur (28) der leitfähigen Platte (2) zu tragen und zu befestigen; ein Befestigungsring (31) ist zu der Mitte des Tragrahmens (3) hin installiert und geht durch ein Positionierungsteil (25) der leitfähigen Platte (2); und ein Klinkenschlitz (35) ist auf einer runden Außenfläche (32) des Tragrahmens (3) gebildet, die um den Umfang eines Öffnungsendes herum angeordnet ist.

12. LED-Beleuchtungsvorrichtung nach Anspruch 7, die als Glühbirne mit nach außen gewölbter Oberfläche verwendet wird, **gekennzeichnet dadurch, dass** die leitfähige Platte (2) einen Energiekontakt (13, 14), einen Elektrodenschlitz (22), ein Positionierungsteil (25), eine Vielzahl von Verbindungsteilen (23), eine Vielzahl von Isolierschlitzen (21) und eine Vielzahl von Streifenstrukturen (20) umfasst; wobei die Vielzahl von Isolierschlitzen (21) die leitfähige Platte (2) in eine Vielzahl von radial verteilten Streifenstrukturen (20) teilt; wobei die leitfähige Platte (2) die Form einer halbkugelförmig gewölbten Oberfläche hat, mit einem Ende bestehend aus einer kugelförmig gewölbten Oberfläche (241) und einer kreisförmig gewölbten Oberfläche (242) und das andere Ende bestehend aus einer konisch gewölbten Oberfläche (243) und einer zylindrischen Oberfläche (244), um eine konische Form zu bilden; ein Verbindungsteil (23), das über dem Isolierschlitz (21) angeordnet ist, ist in V-Form gebogen; jede Streifenstruktur (20) umfasst: eine Vielzahl von Biegeteilen (24), eine Gruppe von Befestigungslöchern (27), einen Elektrodenschlitz (22) und eine Ebene der festen planaren Struktur (28); wobei die Vielzahl von Biegeteilen (24), die in einer Richtung von einer zylindrischen Oberfläche (244) zu einer kugelförmig gewölbten Oberfläche (241) hin angeordnet sind, ein Biegeteil (24) umfassen, das zwischen der zylindrischen Oberfläche (244) und der konisch gewölbten Oberfläche (243) angeordnet ist, ein Biegeteil (24), das zwischen der kreisförmig gewölbten Oberfläche (242) und der konisch gewölbten Oberfläche (243) angeordnet ist, und ein Biegeteil (24), das auf der kugelförmig gewölbten Oberfläche (241) angeordnet ist; eines der Befestigungslöcher (27) ist auf der kugelförmig gewölbten Oberfläche (241) angebracht, und ein anderes Befestigungsloch (27) ist auf der kreisförmig gewölbten Oberfläche (242) angebracht; die feste planare Struktur (28) und der Elektrodenschlitz (22) sind zwischen der kugelförmig gewölbten Oberfläche (241) und der kreisförmig gebogenen Oberfläche (242) angeordnet und in der Mitte der Gruppe von Befestigungslöchern (27) angeordnet; und der Tragrahmen (3) ist eine halbkugelförmige Struktur, und jede Tragrippe (30) hat eine Gruppe von Befestigungssäulen (33), und die Auflagefläche (301) ist zwischen jeder Gruppe von Befestigungssäulen (33) angebracht, und jede Auflagefläche (301), die mit jeder Gruppe von Befestigungssäulen (33) zusammenpasst, ist mit einem Befestigungsloch (27) der leitfähigen Platte (2) kombiniert, um eine feste planare Struktur (28) der leitfähigen Platte (2) zu tragen und zu befestigen; einen Befestigungsring (31), der zu der Mitte des Tragrahmens (3) hin installiert ist und durch ein Positionierungsteil (25) der leitfähigen Platte (2) hindurchgeht; und einen Zungenschlitz (35), der auf einer äußeren runden Oberfläche (32) gebildet ist, die an dem äußeren Umfang des Tragrahmens (3) angeordnet ist, und die runde Außenfläche (32) ist nah an der kreisförmig gewölbten Oberfläche (242) der leitfähigen Platte (2) angebracht.

13. LED-Beleuchtungsvorrichtung nach Anspruch 7, die als Glühbirne mit konkav gewölbter Oberfläche verwendet wird, **gekennzeichnet dadurch, dass** die leitfähige Platte (2) einen Energiekontakt (13, 14), einen Elektrodenschlitz (22), ein Positionierungsteil (25), eine Vielzahl von Verbindungsteilen (23), eine Vielzahl von Isolierschlitzen (21) und eine Vielzahl von Streifenstrukturen (20) umfasst; die Vielzahl von Isolierschlitzen (21) teilt die leitfähige Platte (2) in eine Vielzahl von radial verteilten Streifenstrukturen (20); ein Ende der leitfähigen Platte (2) hat eine konkave halbkugelförmig gebogene Oberfläche, die von einer konkaven kugelförmigen Oberfläche (241a) und einer konkaven kreisförmig gewölbten Oberfläche (242a) gebildet wird, und das andere Ende der leitfähigen Platte (2) ist in konischer Form, die von einer konisch gewölbten Oberfläche (243) gebildet wird, und eine zylindrische Oberfläche (244) wird durch das Verbindungsteil (23) in eine V-Form gebogen, das den Isolierschlitz (21) überspannt und verbunden ist; jede Streifenstruktur (20) umfasst eine Vielzahl von Biegeteilen (24), eine Gruppe von Befestigungslöchern (27), einen Elektrodenschlitz (22) und eine Ebene der festen planaren Struktur (28); die Vielzahl von Biegeteilen (24), die in Richtung von der zylindrischen Oberfläche (244) zu der konkaven kugelförmigen Oberfläche (241a) angeordnet ist, umfasst ein Biegeteil (24), das zwischen der zylindrischen Oberfläche (244) und der konisch gewölbten Oberfläche (243) angeordnet ist, ein Biegeteil (24), das zwischen der konkaven kreisförmig gewölbten Oberfläche (242a) und der konisch gewölbten Oberfläche (243) angeordnet ist, und ein Biegeteil (24), das auf der konkaven kugelförmigen Oberfläche (241a) angeordnet ist; wobei eines der Befestigungslöcher (27) auf der konkaven kugelförmigen Oberfläche (241a) angebracht ist und das andere Befestigungsloch (27) auf der konkaven kreisförmig gewölbten Oberfläche (242a) angebracht ist, und die beiden Befestigungslöcher (27) bilden eine Gruppe; die feste planare Struktur (28) und der Elektrodenschlitz (22) sind zwischen der konkaven kugelförmigen Oberfläche (241a) und der konkaven runden gewölbten Oberfläche (242a) und in der Mitte der Gruppe von Befestigungslöchern (27) angeordnet; und der Tragrahmen (3) ist in einer konkaven halbkugelförmigen Struktur gestaltet und durch eine radial angeordnete Vielzahl von Tragrippen (30) gebildet, und jede Tragrippe (30) hat eine Gruppe von Befestigungssäulen (33), und die Auflagefläche (301) ist zwischen der Gruppe von Befestigungssäulen (33) gebildet, und jede Auflagefläche (301), die mit jeder Gruppe von Befestigungssäulen (33) zusammenpasst, geht durch jede Gruppe von Befestigungslöchern (27) und ist damit kombiniert, um die feste planare Struktur (28) der leitfähigen Platte (2) zu tragen und zu befestigen; und die Mitte des Tragrahmens (3) hat einen Befestigungsring (31), der durch eine Zentrierbohrung des Positionierungsteils (25) der leitfähigen Platte (2) hindurchgeht; eine runde Außenfläche (32) des Tragrahmens (3), die auf einem Öffnungsende angeordnet ist, hat einen Zungenschlitz (35), und die runde Außenfläche (32) ist nah an einer kreisförmig gewölbten Oberfläche (242) der leitfähigen Platte (2) angebracht, und eine runde Außenfläche (32), die am äußeren Umfang des Tragrahmens (3) angeordnet ist, ist nahe an dem U-förmigen Biegeteil der leitfähigen Platte (2) angebracht.

14. LED-Beleuchtungsvorrichtung nach Anspruch 8, die als halbkugelförmige Lampe verwendet wird, **gekennzeichnet dadurch, dass** die leitfähige Platte (2) einen Energiekontakt (13, 14), eine Vielzahl von Elektrodenschlitzen (22), ein Positionierungsteil (25), eine Vielzahl von Verbindungsteilen (23), eine Vielzahl von Isolierschlitzen (21) und eine Vielzahl von Streifenstrukturen (20) umfasst, wobei die leitfähige Platte (2) von der Vielzahl von Isolierschlitzen (21) geschnitten wird, um eine Vielzahl von radial angeordneten Streifenstrukturen (20) zu bilden; die leitfähige Platte (2) hat ein Ende, das eine halbkugelförmige gebogene Oberfläche ist, die von der kugelförmig gewölbten Oberfläche (241) und der kreisförmig gewölbten Oberfläche (242) gebildet wird, und die kugelförmige gebogene Oberfläche (241) hat einen Elektrodenschlitz (22), und ein anderer Elektrodenschlitz (22) ist zwischen der kreisförmig gewölbten Oberfläche (242) und der kugelförmig gewölbten Oberfläche (241) gebildet; jede Streifenstruktur (20) hat zwei radiale Unter-Streifen-Strukturen (20), die durch die Vielzahl von Isolierschlitzen (21) geteilt und auf der kreisförmig gewölbten Oberfläche (242) gebildet ist, entsprechend einer Schaltkreiserfordernis; jede Streifenstruktur (20) hat eine Größe, die es ermöglicht, die Vielzahl von LED-Chips (11) zu installieren;
die kugelförmig gebogene Oberfläche (241) und die kreisförmig gebogene Oberfläche (242) haben verschiedene Mengen von Parallelschaltungsbereichen (12), die in Reihe geschaltet sind, und die Vielzahl von Verbindungsteilen (23) ist über den Isolierschlitz (21) hinweg angeordnet und in eine V-Form gebogen, um Umfang und Größe der leitfähigen Platte (2) zu reduzieren, so dass sie eine Raumstruktur der leitfähigen Plattenstruktur bildet; jede Streifenstruktur (20), die mit einem Abstand voneinander in einer Richtung vom Außendurchmesser zum Innendurchmesser angeordnet ist, umfasst ein Biegeteil (24), ein Befestigungsloch (27), einen Elektrodenschlitz (22), ein Befestigungsloch (27), ein Biegeteil (24) und eine Ebene der festen planaren Struktur (28); zwei Befestigungslöcher (27) bilden eine Gruppe, und die Gruppe der Befestigungslöcher (27), die Ebene und der Elektrodenschlitz (22) sind zwischen den obengenannten zwei Biegeteilen (24) angeordnet; der Tragrahmen (3) ist als halbkugelförmige Struktur mit einem Hauptkörper gestaltet, der aus einer Vielzahl von Tragrippen (30) gebildet ist, und mit verschiedenen Mengen von radial angeordneten Tragrippen (30), die auf der kugelförmig gewölbten Oberfläche (241) bzw. der kreisförmig gebogenen Oberfläche (242) angeordnet sind; jede Tragrippe (30) passt mit der Streifenstruktur (20) der leitfähigen Platte (2) zusammen; jede Tragrippe (30) hat eine Gruppe von Befestigungssäulen (33), eine Auflagefläche (301), die zwischen der Gruppe von Befestigungssäulen (33) angeordnet ist, und jede Auflagefläche (301), die mit jeder Gruppe von Befestigungssäulen (33) zusammenpasst, kann von jeder Gruppe von Befestigungslöchern (27) durchquert werden und damit verbunden sein, so dass sie die feste planare Struktur (28) der leitfähigen Platte (2) tragen und befestigen; ein Belüftungsloch (34) ist zwischen den Tragrippen (30) gebildet; eine runde Außenfläche (32) des Tragrahmens (3) hat einen Zungenschlitz (35), und die runde Außenfläche (32) ist an der kreisförmig gewölbten Oberfläche (242) der leitfähigen Platte (2) befestigt.

15. LED-Beleuchtungsvorrichtung nach Anspruch 14, die als Glühbirnenlampe verwendet wird, wobei die Glühbirnenlampe von zwei identischen leitfähigen Platten (2) und zwei Tragrahmen (3) gebildet wird, und jede leitfähige Platte (2) wird von einem Tragrahmen (3) getragen und befestigt; jeder Tragrahmen (3) hat einen Zungenschlitz (35) und ein Kombinationsteil (36) am Öffnungsende der runden Außenfläche (32), so dass zwei Tragrahmen (3) nah ineinander eingebettet werden können, und das Öffnungsende der runden Außenfläche (32) jedes Tragrahmens (3) hat ein Schlingenloch (321), um die Schlinge zu installieren und ein Netzkabel (37).

16. LED-Beleuchtungsvorrichtung nach Anspruch 9, die als langes Lampenrohr verwendet wird, **gekennzeichnet dadurch, dass** die Struktur der leitfähigen Platte (2) einen Energiekontakt (13, 14), eine Vielzahl von Elektrodenschlitzen (22), eine Vielzahl von Verbindungsteilen (23), eine Vielzahl von Isolierschlitzen (21) und eine Vielzahl von Streifenstrukturen (20) umfasst, wobei die leitfähige Platte (2) von einer Vielzahl von Isolierschlitzen (21) geschnitten wird, um eine Vielzahl von parallelen Streifenstrukturen (20) zu bilden; die leitfähige Platte (2) umfasst außerdem eine U-förmige Querschnittsstruktur mit zwei Laschenverbindungsteilen (262),
und der U-förmige Querschnitt wird gebildet, indem man die Vielzahl von Biegeteilen (24) zu einem relativen Abstand biegt, und jedes Laschenverbindungsteil (262) wird durch Biegung zweier Biegeteile (24) an den Kanten gebildet; wenn die Lasche der Lampenabdeckung (6) in einen Zungenschlitz (35) des Tragrahmens (3) eingebettet wird, ist das Kombinationsteil (36) verbunden und befestigt; jede Streifenstruktur (20) hat eine Vielzahl von Biegeteilen (24), eine Vielzahl von Befestigungslöchern (27), eine Vielzahl von Elektrodenschlitzen (22) und eine Vielzahl von Ebenen der festen planaren Struktur (28); wobei jede Ebene und der Elektrodenschlitz (22) zwischen zwei Biegeteilen (24) mit verschiedenen Abständen angeordnet sind und von einem der Isolierschlitze (21) in zwei Teile geteilt sind, so dass zwei benachbarte Streifenstrukturen (20) in jeder Ebene und im Elektrodenschlitz (22) zusammengebaut sind, und jeder Elektrodenschlitz (22) ist auf den Isolierschlitz (21) montiert; ein Befestigungsloch (21) ist an einer Kante der Vielzahl von Elektrodenschlitze (22) jeder Streifenstruktur (20) gebildet; die beiden Befestigungslöcher (27) der beiden benachbarten Streifenstrukturen (20) sind an beiden Seiten jeder Ebene angeordnet und kombiniert, um eine Gruppe zu bilden; ein Körper der mittleren Streifenstruktur (20) ersetzt das Verbindungsteil (23), um eine Reihenverbindung zwischen den LED-Chip-Parallelschaltungsbereichen (12) zu definieren; und der Tragrahmen (3) ist eine rechteckige Struktur mit einem U-förmigen Querschnitt, und die Vielzahl von querlaufenden parallelen Tragrippen (30) sind zu einer Streifenstruktur (20) zusammengebaut; jede Tragrippe (30) hat eine Gruppe von Befestigungssäulen (33), und eine Auflagefläche (301), die zwischen der Gruppe von Befestigungssäulen (33) angeordnet ist, und jede Auflagefläche (301), die zu jeder Gruppe von Befestigungssäulen (33) passt, kann von jeder Gruppe von Befestigungslöchern (27) durchquert und damit verbunden sein, um die feste planare Struktur (28) der leitfähigen Platte (2) zu tragen und zu befestigen; mehr als ein Belüftungsloch (34) ist zwischen den Tragrippen (30) gebildet; der Tragrahmen (3) hat zwei seitliche Außenkanten (320); jede Gruppe von Befestigungssäulen (33) wird von jeder Gruppe von Befestigungslöchern (27) durchquert bzw. ist damit kombiniert; und die Außenseitenkante (320) des Tragrahmens (3) hat einen Zungenschlitz (35) und einen inneren Zungenschlitz (35a).

17. LED-Beleuchtungsvorrichtung nach Anspruch 10, die als rechteckige flache Lampe verwendet wird, wobei die leitfähige Platte (2) einen Energiekontakt (13, 14), eine Vielzahl von Elektrodenschlitzen (22), eine Vielzahl von Verbindungsteilen (23), eine Vielzahl von Isolierschlitzen (21) und eine Vielzahl von Streifenstrukturen (20) umfasst; die Vielzahl von Isolierschlitzen (21), die in Reihen- oder Spaltenrichtung angeordnet sind, ist aufgeschnitten, um eine Vielzahl von parallelen Streifenstrukturen (20) zu bilden; die leitfähige Platte (2) ist durch eine Vielzahl von rechteckigen Schlitzen gebildet, die durch mehrere Spalten in mehreren Reihen angeordnet sind, und die benachbarten rechteckigen Schlitze sind miteinander durch ihre schiefen Kanten verbunden, und die Ebene des Bodens hat einen Elektrodenschlitz (22) und jeder LED-Chip (11) ist darauf installiert, und ihr äußerer Umfang hat ein Kombinationsteil (36) der Lasche (63); und der Reihen- oder Spaltenschlitz hat einen Querschnitt, der durch Biegen der Vielzahl von Biegeteilen (24) und der Biegeteile (24) auf zwei Kanten der schiefen Oberfläche (245) in Reihen- oder Spaltenrichtung entsteht; jede Streifenstruktur (20) hat eine Vielzahl von Biegeteilen (24), eine Vielzahl von Befestigungslöchern (27), eine Vielzahl von Elektrodenschlitzen (22) und eine Vielzahl von Ebenen der festen planaren Struktur (28); jede Ebene und der Elektrodenschlitz (22) sind zwischen zwei Reihen- und Spalten-Biegeteile (24) in verschiedenem Abstand angeordnet und durch den Isolierschlitz (21) in zwei Teile geteilt, und zwei benachbarte Streifenstrukturen (20) sind zusammengebaut, um die Ebene und den Elektrodenschlitz (22) zu bilden, und jeder Elektrodenschlitz (22) ist auf den Isolierschlitz (21) montiert; jede Streifenstruktur (20) hat eine Vielzahl von Elektrodenschlitzen (22), und die Kante jedes Verbindungsteils (23) hat ein Befestigungsloch (27); die Befestigungslöcher (27) der beiden benachbarten Streifenstrukturen (20) sind auf beiden Seiten der Ebene angeordnet und in einer Gruppe kombiniert; ein Körper der mittleren Streifenstruktur (20) ersetzt das Verbindungsteil (23), um eine Reihenverbindung zwischen den LED-Chip-Parallelschaltungsbereichen (12) zu definieren; der Tragrahmen (3) hat rechteckige Form mit einer Vielzahl von rechteckigen Schlitzen, die in Reihen und Spalten angeordnet sind, und jeder rechteckige Schlitz hat eine Streifentragrippe (30), die darin installiert ist und mit der Ebene des rechteckigen Schlitzes der leitfähigen Platte (2) zusammenpasst, und jede Streifentragrippe (30) hat eine Vielzahl von Auflageflächen (301) und zwei Befestigungssäulen (33), und die beiden Befestigungssäulen (33) können von dem Befestigungsloch (27) der leitfähigen Platte (2) durchquert und damit verbunden werden, um die feste planare Struktur (28) zu tragen und zu befestigen; beide Seiten jeder Tragrippe (30) haben je zwei Belüftungslöcher (34); eine runde Außenfläche (32) des Tragrahmens (3) hat einen Zungenschlitz (35), und die runde Außenfläche (32) des Tragrahmens (3) ist an dem Kombinationsteil (36) der leitfähigen Platte (2) befestigt.

18. Herstellungsverfahren (9) für eine LED-Beleuchtungsvorrichtung nach Anspruch 1, mit einem Entladeverfahren, einem Montageverfahren, einem Rückgewinnungsverfahren, einem Formungsvorbereitungsverfahren, einem Biegeverfahren, einem Zusammenbauverfahren und einem Hilfsteilentfernungsverfahren; und die obengenannten Verfahren unfasssen des Weiteren die Maßnahme eines LED-Chip-Schutzmechanismus, so dass ein Elektrodenlötpunkt jedes LED-Chips (11) während des Herstellungsverfahrens geschützt ist, und die Verformung wird bei den Verfahren verringert, wobei das Entladeverfahren ein Metallblatt stanzt, um eine Werkstoffplatte (8) zu bilden, so dass die Werkstoffplatte (8) eine Vielzahl von Streifenstrukturen (20) umfasst, die durch eine Vielzahl von Isolierschlitzen (21) getrennt sind, und es ist eine Vielzahl von Hilfsteilen (221) vorgesehen, die fähig sind, einen Kurzschluss zu verursachen, und quer über ein Verbindungsteil (23) des Isolierschlitzes (21) angeordnet sind, um die Streifenstruktur (20) zu verbinden, und die Werkstoffplatte (8) ist als Plattenstruktur gebildet;
das Montageverfahren montiert den LED-Chip (11) auf die Vielzahl von Elektrodenschlitzen (22) der Werkstoffplatte (8) durch Löten; das Rückgewinnungsverfahren schneidet die Vielzahl von Verbindungsplatten (82) von der Werkstoffplatte (8) ab und entfernt eine flache Stanzplatte (80);
das Formungsvorbereitungsverfahren verwendet eine Prägeform, um ein Positionierungsteil (25) der Stanzplatte (80) zu pressen und zu positionieren und um die Stanzplatte (80) in einer vorherbestimmten Position vorzupressen, um eine Biegeverformung entsprechend dem erforderlichen 3D-Raum der leitfähigen Platte (2) herzustellen, und die Biegeverformung umfasst die Verformung des Biegeteils (24) und gegebenenfalls die Verformung des Verbindungsteils (23); das Biegeverfahren verwendet die Prägeform, um die feste planare Struktur (28) der vorverformten Stanzplatte (80) zu pressen und das Biegeteil (24) zu biegen, und bildet eine 3D-Raumstruktur der leitfähigen Platte (2) durch die Stanzplatte (80); das Zusammenbauverfahren fügt den Tragrahmen (3) zusammen und kombiniert und befestigt den Tragrahmen (3) im Innern der leitfähigen Platte (2), und lässt jede Befestigungssäule (33) des Tragrahmens (3) durch jedes Befestigungsloch (27) der leitfähigen Platte (2) gehen, so dass jede Auflagefläche (301) die feste planare Struktur (28) der leitfähigen Platte (2) anbringt und trägt, um die notwendige strukturelle Unterstützung der leitfähigen Platte (2) im Folgeverfahren vorzusehen, und ein Belüftungsloch (34), das zwischen den Tragrippen (30) des Tragrahmens (3) gebildet ist, hat einen Bereich, der jedes abgeschnittene Hilfsteil (221) der leitfähigen Platte (2) abdecken kann; und das Hilfsteilentfernungsverfahren verwendet die Prägeform, um die feste planare Struktur (28) der leitfähigen Platte (2) und die Tragrippe (30) des Tragrahmens (3) zu pressen und des Weiteren, um jedes Hilfsteil (221) der leitfähigen Platte (2) aufzuschneiden, damit die Elektrode nicht kurzgeschlossen wird, um eine Reihen-Parallelschaltung zu vollenden.

19. Herstellungsverfahren (9) für eine LED-Beleuchtungsvorrichtung nach Anspruch 18, wobei der LED-Chip-Schutzmechanismus installiert ist und durch die Vielzahl von Hilfsteilen (221) in den Elektrodenschlitz (22) verbunden ist, um eine einteilige leitfähige Platte (2) zu bilden, und bildet die feste planare Struktur (28) zwischen den Befestigungslöchern (27) der leitfähigen Platte (2), der Peripherie des LED-Chips (11) und seinem nicht zu öffnenden Bereich, und jede Gruppe von Befestigungslöchern (27) der leitfähigen Platte (2) und jede Gruppe von Befestigungssäulen (33) jeder Tragrippe (30) sind miteinander kombiniert, und eine Auflagefläche zwischen jeder Gruppe von Befestigungssäulen (33) befestigt, presst und trägt die feste planare Struktur (28) der leitfähigen Platte (2), so dass ein Elektrodenlötpunkt jedes LED-Chips (11) während des Herstellungsverfahrens geschützt werden kann.

20. Herstellungsverfahren (9) für eine LED-Beleuchtungsvorrichtung nach Anspruch 19, das für eine Flachlampe mit Glühbirne angewandt wird, wobei das Biegeverfahren das Biegeteil am Außendurchmesser biegt, um eine flache kappenförmige leitfähige Platte mit einer runden Oberfläche zu bilden und das Positionierungsteil (25) zu schneiden, um ein Mittelloch zu bilden; das Zusammenbauverfahren lässt jede Befestigungssäule (33) des Tragrahmens (3) durch das Befestigungsloch (27) der leitfähigen Platte (2) gehen, und die Auflagefläche (301) jeder Tragrippe (30) passt mit jeder Befestigungssäule (33) zusammen, die durch jedes Befestigungsloch (27) geht, zum Befestigen und Tragen der festen planaren Struktur (28) der leitfähigen Platte (2), und eine runde Außenfläche (32) des Tragrahmens (3) ist an dem Biegeteil (24) der leitfähigen Platte (2) befestigt, und ein Befestigungsring (31) des Tragrahmens (3) wird durch das Mittelloch des Positionierungsteils (25) geleitet.

21. Herstellungsverfahren (9) für eine LED-Beleuchtungsvorrichtung nach Anspruch 19, das für eine Glühbirne mit nach außen gewölbter Oberfläche angewandt wird, wobei das Biegeverfahren des Weiteren ein Vormontagebiegeverfahren und ein Biegeverfahren nach der Montage umfasst; das Formungsvorbereitungsverfahren verwendet des weiteren die Prägeform, um das Mittelloch des Positionierungsteils (25) zu positionieren, und presst die feste planare Struktur (28) eng zusammen und biegt jedes Verbindungsteil (23) des Isolierschlitzes (21), das quer über die leitfähige Platte (2) angeordnet ist, in eine V-Form, so dass es jede Streifenstruktur (20) nach hinten biegt, und reduziert jede Streifenstruktur (20) nahe dem Biegeteil (24) entlang der Umfangsrichtung, so dass die Breite jedes Isolierschlitzes (21) weiter verringert wird, und jetzt wird die Stanzplatte (80) zu einer konischen Struktur, und jeder LED-Chip (11) liegt auf der Außenseite, und der äußere Umfang jedes LED-Chips (11) wird noch flach gehalten; das Vormontagebiegeverfahren umfasst des Weiteren ein Biegeverfahren für eine kugelförmig gebogene Oberfläche und ein Biegeverfahren für eine kreisförmig gebogene Oberfläche, wobei das Biegeverfahren für eine kugelförmig gebogene Oberfläche die Prägeform verwendet, um das Positionierungsteil (25) und die feste planare Struktur (28) in einen vorherbestimmten konischen Winkel zu pressen, und dann führt es eine Formung einer kugelförmig gewölbten Oberfläche aus, und die Breite des Isolierschlitzes (21) am Außendurchmesser wird weiter verringert; das Biegeverfahren für eine kreisförmig gebogene Oberfläche schneidet das Positionierungsteil (25), um ein rundes Mittelloch zu bilden, und verwendet die Prägeform, um jede feste planare Struktur (28) zu pressen, um die Formung einer kreisförmig gewölbten Oberfläche auszuführen, und die so geformte Stanzplatte ist eine leitfähige Platte mit einem 3D-Raum, und die kugelförmig gebogene Oberfläche (241) und die kreisförmig gebogene Oberfläche (242) bilden gemeinsam eine halbkugelförmige Form, und jedes Verbindungsteil (23), das quer über den Isolierschlitz (21) angeordnet ist, wird weiter in eine V-Form gebogen, und die Breite des Isolierschlitzes (21) der konisch gewölbten Oberfläche (243) und der zylindrischen Oberfläche (244) wird ebenfalls verringert;
das Zusammenbauverfahren kombiniert des Weiteren den Tragrahmen (3) und die leitfähige Platte (2), und die runde Außenfläche (32) wird an der inneren gewölbten Oberfläche des Biegeteils (24) befestigt, und die Auflagefläche (301) jeder Tragrippe (30) passt mit jeder Befestigungssäule (33) zusammen, die durch jedes Befestigungsloch (27) geht, um die feste planare Struktur (28) der leitfähigen Platte (2) anzubringen und zu tragen, und der Befestigungsring (31) wird durch das Mittelloch des Positionierungsteils (25) geleitet; das Vormontagebiegeverfahren ist ein Biegeverfahren für eine konisch gebogene Oberfläche und eine zylindrische Oberfläche, das die Prägeform verwendet, um den Tragrahmen (3) zu befestigen, nach dem Aufschneiden jedes Hilfsteils (221), und die konisch gebogene Oberfläche (243) und die zylindrische Oberfläche (244) der leitfähigen Platte (2) zu formen, und da das Biegeteil (24) am Schnittpunkt der konisch gewölbten Oberfläche (243) eine Vielzahl von Biegelöchern hat, um die strukturelle Festigkeit zwecks leichteren Biegens abzuschwächen, so dass die runde Außenfläche (32) des Tragrahmens (3) an dem Biegeteil (24) angebracht werden kann, so dass sie die konische gebogene Oberfläche (243) und die zylindrische Oberfläche (244) bildet.

22. Herstellungsverfahren (9) für eine LED-Beleuchtungsvorrichtung nach Anspruch 19, das für eine Glühbirne mit konkav gewölbter Oberfläche angewandt wird, wobei das Biegeverfahren des Weiteren ein Vormontagebiegeverfahren und ein Biegeverfahren nach der Montage umfasst; wobei das Formungsvorbereitungsverfahren des Weiteren die Prägeform verwendet, um das Mittelloch des Positionierungsteils (25) zu positionieren und die feste planare Struktur (28) eng zusammen zu pressen und jedes Verbindungsteil (23) des Isolierungslochs, das quer über die leitfähige Platte (2) angeordnet ist, in eine V-Form zu biegen, und jede Streifenstruktur (20) zur rückwärtigen Seite hin zu biegen und jede Streifenstruktur (20) nahe dem Biegeteil (24) in der Umfangsrichtung zu biegen, um die Breite jedes Isolierschlitzes (21) noch mehr zu reduzieren, und des Weiteren jedes Verbindungsteil (23) in eine tiefe V-Form zu biegen, und jetzt wird die Stanzplatte (80) zu einer konischen Struktur, und jeder LED-Chip (11) ist auf der Außenseite angebracht, und jetzt wird der äußere Umfang jedes LED-Chips (11) flach gehalten; das Vormontagebiegeverfahren umfasst des Weiteren ein Biegeverfahren für eine konkave kugelförmige Oberfläche und ein Biegeverfahren für eine konkave kreisförmig gebogene Oberfläche, wobei das Biegeverfahren für eine konkave kugelförmige Oberfläche des Weiteren die Prägeform verwendet, um das Positionierungsteil (25) und die feste planare Struktur (28) in einen vorherbestimmten konischen Winkel zu pressen und dann die konkave kugelförmige Oberfläche (241a) verformen, und die konkave kugelförmige Oberfläche (241a) der Struktur wird noch als konische Oberfläche beibehalten, und das Biegeteil (24) jeder Streifenstruktur (20) wird am Außendurchmesser des Befestigungslochs (27) gebogen, und der Biegewinkel des Biegeteils (24) ist größer als 90 Grad, so dass die konische gebogene Oberfläche (243) und die zylindrische Oberfläche (244) die Form einer radialen Ebene haben,
und jeder LED-Chip (11) ist immer noch an der Innenseite angeordnet, und die Breite des Isolierschlitzes auf dem Innendurchmesser der konkaven kreisförmig gewölbten Oberfläche (242a) ist verringert, und die Breite des Isolierschlitzes (21) auf dem Außendurchmesser ist größer aufgrund der flächigen Form; das Biegeverfahren für eine konkave kreisförmig gebogene Oberfläche schneidet und entfernt das Positionierungsteil (25), um ein rundes Mittelloch zu bilden, und die Prägeform wird wieder benutzt, um die feste planare Struktur (28) zu pressen und die konkave kreisförmig gebogene Oberfläche (242a) zu bilden, und das Biegeteil (24) am Außendurchmesser des Befestigungslochs (27) jeder Streifenstruktur (20) wird gebogen, so dass das Biegeteil (24) zwischen der konkaven kreisförmig gewölbten Oberfläche (242a) und der konisch gebogene Oberfläche (243) zu einer umgekehrten U-förmigen Biegung wird, und das U-förmige Biegeteil (24b) hat einen Biegewinkel von im wesentlichen 180 Grad, und die so gebildete Stanzplatte (80) wird zur leitfähigen Platte (2) mit einem 3D-Raum, und die konkave kugelförmige Oberfläche (241a) und die konkave kreisförmig gebogene Oberfläche (242a) bilden eine konkave halbkugelförmig gebogene Oberfläche, und die konisch gebogene Oberfläche (243) und die zylindrische Oberfläche (244) bilden einen auseinandergeklappten Zylinder, und das V-förmige Verbindungsteil, das quer über dem Isolierschlitz (21) angeordnet ist, wird noch mehr gebogen, und die Breite der konisch gewölbten Oberfläche (243) und der zylindrischen Oberfläche (244) ist ebenfalls verringert; das Zusammenbauverfahren kombiniert den Tragrahmen (3) und die leitfähige Platte (2) und befestigt eine runde Außenfläche (32) des Tragrahmens (3) an einer inneren gewölbten Oberfläche des U-förmigen Biegeteils (24b), und die Auflagefläche (301) jeder Tragrippe (30) passt mit jeder Befestigungssäule (33) zusammen, die durch jedes Befestigungsloch (27) hindurchgeht, um die feste planare Struktur (28) der leitfähigen Platte (2) anzubringen und zu tragen, und den Zungenschlitz (35) des Tragrahmens (3) durch den Isolierschlitz (21) hindurchgehen zu lassen, und der Befestigungsring (31) wird durch das Mittelloch geleitet; das Biegeverfahren nach der Montage ist ein Biegeverfahren einer konisch gewölbten Oberfläche und zylindrischen Oberfläche und verwendet die Prägeform, um den Tragrahmen (3) zu befestigen, nachdem jedes Hilfsteilverfahren das Prägeformen beendet, und bildet auch die konisch gebogene Oberfläche (243) und die zylindrische Oberfläche (244) der leitfähigen Platte (2), und da die Biegeteile (24) an zwei Schnittpunkten der konisch gewölbten Oberfläche (243) eine Vielzahl von Biegelöchern haben, um die strukturelle Festigkeit abzuschwächen und das Biegeverfahren zu erleichtern, und die runde Außenfläche (32) des Tragrahmens (3) ist an dem U-förmigen Biegeteil (24b) der leitfähigen Platte (2) befestigt, so dass sie die konisch gebogene Oberfläche (243) und die zylindrische Oberfläche (244) bildet.

23. Herstellungsverfahren (9) für eine LED-Beleuchtungsvorrichtung nach Anspruch 18, das für eine halbkugelförmige Lampe angewandt wird, wobei das Formungsvorbereitungsverfahren des Weiteren die Prägeform verwendet, um das Mittelloch des Positionierungsteils (25) zu positionieren und die feste planare Struktur (28) eng zusammen drückt und das Verbindungsteil (23) des Isolierschlitzes (21), das quer über der Stanzplatte (80) angeordnet ist, in eine V-Form biegt, um die Festigkeit des Verbindungsteils (23) entlang der Umfangsrichtung abzuschwächen;
das Formungsvorbereitungsverfahren verwendet des Weiteren die Prägeform, um das Mittelloch des Positionierungsteils (25) zu positionieren, und verringert die Streifenstruktur (20) nahe dem Biegeteil (24) einer kreisförmig gewölbten Oberfläche (242) entlang der Umfangsrichtung, so dass die Breite jedes Isolierschlitzes (21) weiter verringert wird, und jedes V-förmige Verbindungsteil (25) wird weiter in eine tiefe V-Form gebogen, so dass die Stanzplatte (80) der planaren Struktur zu einer konischen Struktur wird, wobei jede Streifenstruktur (20) in der Umfangsrichtung nicht in eine gebogene Oberfläche gebogen worden ist; der äußere Umfang jedes LED-Chips (11) wird in diesem Verfahren planar gehalten; das Biegeverfahren verwendet des Weiteren die Prägeform, um die feste planare Struktur (28) der kugelförmig gewölbten Oberfläche (241) in einen vorherbestimmten konischen Winkel zu pressen, und dann zwei Biegeteile (24) der Streifenstruktur (20) der kugelförmig gewölbten Oberfläche (241) zu biegen, so dass die kreisförmig gebogene Oberfläche (242) zu einer konischen Oberfläche wird; und dann wird das Positionierungsteil (25) geschnitten und entfernt, um ein rundes Mittelloch zu bilden, und die Prägeform wird wieder benutzt, um die feste planare Struktur (28) der kreisförmig gewölbten Oberfläche (242) zu pressen und dann die beiden Biegeteile (24) der Streifenstruktur (20) zu biegen, und die kreisförmig gebogene Oberfläche (242) und die kugelförmig gebogene Oberfläche (241) bilden gemeinsam die leitfähige Platte (2) mit einer halbkugelförmigen Raumstruktur, und das Verbindungsteil (25), das quer über jeden Isolierschlitz (21) angeordnet ist, wird in eine V-Form gebogen; wenn das Zusammenbauverfahren den Tragrahmen (3) und die leitfähige Platte (2) kombiniert, ist die runde Außenfläche (32) des Tragrahmens (3) an der kreisförmig gewölbten Oberfläche (242) der leitfähigen Platte (2) befestigt, und die Auflagefläche (301) jeder Tragrippe (30) passt mit jeder Befestigungssäule (33) zusammen und ist mit ihr kombiniert, die durch jedes Befestigungsloch (27) geht, um die feste planare Struktur (28) der leitfähigen Platte (2) anzubringen und zu tragen.

24. Herstellungsverfahren (9) für eine LED-Beleuchtungsvorrichtung nach Anspruch 18, die für ein langes Lampenrohr angewandt wird, wobei das Biegeverfahren eine Reihe von Befestigungslöchern (27) an einer Außenseite einer Stanzplatte (80) als Positionierungsteil (25) verwendet und des Weiteren die Prägeform verwendet, um die feste planare Struktur (28) der Säule zu pressen und die Biegeteile (24) an beiden Seiten der Stanzplatte (80) in einen Winkel biegen, so dass das Kombinationsteil (36) eine Winkellasche mit einem Winkel im wesentlichen gleich einem rechtem Winkel wird, und dann wird das obengenannte Verfahren wiederholt, und die Prägeform mit einem Biegewinkel wird benutzt, um die Befestigungslöcher (21) an einer anderen Säule zu befestigen und die feste planare Struktur (28) zu pressen und das Biegeteil (24) mehrmals zu biegen, so dass die Stanzplatte (80) eine leitfähige Plattenstruktur mit einem U-förmigen Querschnitt bildet und mit zwei Laschenverbindungsteilen (262); das Zusammenbauverfahren kombiniert den Tragrahmen (3) und die leitfähige Platte (2) und bringt die Außenseitenkante (320) an dem Kombinationsteil (36) an, und die Auflagefläche (301) jeder Tragrippe (30) passt mit jeder Befestigungssäule (33) zusammen und ist mit ihr kombiniert, die durch jedes Befestigungsloch (27) hindurchgeht, um die feste planare Struktur (28) der leitfähigen Platte (2) anzubringen und zu tragen.

25. Herstellungsverfahren (9) für eine LED-Beleuchtungsvorrichtung nach Anspruch 18, das für eine rechteckige flache Lampe angewandt wird und des Weiteren ein Formverfahren umfasst, bei dem das Biegeverfahren des Weiteren die Prägeform verwendet, um eine Zeilen- oder Spaltenrichtung auszuwählen, und das Befestigungsloch (27) der festen planaren Struktur (28) in derselben Richtung wie das Positionierungsteil (25) verwendet, und die feste planare Struktur (28) in Zeilen- oder Spaltenrichtung zu pressen und die Biegeteile (24) an beiden Seiten der Stanzplatte (80) mit einem großen Winkel zu biegen, so dass das Kombinationsteil (36) eine angewinkelte Lasche mit einem Winkel von im wesentlichen 150 Grad hat,
und dann wird das Biegeteil (24) der festen planaren Struktur (28) gebogen, und dasselbe Biegeverfahren wird in eine Richtung wiederholt und dann in eine andere Richtung, bis alle Biegeteile (24) an der festen planaren Struktur (28) und der Umfang des rechteckigen Schlitzes gebogen sind; so dass die Stanzplatte (80) in eine leitfähige Platte (2) geformt wird, die eine Vielzahl von rechteckigen Schlitzstrukturen umfasst, die in Reihen und Spalten angeordnet sind; das Formverfahren formt den rechteckigen Schlitz und verwendet des Weiteren die Prägeform, um jedes Befestigungsloch (27) zu kombinieren und positionieren und drückt eine Ebene der festen planaren Struktur (28) eng zusammen und formt die Endabmessungen des rechteckigen Schlitzes und die schiefe Oberfläche (245) seiner Öffnung; das Zusammenbauverfahren kombiniert den Tragrahmen (3) und die leitfähige Platte (2), und die runde Außenfläche (32) des Tragrahmens (3) ist an dem Kombinationsteil (36) der leitfähigen Platte (2) befestigt, und die Auflagefläche (301) jeder Tragrippe (30) passt mit jeder Befestigungssäule (33) zusammen, die durch jedes Befestigungsloch (27) geht, um die feste planare Struktur (28) der leitfähigen Platte (2) anzubringen und zu tragen.

## Revendications

1. Appareil d'éclairage à diodes électroluminescentes (DEL), comprenant :
une plaque conductrice (2), qui est poinçonnée pour former une structure ayant un espace tridimensionnel (3D), et ayant au moins une fente d'électrode (22) et une pluralité de fentes d'isolation (21), et chaque fente d'isolation (21) divisant la plaque conductrice (2) en une pluralité de structures de bande (20), et chaque structure de bande (20) formant une structure plane fixe (28) et une pluralité de trous de fixation (27) prévus pour un pressage de moule, la structure plane fixe (28) étant disposée à travers la fente d'électrode (22), et chaque trou de fixation (27) étant formé adjacent à un bord de la structure plane fixe (28) ;
une pluralité de puces à DEL (11), couplées et installées dans la structure plane fixe (28) de la plaque conductrice (2) et à travers la fente d'électrode (22), et destinées à diviser chaque structure de bande (20) en une pluralité de zones de circuit parallèles (12) de la puce à DEL (11), et une pluralité de parties de connexion (23) ou une structure de bande (20) étant destinée(s) à connecter chaque zone de circuit parallèle (12) en série pour former un circuit série-parallèle (1) ; et
un cadre de support (3) ayant un effet isolant, comprenant une pluralité de nervures de support (30) de bande, chaque nervure de support (30) comprenant une pluralité de colonnes de fixation (33) sur celle-ci, et étant disposé dans un espace interne sous la plaque conductrice (2), de telle sorte que chaque colonne de fixation (33) est passée à travers et couplée à un trou de fixation (27) de la plaque conductrice (2), et un trou de ventilation (34) est formé entre des nervures de support (30) adjacentes, et chaque nervure de support (30) est configurée pour correspondre à une structure de bande (20) de la plaque conductrice (2) ;
et le cadre de support (3) comprenant une surface de support (301), s'étendant entre la nervure de support (30) et chaque colonne de fixation (33), et destinée à fixer la partie inférieure de chaque plan de la plaque conductrice (2), et utilisée pour un pressage de moule, et chaque colonne de fixation (33) étant passée à travers et étendue sur les deux côtés de chaque puce à DEL (11) pour former un mécanisme de protection de point de soudure de puce à DEL (11) pour protéger un point de soudure d'électrode de chaque puce à DEL (11) durant un processus de fabrication de la puce à DEL (11).

2. Appareil d'éclairage à DEL selon la revendication 1, dans lequel le circuit d'éclairage (1, 10, 100) a un circuit série isolé par chaque fente d'isolation (21), et chaque zone de circuit parallèle (12) est isolée par la fente d'électrode (22), et une partie de connexion (23) dans la zone de circuit parallèle (12) est disposée à travers la fente d'isolation (21) et destinée à connecter une électrode à haut potentiel (223) et un bas potentiel (222) de la pluralité de puces à DEL (11) dans la zone en parallèle.

3. Appareil d'éclairage à DEL selon la revendication 1, dans lequel la plaque conductrice (2) peut dissiper la chaleur avec deux grandes surfaces et le cadre de support (3) combiné augmente également une surface de dissipation de chaleur supplémentaire.

4. Appareil d'éclairage à DEL selon la revendication 1, comprenant en outre une pluralité de parties auxiliaires (221) couplées dans la fente d'électrode (22) pour former une plaque conductrice à un seul composant (2), et une structure plane fixe (28) étant formée entre les trous de fixation (27) de la plaque conductrice (2), la périphérie de la puce à DEL (11), et sa zone ne s'ouvrant pas, et chaque groupe de trous de fixation (27) de la plaque conductrice (2) et chaque groupe de colonnes de fixation (33) de chaque nervure de support (30) étant couplés les uns aux autres, et une surface de support (301) entre chaque groupe de colonnes de fixation (27) fixant et venant en butée contre la partie inférieure de la structure plane fixe (28), de telle sorte que le point de soudure d'électrode de chaque puce à DEL (11) est protégé durant le processus de fabrication pour réduire la déformation de chaque point de soudure d'électrode de puce à DEL et améliorer le taux de rendement, et enfin, la pluralité de parties auxiliaires (221) sont retirées pour empêcher un court-circuit de l'électrode et former un circuit série-parallèle complet.

5. Appareil d'éclairage à DEL selon la revendication 1, dans lequel l'électrode à bas potentiel (222) de la fente d'électrode (22) recouvre un contact de transfert de chaleur de chaque puce à DEL (11) pour accélérer la dissipation de chaleur de chaque puce à DEL (11), lorsque le contact d'électrode de chaque puce à DEL (11) est soudé.

6. Appareil d'éclairage à DEL selon la revendication 1, dans lequel, chaque colonne de fixation (33) est passée à travers et s'étend dans chaque trou de fixation (27) pour connecter chaque colonne de fixation (33), de telle sorte que chaque colonne de fixation (33) est fixée dans le trou de fixation (27) par déformation ou au moyen d'un adhésif.

7. Appareil d'éclairage à DEL selon la revendication 1, dans lequel, lorsque chaque structure de bande (20) est agencée radialement, chaque partie de connexion (23) est disposée à travers la fente d'isolation (21) pour maintenir une structure de feuille intégrale de la plaque conductrice (2) après que la plaque conductrice (2) est poinçonnée et formée.

8. Appareil d'éclairage à DEL selon la revendication 7, comprenant en outre une pluralité de fentes d'isolation (21) radiales pour diviser la partie la plus à l'extérieur de chaque structure de bande (20) en de plus petites structures de bande (20), et une pluralité de fentes d'électrode (22) pour satisfaire une exigence de circuit.

9. Appareil d'éclairage à DEL selon la revendication 1, dans lequel, lorsque chaque structure de bande (20) est agencée en parallèle, chaque fente d'électrode (22) est disposée dans la fente d'isolation (21), et lorsque chaque fente d'électrode (22) est agencée sur les deux bords de la structure de bande (20), la fente d'électrode (22) est située sur la fente d'isolation (21) pour remplacer la partie de connexion (23) par deux structures de bande (20) intermédiaires, et plusieurs groupes de plaques conductrices (2) plus courtes sont connectées en série pour former une plaque conductrice (2) en bande plus longue.

10. Appareil d'éclairage à DEL selon la revendication 1, dans lequel, lorsque chaque structure de bande (20) est agencée en parallèle, et que la structure plane fixe (28) est divisée par chaque fente d'isolation (21), deux structures de bande (20) adjacentes forment un plan et une fente d'électrode (22) pour un pressage de moule, et la pluralité de fentes d'électrode (22) sont agencées dans la fente d'isolation (21) ; et chaque structure de bande (20) a une pluralité de fentes d'électrode (22), et les trous de fixation (27) de deux structures de bande (20) adjacentes sont formés sur les deux côtés du plan ; un corps de la structure de bande (20) intermédiaire peut remplacer chaque partie de connexion (23) pour définir une connexion en série entre les zones de circuit parallèles (12) de la puce à DEL (11).

11. Appareil d'éclairage à DEL selon la revendication 7, qui est utilisé comme lampe à ampoule plate, **caractérisé par le fait que** la plaque conductrice (2) comprend un contact d'alimentation (13, 14), une fente d'électrode (22), une partie de positionnement (25), une pluralité de parties de connexion (23), une pluralité de fentes d'isolation (21), et une pluralité de structures de bande (20), la pluralité de fentes d'isolation (21) pouvant diviser la plaque conductrice (2) en structures de bande (20) réparties radialement ; la plaque conductrice (2) comprenant en outre une pluralité de surfaces de conduction thermique (26) qui sont des structures en forme de cupule à bord relevé sensiblement circulaires, et la surface de conduction thermique (26) pouvant être fixée à une surface circulaire externe (32) du cadre de support (3) ; chaque structure de bande (20) comprenant en outre : un groupe de trous de fixation (27), une fente d'électrode (22), une partie de flexion (24), et un plan de la structure plane fixe (28), le groupe de trous de fixation (27) étant disposé sur les deux côtés de la fente d'électrode (22) ; la partie de flexion (24) étant disposée sur une périphérie externe et fixée à une surface circulaire externe (32) du cadre de support (3) après que la partie de flexion (24) est pliée et formée ; et le cadre de support (3) étant sensiblement une structure de disque circulaire appariée à la plaque conductrice (2) et composée d'une pluralité de nervures de support de bande (30) agencées radialement, et chaque nervure de support (30) ayant un groupe de colonnes de fixation (33) et la surface de support (301) disposée entre le groupe de colonnes de fixation (33), et chaque surface de support (301) étant appariée à chaque groupe de colonnes de fixation (33) et étant combinée avec un trou de fixation (27) de la plaque conductrice (2) pour supporter et fixer une structure plane fixe (28) de la plaque conductrice (2) ; une bague de fixation (31) installée au centre du cadre de support (3) et passant à travers une partie de positionnement (25) de la plaque conductrice (2) ; et une fente de verrouillage (35) qui est formée sur une surface circulaire externe (32) du cadre de support (3) disposé autour de la périphérie d'une extrémité d'ouverture.

12. Appareil d'éclairage à DEL selon la revendication 7, qui est utilisé comme ampoule à surface incurvée convexe, **caractérisé par le fait que** la plaque conductrice (2) comprend un contact d'alimentation (13, 14), une fente d'électrode (22), une partie de positionnement (25), une pluralité de parties de connexion (23), une pluralité de fentes d'isolation (21), et une pluralité de structures de bande (20) ; la pluralité de fentes d'isolation (21) divisant la plaque conductrice (2) en une pluralité de structures de bande (20) réparties radialement ; la plaque conductrice (2) ayant une forme de surface incurvée hémisphérique avec une extrémité composée d'une surface incurvée sphérique (241) et d'une surface incurvée circulaire (242) et l'autre extrémité composée d'une surface incurvée conique (243) et d'une surface cylindrique (244) pour former une forme conique ; une partie de connexion (23), disposée à travers la fente d'isolation (21), qui est pliée selon une forme en V ; chaque structure de bande (20) comprenant : une pluralité de parties de flexion (24), un groupe de trous de fixation (27), une fente d'électrode (22), et un plan de la structure plane fixe (28) ; la pluralité de parties de flexion (24) agencées dans une direction allant d'une surface cylindrique (244) vers une surface incurvée sphérique (241) comprenant une partie de flexion (24) disposée entre la surface cylindrique (244) et la surface incurvée conique (243), une partie de flexion (24) disposée entre la surface incurvée circulaire (242) et la surface incurvée conique (243), et une partie de flexion (24) disposée sur la surface incurvée sphérique (241) ; l'un des trous de fixation (27) étant disposé sur la surface incurvée sphérique (241), et un autre trou de fixation (27) étant disposé sur la surface incurvée circulaire (242) ; la structure plane fixe (28) et la fente d'électrode (22) étant disposées entre la surface incurvée sphérique (241) et la surface incurvée circulaire (242) et agencées au milieu du groupe de trous de fixation (27) ; et le cadre de support (3) étant une structure hémisphérique, et chaque nervure de support (30) ayant un groupe de colonnes de fixation (33), et la surface de support (301) étant disposée entre chaque groupe de colonnes de fixation (33), et chaque surface de support (301) appariée à chaque groupe de colonnes de fixation (33) étant combinée avec un trou de fixation (27) de la plaque conductrice (2) pour supporter et fixer une structure plane fixe (28) de la plaque conductrice (2) ; une bague de fixation (31), installée au centre du cadre de support (3), et passant à travers une partie de positionnement (25) de la plaque conductrice (2) ; et une fente de verrouillage (35) formée sur une surface circulaire externe (32) disposée sur la circonférence externe du cadre de support (3), et la surface circulaire externe (32) étant fixée de manière étroite à la surface incurvée circulaire (242) de la plaque conductrice (2).

13. Appareil d'éclairage à DEL selon la revendication 7, qui est utilisé comme ampoule à surface incurvée concave, **caractérisé par le fait que** la plaque conductrice (2) comprend un contact d'alimentation (13, 14), une fente d'électrode (22), une partie de positionnement (25), une pluralité de parties de connexion (23), une pluralité de fentes d'isolation (21), et une pluralité de structures de bande (20) ; la pluralité de fentes d'isolation (21) divisant la plaque conductrice (2) en une pluralité de structures de bande (20) réparties radialement ; une extrémité de la plaque conductrice (2) ayant une surface incurvée hémisphérique concave formée par une surface sphérique concave (241a) et une surface incurvée circulaire concave (242a), et l'autre extrémité de la plaque conductrice (2) ayant une forme conique formée par une surface incurvée conique (243) et une surface cylindrique (244) étant pliée selon une forme en V par la partie de connexion (23) connectée et s'étendant à travers la fente d'isolation (21) ; chaque structure de bande (20) comprenant une pluralité de parties de flexion (24), un groupe de trous de fixation (27), une fente d'électrode (22), et un plan de la structure plane fixe (28) ; la pluralité de parties de flexion (24) agencées dans la direction allant de la surface cylindrique (244) vers la surface sphérique concave (241a) comprenant une partie de flexion (24) disposée entre la surface cylindrique (244) et la surface incurvée conique (243), une partie de flexion (24) disposée entre la surface incurvée circulaire concave (242a) et la surface incurvée conique (243), et une partie de flexion (24) disposée sur la surface sphérique concave (241a) ; l'un des trous de fixation (27) étant disposé sur la surface sphérique concave (241a) et l'autre trou de fixation (27) étant disposé sur la surface incurvée circulaire concave (242a), et les deux trous de fixation (27) formant un groupe ; la structure plane fixe (28) et la fente d'électrode (22) étant disposées entre la surface sphérique concave (241a) et la surface incurvée circulaire concave (242a) et disposées au milieu du groupe de trous de fixation (27) ; et le cadre de support (3) étant conçu sous la forme d'une structure hémisphérique concave et formé par une pluralité de nervures de support (30) agencées radialement, et chaque nervure de support (30) ayant un groupe de colonnes de fixation (33), et la surface de support (301) étant formée entre le groupe de colonnes de fixation (33), et chaque surface de support (301) appariée à chaque groupe de colonnes de fixation (33) étant passée à travers et combinée avec chaque groupe de trous de fixation (27), de façon à supporter et à fixer la structure plane fixe (28) de la plaque conductrice (2) ; et le centre du cadre de support (3) ayant une bague de fixation (31) passant à travers un trou central de la partie de positionnement (25) de la plaque conductrice (2) ; une surface circulaire externe (32) du cadre de support (3) disposé sur une extrémité d'ouverture ayant une fente de verrouillage (35), et la surface circulaire externe (32) étant fixée de manière étroite à une surface incurvée circulaire (242) de la plaque conductrice (2), et une surface circulaire externe (32) disposée sur la circonférence externe du cadre de support (3) étant fixée de manière étroite à la partie de flexion en forme de U de la plaque conductrice (2).

14. Appareil d'éclairage à DEL selon la revendication 8, qui est utilisé comme lampe hémisphérique, **caractérisé par le fait que** la plaque conductrice (2) comprend un contact d'alimentation (13, 14), une pluralité de fentes d'électrode (22), une partie de positionnement (25), une pluralité de parties de connexion (23), une pluralité de fentes d'isolation (21), et une pluralité de structures de bande (20), la plaque conductrice (2) étant coupée par la pluralité de fentes d'isolation (21) pour former une pluralité de structures de bande (20) agencées radialement ; la plaque conductrice (2) ayant une extrémité qui est une surface incurvée hémisphérique formée par la surface incurvée sphérique (241) et la surface incurvée circulaire (242), et la surface incurvée sphérique (241) ayant une fente d'électrode (22), et une autre fente d'électrode (22) formée entre la surface incurvée circulaire (242) et la surface incurvée sphérique (241) ; chaque structure de bande (20) ayant deux structures de sous-bande (20) radiales divisées par la pluralité de fentes d'isolation (21) et formées sur la surface incurvée circulaire (242) selon une exigence de circuit ; chaque structure de bande (20) ayant une taille permettant d'installer la pluralité de puces à DEL (11) ; la surface incurvée sphérique (241) et la surface incurvée circulaire (242) ayant différentes quantités de zones de circuit parallèles (12) connectées en série, et la pluralité de parties de connexion (23) étant disposées à travers la fente d'isolation (21) et pliées selon une forme en V pour réduire la circonférence et la taille de la plaque conductrice (2), de façon à former une structure d'espace de la structure de plaque conductrice ; chaque structure de bande (20) agencée avec un intervalle d'écart dans une direction allant du diamètre externe vers le diamètre interne comprenant une partie de flexion (24), un trou de fixation (27), une fente d'électrode (22), un trou de fixation (27), une partie de flexion (24), et un plan de la structure plane fixe (28) ; deux trous de fixation (27) formant un groupe, et le groupe des trous de fixation (27), le plan et la fente d'électrode (22) étant disposés entre les deux parties de flexion (24) mentionnées ci-dessus ; le cadre de support (3) étant conçu sous la forme d'une structure hémisphérique ayant un corps principal formé par une pluralité de nervures de support (30), et ayant différentes quantités de nervures de support (30) agencées radialement, disposées sur la surface incurvée sphérique (241) et la surface incurvée circulaire (242), respectivement ; chaque nervure de support (30) étant appariée à la structure de bande (20) de la plaque conductrice (2) ; chaque nervure de support (30) ayant un groupe de colonnes de fixation (33), une surface de support (301) disposée entre le groupe de colonnes de fixation (33), et chaque surface de support (301) appariée à chaque groupe de colonnes de fixation (33) pouvant être passée à travers et combinée avec chaque groupe de trous de fixation (27), de façon à supporter et à fixer la structure plane fixe (28) de la plaque conductrice (2) ; un trou de ventilation (34) étant formé entre les nervures de support (30) ; une surface circulaire externe (32) du cadre de support (3) ayant une fente de verrouillage (35), et la surface circulaire externe (32) étant fixée à la surface incurvée circulaire (242) de la plaque conductrice (2).

15. Appareil d'éclairage à DEL selon la revendication 14, qui est utilisé comme lampe à ampoule, la lampe à ampoule étant formée par deux plaques conductrices (2) identiques et deux cadres de support (3), et chaque plaque conductrice (2) étant supportée et fixée par un cadre de support (3) ; chaque cadre de support (3) ayant une fente de verrouillage (35) et une partie de combinaison (36) formée au niveau de l'extrémité d'ouverture de la surface circulaire externe (32), de telle sorte que deux cadres de support (3) peuvent être intégrés étroitement l'un dans l'autre, et l'extrémité d'ouverture de la surface circulaire externe (32) de chaque cadre de support (3) a un trou d'élingue (321) prévu pour installer l'élingue et un cordon d'alimentation (37).

16. Appareil d'éclairage à DEL selon la revendication 9, qui est utilisé comme un tube de lampe allongé, **caractérisé par le fait que** la structure de la plaque conductrice (2) comprend un contact d'alimentation (13, 14), une pluralité de fentes d'électrode (22), une pluralité de parties de connexion (23), une pluralité de fentes d'isolation (21), et une pluralité de structures de bande (20), la plaque conductrice (2) étant coupée par une pluralité de fentes d'isolation (21) pour former une pluralité de structures de bande (20) parallèles ; la plaque conductrice (2) comprenant en outre une structure en coupe transversale en forme de U ayant deux parties de combinaison de rabat (262), et la section transversale en forme de U étant formée par pliage de la pluralité de parties de flexion (24) à une distance relative, et chaque partie de combinaison de rabat (262) étant formée par pliage de deux parties de flexion (24) au niveau des bords ; lorsque le rabat du couvercle de lampe (6) est inséré une chaque fente de verrouillage (35) du cadre de support (3), la partie de combinaison (36) est mise en prise et fixée ; chaque structure de bande (20) ayant une pluralité de parties de flexion (24), une pluralité de trous de fixation (27), une pluralité de fentes d'électrode (22), et une pluralité de plans de la structure plane fixe (28) ; chaque plan et la fente d'électrode (22) étant disposés entre deux parties de flexion (24) ayant différents intervalles et divisés en deux parties par l'une des fentes d'isolation (21), de telle sorte que deux structures de bande (20) adjacentes sont assemblées dans chaque plan et la fente d'électrode (22), et chaque fente d'électrode (22) est montée sur la fente d'isolation (21) ; un trou de fixation (21) étant formé à un bord de la pluralité de fentes d'électrode (22) de chaque structure de bande (20) ; les deux trous de fixation (27) des deux structures de bande (20) adjacentes étant disposés sur les deux côtés de chaque plan et combinés pour former un groupe ; un corps de la structure de bande (20) intermédiaire remplaçant la partie de connexion (23) pour définir une connexion en série entre les zones de circuit parallèles (12) de puce à DEL ; et le cadre de support (3) étant une structure rectangulaire à section transversale en forme de U, et la pluralité de nervures de support (30) parallèles transversales étant assemblées en une structure de bande (20) ; chaque nervure de support (30) ayant un groupe de colonnes de fixation (33), et une surface de support (301) disposée entre le groupe de colonnes de fixation (33), et chaque surface de support (301) appariée à chaque groupe de colonnes de fixation (33) pouvant être passée à travers et combinée avec chaque groupe de trous de fixation (27) pour supporter et fixer la structure plane fixe (28) de la plaque conductrice (2) ; plus d'un trou de ventilation (34) étant formé entre les nervures de support (30) ; le cadre de support (3) ayant deux bords latéraux externes (320) ; chaque groupe de colonnes de fixation (33) étant passé à travers et combiné avec chaque groupe de trous de fixation (27), respectivement ; et le bord latéral externe (320) du cadre de support (3) ayant une fente de verrouillage (35) et une fente de verrouillage interne (35a).

17. Appareil d'éclairage à DEL selon la revendication 10, qui est utilisé comme lampe plate rectangulaire, la plaque conductrice (2) comprenant un contact d'alimentation (13, 14), une pluralité de fentes d'électrode (22), une pluralité de parties de connexion (23), une pluralité de fentes d'isolation (21), et une pluralité de structures de bande (20) ; la pluralité de fentes d'isolation (21) agencées dans une direction de rangée ou une direction de colonne étant découpées ouvertes pour former une pluralité de structures de bande (20) parallèles ; la plaque conductrice (2) étant formée par une pluralité de fentes rectangulaires agencées dans plusieurs rangées par plusieurs colonnes, et les fentes rectangulaires adjacentes étant reliées les unes aux autres par leurs bords obliques, et le plan de la partie inférieure ayant une fente d'électrode (22) et chaque puce à DEL (11) installés sur celui-ci, et sa périphérie externe ayant une partie de combinaison (36) du rabat (63) ; et la fente de rangée ou de colonne ayant une section transversale formée par pliage de la pluralité de parties de flexion (24) et des parties de flexion (24) sur deux bords de la surface oblique (245) le long de la direction de rangée ou de colonne ; chaque structure de bande (20) ayant une pluralité de parties de flexion (24), une pluralité de trous de fixation (27), une pluralité de fentes d'électrode (22), et une pluralité de plans de la structure plane fixe (28) ; chaque plan et la fente d'électrode (22) étant disposés entre deux parties de flexion de rangée et de colonne (24) avec un intervalle d'écart différent et divisés en deux parties par la fente d'isolation (21), et deux structures de bande (20) adjacentes étant assemblées pour former le plan et la fente d'électrode (22), et chaque fente d'électrode (22) étant montée sur la fente d'isolation (21) ; chaque structure de bande (20) ayant une pluralité de fentes d'électrode (22), et le bord de chaque partie de connexion (23) ayant un trou de fixation (27) ; les trous de fixation (27) des deux structures de bande (20) adjacentes étant disposés sur les deux côtés du plan et combinés en un groupe ; un corps de la structure de bande intermédiaire (20) remplaçant la partie de connexion (23) pour définir une connexion en série entre les zones de circuit parallèles de puce à DEL (12) ; le cadre de support (3) ayant une forme rectangulaire présentant une pluralité de fentes rectangulaires agencées en rangées et en colonnes, et chaque fente rectangulaire ayant une nervure de support de bande (30) installée dans celle-ci et appariée au plan de la fente rectangulaire de la plaque conductrice (2), et chaque nervure de support de bande (30) ayant une pluralité de surfaces de support (301) et deux colonnes de fixation (33), et les deux colonnes de fixation (33) pouvant être passées à travers et combinées avec le trou de fixation (27) de la plaque conductrice (2) pour supporter et fixer la structure plane fixe (28) ; les deux côtés de chaque nervure de support (30) ayant deux trous de ventilation (34), respectivement ; une surface circulaire externe (32) du cadre de support (3) ayant une fente de verrouillage (35), et la surface circulaire externe (32) du cadre de support (3) étant fixée à la partie de combinaison (36) de la plaque conductrice (2).

18. Procédé de fabrication (9) d'un appareil d'éclairage à DEL selon la revendication 1, comprenant un processus de déchargement, un processus de montage, un processus de retraitement, un processus de préparation de formation, un processus de flexion, un processus d'assemblage et un processus de retrait de partie auxiliaire ; et les processus mentionnés ci-dessus comprenant en outre la mesure d'un mécanisme de protection de puce à DEL, de telle sorte qu'un point de soudure d'électrode de chaque puce à DEL (11) est protégé durant le processus de fabrication, et la déformation est réduite dans les processus, le processus de déchargement poinçonnant une feuille métallique pour former un panneau de matériau (8), de telle sorte que le panneau de matériau (8) comprend une pluralité de structures de bande (20) séparées par une pluralité de fentes d'isolation (21), et une pluralité de parties auxiliaires (221) capables d'entraîner un court-circuit et disposées à travers une partie de connexion (23) de la fente d'isolation (21) sont prévues pour connecter la structure de bande (20), et le panneau de matériau (8) est formé de façon à être une structure de plaque ; le processus de montage consistant à monter la puce à DEL (11) sur la pluralité de fentes d'électrode (22) du panneau de matériau (8) par soudure ; le processus de retraitement consistant à découper la pluralité de plaques de connexion (82) à partir du panneau de matériau (8) et à retirer un panneau de poinçonnage plat (80) ; le processus de préparation de formation consistant à utiliser un moule de poinçonnage pour presser et positionner une partie de positionnement (25) du panneau de poinçonnage (80) et pré-presser le panneau de poinçonnage (80) à une position prédéterminée pour produire une déformation de flexion selon l'espace tridimensionnel (3D) requis de la plaque conductrice (2), et la déformation de flexion comprenant la déformation de la partie de flexion (24) et, le cas échéant, la déformation de la partie de connexion (23) ; le processus de flexion utilisant le moule de poinçonnage pour presser la structure plane fixe (28) du panneau de poinçonnage (80) prédéformé et plier la partie de flexion (24) et formant une structure d'espace 3D de la plaque conductrice (2) par le panneau de poinçonnage (80) ; le processus d'assemblage consistant à assembler le cadre de support (3) et à combiner et fixer le cadre de support (3) dans la partie intérieure de la plaque conductrice (2), et faisant passer chaque colonne de fixation (33) du cadre de support (3) à travers chaque trou de fixation (27) de la plaque conductrice (2), de telle sorte que chaque surface de support (301) fixe et supporte la structure plane fixe (28) de la plaque conductrice (2) pour fournir le support structural nécessaire à la plaque conductrice (2) dans le processus de suivi, et un trou de ventilation (34) formé entre les nervures de support (30) du cadre de support (3) ayant une surface capable de recouvrir chaque partie auxiliaire (221) découpée de la plaque conductrice (2) ; et le processus de retrait de partie auxiliaire consiste à utiliser le moule de poinçonnage pour presser la structure plane fixe (28) de la plaque de la structure conductrice (2) et la nervure de support (30) du cadre de support (3) et en outre pour ouvrir par découpe chaque partie auxiliaire (221) de la plaque conductrice (2) afin d'empêcher l'électrode d'être court-circuitée, de façon à obtenir un circuit série-parallèle.

19. Procédé de fabrication (9) d'un appareil d'éclairage à DEL selon la revendication 18, dans lequel le mécanisme de protection de puce à DEL est installé et connecté dans la fente d'électrode (22) par la pluralité de parties auxiliaires (221) pour former une plaque conductrice à un seul composant (2), et forme la structure plane fixe (28) entre les trous de fixation (27) de la plaque conductrice (2), la périphérie de la puce à DEL (11) et sa zone ne s'ouvrant pas, et chaque groupe de trous de fixation (27) de la plaque conductrice (2) et chaque groupe de colonnes de fixation (33) de chaque nervure de support (30) sont combinés les uns aux autres, et une surface de support entre chaque groupe de colonnes de fixation (33) fixe, presse et supporte la structure plane fixe (28) de la plaque conductrice (2), de telle sorte qu'un point de soudure d'électrode de chaque puce à DEL (11) peut être protégé durant le processus de fabrication.

20. Procédé de fabrication (9) d'un appareil d'éclairage à DEL selon la revendication 19, qui est appliqué pour une lampe à ampoule plate, dans lequel le processus de flexion plie la partie de flexion au niveau du diamètre externe pour former une plaque conductrice en forme de cupule à bord relevé ayant une surface circulaire et découper la partie de positionnement (25) pour former un trou central ; le processus d'assemblage fait passer chaque colonne de fixation (33) du cadre de support (3) à travers le trou de fixation (27) de la plaque conductrice (2), et la surface de support (301) de chaque nervure de support (30) est appariée à chaque colonne de fixation (33) passant à travers chaque trou de fixation (27) pour fixer et supporter la structure plane fixe (28) de la plaque conductrice (2), et une surface circulaire externe (32) du cadre de support (3) est fixée à la partie de flexion (24) de la plaque conductrice (2), et une bague de fixation (31) du cadre de support (3) est passée à travers le trou central de la partie de positionnement (25).

21. Procédé de fabrication (9) d'un appareil d'éclairage à DEL selon la revendication 19, qui est appliqué pour une ampoule à surface incurvée convexe, dans lequel le processus de flexion comprend en outre un processus de flexion pré-assemblage et un processus de flexion post-assemblage ; le processus de préparation de formation utilise en outre le moule de poinçonnage pour positionner le trou central de la partie de positionnement (25) et presse la structure plane fixe (28) étroitement et plie chaque partie de connexion (23) de la fente d'isolation (21) disposée à travers la plaque conductrice (2) selon une forme en V, de façon à plier chaque structure de bande (20) vers le côté arrière, et réduit chaque structure de bande (20) près de la partie de flexion (24) le long de la direction circonférentielle, de telle sorte que la largeur de chaque fente d'isolation (21) est réduite davantage, et à présent, le panneau de poinçonnage (80) devient une structure conique et chaque puce à DEL (11) est située sur le côté externe, et la périphérie externe de chaque puce à DEL (11) est toujours maintenue de façon à être plate ; le processus de flexion pré-assemblage comprend en outre un processus de flexion de surface incurvée sphérique et un processus de flexion de surface incurvée circulaire, le processus de flexion de surface incurvée sphérique utilisant le moule de poinçonnage pour presser la partie de positionnement (25) et la structure plane fixe (28) selon un angle conique prédéterminé, puis réalisant une opération de formation de surface incurvée sphérique, et la largeur de la fente d'isolation (21) au niveau du diamètre externe étant davantage réduite ; le processus de flexion de surface incurvée circulaire coupant la partie de positionnement (25) pour former un trou central circulaire, et utilisant le moule de poinçonnage pour presser chaque structure plane fixe (28) afin de réaliser une opération de formation de surface incurvée circulaire, et le panneau de poinçonnage ainsi formé étant une plaque conductrice ayant un espace 3D, et la surface incurvée sphérique (241) et la surface incurvée circulaire (242) formant conjointement une forme hémisphérique, et chaque partie de connexion (23) disposée à travers la fente d'isolation (21) étant en outre pliée selon une forme en V, et la largeur de la fente d'isolation (21) de la surface incurvée conique (243) et de la surface cylindrique (244) étant également réduite ; le processus d'assemblage combinant en outre le cadre de support (3) et la plaque conductrice (2), et la surface circulaire externe (32) étant fixée à la surface incurvée interne de la partie de flexion (24), et la surface de support (301) de chaque nervure de support (30) étant appariée à chaque colonne de fixation (33) passant à travers chaque trou de fixation (27) pour fixer et supporter la structure plane fixe (28) de la plaque conductrice (2), et la bague de fixation (31) étant passée à travers le trou central de la partie de positionnement (25) ; le processus de flexion pré-assemblage étant un processus de flexion de surface incurvée conique et de surface cylindrique qui utilise le moule de poinçonnage pour fixer le cadre de support (3) après l'ouverture par découpe de chaque partie auxiliaire (221) et former la surface incurvée conique (243) et la surface cylindrique (244) de la plaque conductrice (2), et puisque la partie de flexion (24) à l'intersection de la surface incurvée conique (243) a une pluralité de trous de flexion pour affaiblir la résistance structurale pour un effet de flexion aisé, alors la surface circulaire externe (32) du cadre de support (3) peut être fixée à la partie de flexion (24), de façon à former la surface incurvée conique (243) et la surface cylindrique (244).

22. Procédé de fabrication (9) d'un appareil d'éclairage à DEL selon la revendication 19, qui est appliqué pour une ampoule à surface incurvée concave, dans lequel le processus de flexion comprend en outre un processus de flexion pré-assemblage et un processus de flexion post-assemblage ; dans lequel le processus de préparation de formation utilise en outre le moule de poinçonnage pour positionner le trou central de la partie de positionnement (25) et presser la structure plane fixe (28) étroitement et plier chaque partie de connexion (23) du trou d'isolation disposé à travers la plaque conductrice (2) selon une forme en V, et plier chaque structure de bande (20) vers le côté arrière, et plier chaque structure de bande (20) près de la partie de flexion (24) dans la direction circonférentielle, de façon à réduire davantage la largeur de chaque fente d'isolation (21), et davantage plier chaque partie de connexion (23) selon une forme en V profond, et à présent, le panneau de poinçonnage (80) devient une structure conique, et chaque puce à DEL (11) est disposée sur le côté externe, et à présent, la périphérie externe de chaque puce à DEL (11) est maintenue de façon à être plate ; le processus de flexion pré-assemblage comprend en outre un processus de flexion de surface sphérique concave et un processus de flexion de surface incurvée circulaire concave, le processus de flexion de surface sphérique concave utilisant en outre le moule de poinçonnage pour presser la partie de positionnement (25) et la structure plane fixe (28) selon un angle conique prédéterminé, puis déformer la surface sphérique concave (241a), et la surface sphérique concave (241a) de la structure étant toujours maintenue de façon à être une surface conique, et la partie de flexion (24) de chaque structure de bande (20) étant pliée au niveau du diamètre externe du trou de fixation (27), et l'angle de flexion de la partie de flexion (24) étant supérieur à 90 degrés, de telle sorte que la surface incurvée conique (243) et la surface cylindrique (244) sont sous la forme d'un plan radial, et chaque puce à DEL (11) étant toujours disposée sur le côté interne, et la largeur de la fente d'isolation sur le diamètre interne de la surface incurvée circulaire concave (242a) étant réduite, et la largeur de la fente d'isolation (21) sur le diamètre externe devenant plus grande en raison de la forme plane ; le processus de flexion de surface incurvée circulaire concave découpant et retirant la partie de positionnement (25) pour former un trou central circulaire, et le moule de poinçonnage étant à nouveau utilisé pour presser la structure plane fixe (28) et former la surface incurvée circulaire concave (242a), et la partie de flexion (24) au niveau du diamètre externe du trou de fixation (27) de chaque structure de bande (20) étant pliée, de telle sorte que la partie de flexion (24) entre la surface incurvée circulaire concave (242a) et la surface incurvée conique (243) devient une flexion en forme de U inversé, et la partie de flexion en forme de U (24b) ayant un angle de flexion sensiblement égal à 180 degrés, et le panneau de poinçonnage (80) ainsi formé devenant la plaque conductrice (2) ayant un espace 3D, et la surface sphérique concave (241a) et la surface incurvée circulaire concave (242a) formant une surface incurvée hémisphérique concave, et la surface incurvée conique (243) et la surface cylindrique (244) formant un cylindre à rabat vers l'extérieur, et la partie de connexion en forme de V disposée à travers la fente d'isolation (21) étant davantage pliée, et la largeur de la surface incurvée conique (243) et de la surface cylindrique (244) étant également réduite ; le processus d'assemblage combinant le cadre de support (3) et la plaque conductrice (2) et fixant une surface circulaire externe (32) du cadre de support (3) à une surface incurvée interne de la partie de flexion en forme de U (24b), et la surface de support (301) de chaque nervure de support (30) étant appariée à chaque colonne de fixation (33) passant à travers chaque trou de fixation (27) pour fixer et supporter la structure plane fixe (28) de la plaque conductrice (2), et faire passer la fente de verrouillage (35) du cadre de support (3) à travers la fente d'isolation (21), et la bague de fixation (31) étant passée à travers le trou central ; le processus de flexion post-assemblage étant un processus de flexion de surface incurvée conique et de surface cylindrique, et utilisant le moule de poinçonnage pour fixer le cadre de support (3) après que chaque processus de partie auxiliaire termine le moule de poinçonnage et former également la surface incurvée conique (243) et la surface cylindrique (244) de la plaque conductrice (2), et puisque les parties de flexion (24) aux deux intersections de la surface incurvée conique (243) ont une pluralité de trous de flexion pour affaiblir la résistance structurale et rendre le processus de flexion aisé, et la surface circulaire externe (32) du cadre de support (3) étant fixée à la partie de flexion en forme de U (24b) de la plaque conductrice (2), alors la surface incurvée conique (243) et la surface cylindrique (244) sont formées.

23. Procédé de fabrication (9) d'un appareil d'éclairage à DEL selon la revendication 18, qui est appliqué pour une lampe hémisphérique, dans lequel le processus de préparation de formation utilise en outre le moule de poinçonnage pour positionner le trou central de la partie de positionnement (25) et presse la structure plane fixe (28) étroitement et plie la partie de connexion (23) de la fente d'isolation (21) disposée à travers le panneau de poinçonnage (80) selon une forme en V pour affaiblir la résistance de la partie de connexion (23) le long de la direction circonférentielle ; le processus de préparation de formation utilise en outre le moule de poinçonnage pour positionner le trou central de la partie de positionnement (25), et réduit la structure de bande (20) près de la partie de flexion (24) d'une surface incurvée circulaire (242) le long de la direction circonférentielle, de telle sorte que la largeur de chaque fente d'isolation (21) est davantage réduite, et chaque partie de connexion en forme de V (25) est davantage pliée selon une forme en V profond, de telle sorte que le panneau de poinçonnage (80) de la structure plane devient une structure conique, chaque structure de bande (20) dans la direction circonférentielle n'ayant pas été pliée selon une surface incurvée ; la périphérie externe de chaque puce à DEL (11) est maintenue de façon à être plane dans ce processus ; le processus de flexion utilise en outre le moule de poinçonnage pour presser la structure plane fixe (28) de la surface incurvée sphérique (241) selon un angle conique prédéterminé, puis plier deux parties de flexion (24) de la structure de bande (20) de la surface incurvée sphérique (241), de telle sorte que la surface incurvée circulaire (242) devient une surface conique ; puis la partie de positionnement (25) est découpée et retirée pour former un trou central circulaire, et le moule de poinçonnage est à nouveau utilisé pour presser la structure plane fixe (28) de la surface incurvée circulaire (242), puis plier les deux parties de flexion (24) de la structure de bande (20), et la surface incurvée circulaire (242) et la surface incurvée sphérique (241) forment conjointement la plaque conductrice (2) ayant une structure d'espace hémisphérique, et la partie de connexion (25) disposée à travers chaque fente d'isolation (21) est pliée selon une forme en V ; lorsque le processus d'assemblage combine le cadre de support (3) et la plaque conductrice (2), la surface circulaire externe (32) du cadre de support (3) est fixée à la surface incurvée circulaire (242) de la plaque conductrice (2), et la surface de support (301) de chaque nervure de support (30) est appariée et combinée à chaque colonne de fixation (33) passant à travers chaque trou de fixation (27) pour fixer et supporter la structure plane fixe (28) de la plaque conductrice (2).

24. Procédé de fabrication (9) d'un appareil d'éclairage à DEL selon la revendication 18, qui est appliqué pour un tube de lampe allongé, dans lequel le processus de flexion utilise une rangée de trous de fixation (27) sur un côté externe d'un panneau de poinçonnage (80) comme partie de positionnement (25) et utilise en outre le moule de poinçonnage pour presser la structure plane fixe (28) de la colonne et plier les parties de flexion (24) sur le deux côtés du panneau de poinçonnage (80) selon un angle, de telle sorte que la partie de combinaison (36) devient un rabat incliné avec un angle sensiblement égal à un angle droit, puis le processus mentionné ci-dessus est répété, et le moule de poinçonnage ayant un angle de flexion est utilisé pour fixer les trous de fixation (21) au niveau d'une autre colonne, et presser la structure plane fixe (28), et plier la partie de flexion (24) plusieurs fois, de telle sorte que le panneau de poinçonnage (80) forme une structure de plaque conductrice ayant une section transversale en forme de U et ayant deux parties de combinaison de rabat (262) ; le processus d'assemblage combine le cadre de support (3) et la plaque conductrice (2), et fixe le bord latéral externe (320) à la partie de combinaison (36), et la surface de support (301) de chaque nervure de support (30) est appariée et combinée avec chaque colonne de fixation (33) passant à travers chaque trou de fixation (27) pour fixer et supporter la structure plane fixe (28) de la plaque conductrice (2).

25. Procédé de fabrication (9) d'un appareil d'éclairage à DEL selon la revendication 18, qui est appliqué pour une lampe plate rectangulaire, comprenant en outre un processus de façonnage, dans lequel le processus de flexion utilise en outre le moule de poinçonnage pour sélectionner une direction de rangée ou une direction de colonne, et utilise le trou de fixation (27) de la structure plane fixe (28) dans la direction de la partie de positionnement (25), et presse la structure plane fixe (28) dans la direction de rangée ou la direction de colonne et plie les parties de flexion (24) sur les deux côtés du panneau de poinçonnage (80) avec un grand angle, de telle sorte que la partie de combinaison (36) a un rabat incliné avec un angle sensiblement égal à 150 degrés, puis la partie de flexion (24) de la structure plane fixe (28) est pliée, et le même processus de flexion est répété dans une direction puis dans une autre direction jusqu'à ce que toutes les parties de flexion (24) au niveau de la structure plane fixe (28) et de la périphérie de la fente rectangulaire soient pliées ; de telle sorte que le panneau de poinçonnage (80) est formé en une plaque conductrice (2) ayant une pluralité de structures de fente rectangulaire agencées en rangées et en colonnes ; le processus de façonnage façonne la fente rectangulaire et utilise en outre le moule de poinçonnage pour combiner et positionner chaque trou de fixation (27) et presse un plan de la structure plane fixe (28) étroitement et façonne les dimensions finales de la fente rectangulaire et la surface oblique (245) de son ouverture ; le processus d'assemblage combine le cadre de support (3) et la plaque conductrice (2), et la surface circulaire externe (32) du cadre de support (3) est fixée à la partie de combinaison (36) de la plaque conductrice (2), et la surface de support (301) de chaque nervure de support (30) est appariée à chaque colonne de fixation (33) passant à travers chaque trou de fixation (27) pour fixer et supporter la structure plane fixe (28) de la plaque conductrice (2).
